(19) Europäisches Patentamt
European Patent Office
Office européen des brevets

(11) EP 1 438 634 B1

(12) **EUROPÄISCHE PATENTSCHRIFT**

(45) Veröffentlichungstag und Bekanntmachung des Hinweises auf die Patenterteilung:
**16.03.2011 Patentblatt 2011/11**

(21) Anmeldenummer: **02772397.2**

(22) Anmeldetag: **25.10.2002**

(51) Int Cl.:
*G03F 7/032* (2006.01) *G03F 7/00* (2006.01)

(86) Internationale Anmeldenummer:
**PCT/EP2002/011976**

(87) Internationale Veröffentlichungsnummer:
**WO 2003/036389 (01.05.2003 Gazette 2003/18)**

(54) **HOLOGRAPHISCHES AUFZEICHNUNGSMATERIAL UND VERFAHREN ZUR BILDUNG EINES LICHTBESTÄNDIGEN HOLOGRAMMS**

HOLOGRAPHIC RECORDING MATERIAL AND METHOD FOR CREATING A LIGHT-RESISTANT HOLOGRAM

MATERIAU DE REPRODUCTION HOLOGRAPHIQUE ET PROCEDE DE FORMATION D'UN HOLOGRAMME RESISTANT A LA LUMIERE

(84) Benannte Vertragsstaaten:
**AT BE BG CH CY CZ DE DK EE ES FI FR GB GR IE IT LI LU MC NL PT SE SK TR**

(30) Priorität: **26.10.2001 DE 10153028**

(43) Veröffentlichungstag der Anmeldung:
**21.07.2004 Patentblatt 2004/30**

(73) Patentinhaber: **Xetos AG**
**82064 Strasslach (DE)**

(72) Erfinder:
- **GROSS, Markus**
**87600 Kaufbeuren (DE)**
- **MAIER, Gerhard**
**87600 Kaufbeuren (DE)**
- **STEBANI, Jürgen**
**87600 Kaufbeuren (DE)**
- **KNOCKE, Frank**
**85560 Ebersberg (DE)**
- **JONGH DE, Rudi**
**83026 Rosenheim (DE)**
- **FRÖMEL, Martin**
**82343 Maising (DE)**
- **PODRATZKI, Bernd**
**63263 Neu-Isenburg (DE)**
- **EBERT, Dieter**
**82064 Grossdingharting (DE)**

(74) Vertreter: **Adam, Holger et al**
**Kraus & Weisert**
**Patent- und Rechtsanwälte**
**Thomas-Wimmer-Ring 15**
**80539 München (DE)**

(56) Entgegenhaltungen:
**EP-A- 0 324 480** **EP-A- 0 697 631**
**US-A- 5 484 927** **US-A- 6 045 953**

EP 1 438 634 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung bezieht sich auf photopolymerisierbare Zusammensetzungen als Aufzeichnungsmaterial für Bilder und auf Elemente mit Brechungsindexmodulation, insbesondere Hologramme. Des Weiteren betrifft die vorliegende Erfindung ein Verfahren zur Bildung eines lichtbeständigen Hologramms. Die erfindungsgemäßen Zusammensetzungen, die als selbstentwickelndes holographisches Aufzeichnungsmaterial verwendet werden, umfassen im Wesentlichen Binder, Monomer, Photoinitiator und gegebenenfalls weitere Additive bzw. Komponenten. In den erfindungsgemäßen Zusammensetzungen besitzen der polymere Binder und/oder das Monomer Gruppierungen, die zu einer durch Licht induzierten Vernetzungsreaktion befähigt sind. Dabei wird diese Vernetzung im Wesentlichen nicht durch das Licht, welches für das Einschreiben des Hologramms verwendet wird, hervorgerufen, sondern durch Licht anderer Wellenlänge, bevorzugt UV-Licht. Die Vernetzungsreaktion läuft also im Wesentlichen unabhängig von der Polymerisation bei der holographischen Belichtung ab. Die so hergestellten Hologramme zeichnen sich durch eine erhöhte Brechungsindexmodulation und verbesserte thermische, mechanische und chemische Stabilität (z.B. Lösungsmittelbeständigkeit) bei geringerem Herstellungsaufwand aus.

Bei der Bilderzeugung mit Brechungsindexmodulation wird innerhalb des Aufzeichungsmaterials ein Muster variierender Brechungsindices erzeugt. Ein solches Muster wird gewöhnlich als Phasenhologramm bezeichnet. Methoden zur Erzeugung von Hologrammen und die Theorie können der Literatur, u.a. "Holography" von C.C. Guest (Encyclopedia of Physical Science and Technology, Vol. 6, S. 507-519, R.A. Meyers, Hrsg. Academic Press, Orlando, FL, 1987) entnommen werden.

Als Aufzeichnungsmaterial für Hologramme eignen sich eine Vielzahl verschiedener Materialien, wie z.B. Silberhalogenidemulsionen oder gehärtete dichromatbehandelte Gelatine. Eine nützliche Diskussion über schon länger bekannte Materialien findet sich z.B. in "HQlographic Recording Materials" von H.M. Smith, Ed. (Topics in Applied Physics, Vol. 20, Springer Verlag, 1977).

Photopolymerfilme als Aufzeichnungsmaterial sind ebenfalls schon länger bekannt. Sie können prinzipiell eingeteilt werden in solche, die nasschemisch entwickelt werden müssen und solche, die keines Entwicklungsschritts bedürfen. Letztgenannte Systeme werden i.A. als selbstentwickelnd bezeichnet und besitzen allein schon durch die wesentlich höhere Verarbeitungsgeschwindigkeit entscheidende Vorteile. Bereits 1969 wurde von Haugh im US-Patent 3,658,526 ein selbstentwickelnder Photopolymerfilm vorgestellt, der im Wesentlichen aus polymerem Binder, Monomer und einem Initiatorsystem besteht und sich zur Aufnahme von hochaufgelösten Hologrammen eignet. Seither sind im Stand der Technik weitere Monomer-Binder-Photopolymere beschrieben worden, die im Vergleich zu dem ursprünglich vorgestellten Material verbesserte Eigenschaften aufweisen. Mittlerweile wird von Du Pont ein Holographie-Material unter dem Markennamen Omnidex® kommerziell vertrieben.

Die EP 0 324 480 (Du Pont) beschreibt eine im Wesentlichen feste, photopolymerisierbare Zusammensetzung, die eine Brechungsindex-Abbildung bei Einwirkung aktinischer Strahlung als dem einzigen Verarbeitungsschritt bildet, wobei diese Zusammensetzung
im Wesentlichen besteht aus

(a) 25 bis 75% eines in einem Lösungsmittel löslichen, thermoplastischen polymeren Bindemittels,
(b) 5 bis 60% einer Mischung aus

(i) einem flüssigen, ethylenisch ungesättigten Monomer, das einen Siedepunkt oberhalb von 100°C hat und zur Additionspolymerisation befähigt ist, und
(ii) einem festen, ethylenisch ungesättigten Monomer,

(c) 0,1 bis 10% eines Photoinitiator-Systems, das die Polymerisation des ungesättigten Monomers bei der Einwirkung einer aktinischen Strahlung aktiviert;

wobei alle Prozent-Angaben Gewichts-Angaben sind, die sich auf das Gesamt-Gewicht der Komponenten (a), (b) und (c) beziehen, dadurch gekennzeichnet, dass die Zusammensetzung eine BrechungsIndex-Modulation von wenigstens 0,005 hat, bestimmt mit Strahlung von 632,8 nm von einem Transmissionsgitter mit einer Raumfrequenz von etwa 1000 Linien/mm, wobei dieses Transmissionsgitter holographisch aus einer Schicht der Zusammensetzung hergestellt ist, worin das flüssige ungesättigte Monomer (i) einen Substituenten enthält, der aus der aus (1) Phenyl, Phenoxy, Naphthyl, Napthyloxy, heteroaromatischen Struktureinheiten mit bis zu drei aromatischen Ringen, (2) Chlor, (3) Brom und deren Mischungen bestehenden Gruppe ausgewählt ist, wobei das Bindemittel (a) im Wesentlichen frei von dem Substituenten ist und das feste ungesättigte Monomer (ii) einen Substituenten aus der aus (1) Naphthyl, Napthyloxy, heteroaromatischen Struktureinheiten mit bis zu drei aromatischen Ringen, (2) Chlor, (3) Brom bestehenden Gruppe enthält.

Allen diesen im Wesentlichen festen Monomer-Binder-Photopolymeren ist allerdings der Umstand gemein, dass zur Stabilisierung/Fixierung des Hologramms bzw. zur Erhöhung des Beugungswirkungsgrades der Film nach der

holographischen Belichtung neben einer ganzflächigen Bestrahlung mit UV-Licht zusätzlich noch einer weiteren zeitintensiven thermischen Behandlung unterzogen werden muss. Weitere Schritte zur Erhöhung des Beugungswirkungsgrades umfassen z.B. das Behandeln des Hologramms mit Lösungsmittel und/oder flüssigen Monomer. Für viele Produktionsverfahren sind aber möglichst geringe Zeiten bzw. ein möglichst hoher Durchsatz und eine einfache, kostengünstige Prozessführung für die Herstellung der Hologramme gefordert, so dass umständliche und zeitintensive Nachbehandlungen von Nachteil sind. Tatsächlich selbstentwickelnde und effektive Photopolymere als holographisches Aufzeichnungsmaterial sind deshalb immer noch Gegenstand intensiver Entwicklung.

Die Ursache für die Notwendigkeit einer thermischen Nachbehandlung von im Wesentlichen festen Monomer-Binder-Systemen liegt darin begründet, dass bei der holographischen Belichtung und der anschließenden ganzflächigen Fixierung mit UV-Licht das Monomer oder Monomergemisch zu weit weniger als 100% umgesetzt werden kann, da während der Polymerisation die Mobilität der Monomere und der wachsenden Polymerketten absinkt, und somit die Polymerisation zum Erliegen kommt. Durch die thermische Behandlung des Films wird dann dafür gesorgt, dass die Mobilität der Restmonomeren wieder erhöht und somit der Umsatz an Monomer gesteigert wird. Außerdem wird erreicht, dass ein gewisser Anteil an Restmonomer durch die Temperaturerhöhung aus dem Film verdampft. Wird das Hologramm dieser thermischen Nachbehandlung nicht ausgesetzt, so hat dies zur Folge, dass unverbrauchte Monomere und Polymerketten durch ihre, wenn auch geringe, aber dennoch vorhandene Mobilität im Laufe der Zeit im Film diffundieren und somit die Qualität des Hologramms durch eine Verringerung der Brechungsindexmodulation beeinträchtigen. D.h. die Langzeitstabilität des Hologramms ist dann gering. Zur Verbesserung der Langzeitstabilität kann ein Teil des verwendeten, i.d.R. monofunktionellen Monomers durch höherfunktionelle Monomere ersetzt werden, so dass die Mobilität der Restmonomere und Polymerketten im ausbelichteten Film durch eine Vernetzung erheblich verringert wird. Allerdings wird dann die Mobilität der Monomeren schon während der holographischen Belichtung so stark herabgesetzt, dass sich der Umsatz an Monomeren verringert. Im gleichen Maße verringert sich damit die Brechungsindexmodulation und damit der Beugungswirkungsgrad bei gegebener Filmdicke.

Beim Einschreiben des Hologramms in das Material wird z.B. durch die Überlagerung zweier Laserstrahlen ein Intensitätsmuster im Aufzeichnungsmaterial erzeugt. In den hellen Zonen wird durch das Initiatorsystem die Photopolymerisation gestartet, während in den dunklen Zonen keine Reaktion abläuft. Im Laufe der Polymerisation wird zunächst in den hellen Zonen Monomer verbraucht, so dass dessen Konzentration dort sinkt. Im Allgemeinen wird davon ausgegangen, dass durch den entstehenden Konzentrationsgradienten zwischen den dunklen und hellen Zonen und durch die bei der Polymerisation eintretende Volumenkontraktion Monomer aus den dunklen in die hellen Zonen nachdiffundiert. Gleichzeitig wird teilweise auch inaktiver polymerer Binder aus den hellen in die dunklen Zonen verdrängt. Im Vergleich zu der ursprünglich homogenen Verteilung von polymerem Binder und Monomer, hat sich nach der bildgebenden holographischen Belichtung das aus dem Monomer entstandene Polymer in den hellen Zonen angereichert, während in den dunklen Zonen die Konzentration an polymerem Binder angestiegen ist. Könnte erreicht werden, dass sich das durch das Monomer entstandene Polymer ausschließlich in den hellen Zonen und der inaktive polymere Binder zu 100% in den dunklen Zonen befindet, so entspräche die erzeugte Brechungsindexmodulation dem Unterschied der Brechungsindices zwischen dem erzeugten Polymer und dem polymeren Binder. In allen bisherigen Systemen wird dies bei weitem nicht erreicht und der tatsächlich resultierende Brechungsindexunterschied ist wesentlich geringer als der maximal mögliche. Würde sich in den dunklen Zonen kein Monomer mehr befinden, sich aber der polymere Binder homogen über das gesamte Aufzeichnungsmedium verteilen, so könnte immerhin noch 2/3 des maximalen Brechnungsindexunterschieds erreicht werden (der effektive ortsabhängige Brechungsindex setzt sich in erster Näherung aus dem arithmetischen Mittel der Brechungsindices aller Komponenten zusammen). Selbst dieser Wert wird bei weitem ohne Nachbehandlung nicht erreicht, da der Gesamtumsatz an Monomer wesentlich geringer als 100% ist. Dieser Umsatz wird hauptsächlich dadurch bestimmt, wie effektiv die Polymerisation in den hellen Zonen abläuft und wie viel aus den dunklen Zonen nachdiffundieren kann. Für beide Prozesse ist entscheidend, dass die Mobilität der Monomere während der gesamten Polymerisation möglichst hoch ist. Verglichen mit flüssigen Mischungen oder mit verdünnten Lösungen ist die Mobilität von Monomeren in festen Polymerfilmen wesentlich geringer und sinkt im Verlauf der Polymerisation weiter ab. Um eine relativ hohe Mobilität und damit einen hohen Umsatz an Monomer zu gewährleisten, werden häufig monofunktionelle Monomere eingesetzt, da bei Verwendung von höherfunktionellen Monomeren die Mobilität durch eine Vernetzung bereits bei der holographischen Belichtung wesentlich drastischer herabgesetzt wird und damit der Umsatz an Monomer gering wird. Zur Erhöhung der Mobilität können der Mischung Weichmacher zugesetzt werden. Wird allerdings ausschließlich monofunktionelles Monomer verwendet, so ist die Langzeitstabilität des Hologramms gering, da Restmonomere und Polymerketten eine nicht zu vernachlässigende Mobilität im ausbelichteten Film aufweisen. Es kommt zu einer Veränderung der Brechungsindexmodulation im Laufe der Zeit, da sich der räumliche Konzentrationsunterschied von polymerem Binder und gebildetem Polymer verändert. Um diesem Umstand entgegenzuwirken, wird häufig ein Gemisch aus mono- und höherfunktionellen Monomeren verwendet. Damit wird also ein Kompromiss zwischen genügend hohem Monomerumsatz und ausreichend guter Langzeitstabilität eingegangen, wodurch allerdings auch das thermische Nachbehandeln unabdingbar wird.

Der vorliegenden Erfindung liegt somit die Aufgabe zugrunde, ein effektives holographisches Aufzeichnungsmaterial bereitzustellen, das durch einen hohen Umsatz an Monomer und damit durch eine hohe Brechungsindexmodulation, eine große Langzeitstabilität und durch eine hohe Verarbeitungsgeschwindigkeit gekennzeichnet ist. Eine Möglichkeit alle diese Parameter zu vereinen, ist die in der vorliegenden Erfindung beschriebene photopolymerisierbare Zusammensetzung gemäß Anspruch 1, welche durch photoaktivierbare Struktureinheiten im polymeren Binder und/ oder im durch die Photopolymerisation entstandenen Polymer gekennzeichnet ist. Die photoaktivierbaren Struktureinheiten können einer von der holographischen Belichtung unabhängigen, also mit Licht anderer Wellenlänge, initiierbaren Vernetzungsreaktion unterworfen werden, bei der es sich im Wesentlichen nicht um eine Polymerisation handelt. Dadurch kann ein optimaler Umsatz an Monomer und gleichzeitig eine sehr hohe Langzeitstabilität erreicht werden, ohne dass eine zeitintensive thermische Nachbehandlung notwendig ist. Solche Aufzeichnungsmaterialien sind somit im Gegensatz zu herkömmlichen Materialien für sehr schnelle und kostengünstige Herstellungsverfahren geeignet. Die vorliegende Erfindung stellt des Weiteren ein Element, enthaltend ein Hologramm gemäß Anspruch 6 und ein Verfahren zur Bildung eines lichtbeständigen Hologramms in einer photopolymerisierbaren Schicht auf einer Substratoberfläche gemäß Anspruch 11 bereit.

Die in dieser Erfindung beschriebenen Zusammensetzungen besitzen den Vorteil, dass durch den Einsatz von ausschließlich monofunktionellen reaktiven Monomeren ein hoher Umsatz gewährleistet wird und erst nach der holographischen Belichtung und unabhängig (isoliert) von dieser durch eine homogene Bestrahlung des Aufzeichnungsmaterials mit Licht anderer Wellenlänge, bevorzugt mit UV-Strahlung (150 nm bis 400 nm, bevorzugt 200-400 nm, insbesondere 250-350 nm) die Vernetzungsreaktion der photoaktivierbaren Struktureinheiten zur Verringerung der Mobilität von noch vorhandenem Restmonomer und Polymerketten initiiert wird. Dadurch kann das Hologramm bei gleichzeitig höherem Umsatz an Monomer wesentlich effektiver und besser stabilisiert werden als bei herkömmlichen Systemen. Bei geschickter Wahl an solchen vernetzenden, photoaktivierbaren Gruppierungen bzw. Struktureinheiten, die sich sowohl im polymeren Binder als auch im Monomer oder in beiden befinden können, kann außerdem die Brechungsindexmodulation verbessert werden. Dies steht damit im Zusammenhang, dass sich bei der Vernetzungsreaktion der Brechungsindex dieser Komponente ändert (Nagata et al., "Refractive index decrease during photocrosslinking in photopolymers suitable for holographic recording." Macromol. Rapid Commun. 18, 191-196 (1997)) und sich diese entweder in den hellen Zonen oder in den dunklen Zonen gehäuft befindet. Dadurch wirkt sich die Brechungsindexänderung bei der Vernetzung in einer der beiden Zonen stärker aus, so dass die Brechungsindexmodulation zwischen hellen und dunklen Zonen vergrößert wird. Die in dieser Erfindung beschriebenen Zusammensetzungen stellen somit einen wesentlichen Fortschritt im Hinblick auf wirklich selbstentwickelnde effektive holographische Aufzeichnungsmaterialien dar, da auf zeitintensive thermische und weitere Nachbehandlungsschritte verzichtet werden kann.

Besonders geeignete photoaktivierbare Struktureinheiten gemäß der vorliegenden Erfindung sind solche, die durch Bestrahlung mit UV-Strahlung eine Vernetzungsreaktion, insbesondere eine Cycloadditionsreaktion, eingehen und somit die Vernetzung auslösen, wobei sich diese Reaktion von denen in herkömmlichen Monomer-Binder-Systemen grundsätzlich dadurch unterscheidet, dass sie keine Polymerisation darstellt.

Schematisch lässt sich der Mechanismus der Photocycloaddition für die nachstehend definierten photoaktivierbaren Struktureinheiten der allgemeinen Formeln I und II beispielhaft wie folgt darstellen (2+2-Cycloaddition):

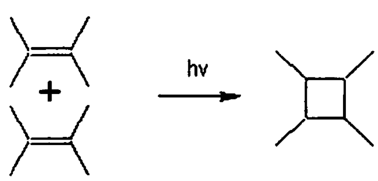

;
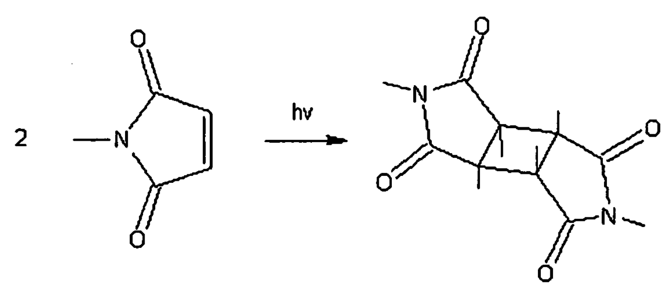


Dabei muss sich die Vernetzungsreaktion aber nicht zwangsläufig auf Photocycloadditionen beschränken, sondern kann auch durch andere Gruppierungen, die zu einer lichtinduzierten Vernetzungsreaktion befähigt sind, erfolgen. Geeignete Gruppierungen können dabei entweder im Monomer, im polymeren Binder oder gleichzeitig in beiden Komponenten vorhanden sein. Die Photocycloaddition wird im Wesentlichen nicht bei der holographischen Belichtung ausgelöst, sondern erst nachdem diese abgeschlossen ist, vorzugsweise mit UV-Licht. Dabei werden die hierin angegebenen photoaktivierbaren Struktureinheiten in der Art und Weise im polymeren Binder bzw. Bindergemisch und/oder im Monomer bzw. Monomergemisch eingesetzt, dass sich durch die Photocycloaddition bzw. lichtinduzierten Vernetzungsreaktion (Photovernetzung) ein positiver Effekt für die Brechungsindexmodulation ergibt. Solche Gruppierungen, die zur Photocycloaddition befähigt sind, sind dem Fachmann bekannt. Polymere, die solche Gruppierungen tragen, sind bekannt und werden z.B. als Photoresists (vgl. US 2 690 966, US 4 152 159, EP 0 240 276, US 3 640 722, US 3 748 131, DE 2 230 936 und EP 0 021 019) eingesetzt. Besonders geeignet sind darüber hinaus solche Struktureinheiten, deren Photocycloaddition nicht durch dieselben Farbstoffe sensibilisiert wird, wie die verwendeten Photoinitiatoren, die die Photopolymerisation starten.

Photoaktivierbare Struktureinheiten P, die im Monomer und/oder im polymeren Binder vorliegen können, sind die folgenden:

P= 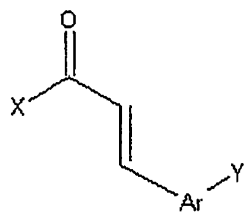

I

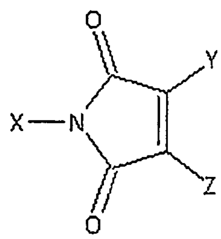

II

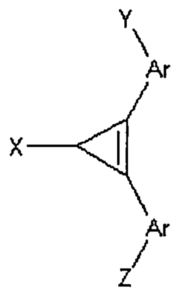

III

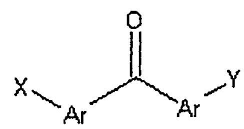

IV

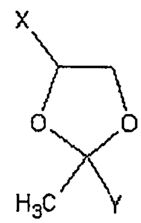

V

wobei Ar ein ein- oder mehrkerniger substituierter oder unsubstituierter aromatischer oder heterocyclischer aromatischer Rest, insbesondere

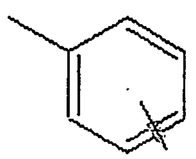

oder

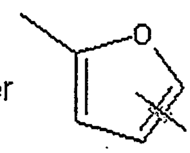

ist und wobei X, Y und Z gleich oder verschieden sind und unabhängig voneinander ausgewählt sind aus

A) Monomerresten, die ethylenisch ungesättigte Gruppen enthalten, die zur Polymerisation befähigt sind oder
B) Polymerresten, die von in Wasser und/oder organischen Lösungsmitteln löslichen polymeren Bindern abgeleitet sind und
C) Resten, unabhängig voneinander ausgewählt aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

Die vorstehend angegebenen Reste C) haben die nachfolgende Bedeutung:

Die Alkylreste enthalten 1-12, vorzugsweise 1-10 und insbesondere 1-8 Kohlenstoffatome. Beispiele für diese Reste beinhalten Methyl, Ethyl, n-Propyl, Isopropyl, n-Butyl, Isobutyl, sec-Butyl, tert-Butyl, Pentyl, Isoamyl, Hexyl, Octyl und dergleichen. Beispiele für substituierte Reste beinhalten Trifluormethyl, 1H,1H,2H,2H-Perfluoroctyl, 1H,1H-Perfluoroctyl, Pentafluorethyl, 2,2,2-Trifluorethyl, Heptafluorpropyl, 1,1,1,3,3,3-Hexafluorisopropyl, 2,2,3,3,4,4,4-Heptafluorbutyl, 2,2,3,3-Tetrafluorpropyl, 2,2,3,3,4,4,5,5-Octafluorpentyl und Trichlormethyl.

Die Alkenylreste beziehen sich auf ungesättigte acyclische Kohlenwasserstoffreste mit einer oder mehreren Kohlenstoff-Kohlenstoff-Doppelbindungen. Diese Reste enthalten 2-12, vorzugsweise 2-10 und insbesondere 2-8 Kohlenstoffatome. Beispiele für geeignete Alkenylreste beinhalten Ethenyl, Propenyl, Buten-1-yl, Isobutenyl, Penten-1-yl, 2-Methylbuten-1-yl, 3-Methylbuten-1-yl, Hexen-1-yl, Hepten-1-yl, Octen-1-yl, Isoprenyl, 2,4-Pentadienyl, 3,5-Hexandienyl, 3,5-Pentandienyl, 3-Methyl-3,5-hexandienyl und dergleichen.

Die Alkinylreste beziehen sich auf ungesättigte acyclische Kohlenwasserstoffreste mit einer oder mehreren Kohlenstoff-Kohlenstoff-Dreifachbindungen. Diese Reste enthalten 2-12, vorzugsweise 2-10 und insbesondere 2-8 Kohlenstoffatome. Beispiele für geeignete Alkinylreste beinhalten Ethinyl, Propinyl, Butin-1-yl, Butin-2-yl, Pentin-1-yl, Pentin-2-yl, 3-Methylbutin-1-yl, Hexin-1-yl, Hexin-2-yl, Hexin-3-yl, 3,3-Dimethyl-Butin-1-yl und dergleichen.

Bei den Alkoxyresten hat Alkyl die vorstehend angegebene Bedeutung und enthält besonders bevorzugt 1-4 Kohlenstoffatome. Beispiele für geeignete Alkoxyreste sind Methoxy, Ethoxy, n-Propoxy, Isopropoxy, n-Butoxy, Isobutoxy, sec-Butoxy, tert-Butoxy und dergleichen.

Die Acylreste enthalten 2-13, vorzugsweise 2-12 und insbesondere 2-9 Kohlenstoffatome. Geeignete Beispiele beinhalten Formyl, Acetyl, 2-Oxo-propyl, 3-Oxo-propyl, 2-Oxo-butyl, 2-Methyl-3-oxobutyl, 2-Oxo-hexyl, 2-Oxo-octyl, Benzoyl und dergleichen.

Die Acyloxyreste enthalten 2-13, vorzugsweise 2-12 und insbesondere 2-9 Kohlenstoffatome. Geeignete Beispiele beinhalten Formyloxy, Acetyloxy, Propionyloxy, n-Butyryloxy, Benzoyloxy und dergleichen.

Die Aryloxyreste enthalten 6-50, bevorzugt 6-14, vorzugsweise 6-10 und insbesondere 6 Kohlenstoffatome. Geeignete Beispiele beinhalten substituierte oder unsubstituierte Phenoxy- und Naphthoxyreste, wie p-Chlorphenoxy, p-Nitrophenoxy, p-Hydroxyphenoxy.

Die aromatischen Reste können ein- oder mehrkernig sein und enthalten 6-50, bevorzugt 6-14, vorzugsweise 6-10 und insbesondere 6 Kohlenstoffatome. Beispiele beinhalten Phenyl, Naphthyl, Biphenyl und Alkylarylreste wie Benzyl und Triphenylmethyl. Beispiele für substituierte Aromaten sind p-Chlorphenyl, p-Nitrophenyl und p-Hydroxyphenyl.

Heterocyclische Reste beziehen sich auf gesättigte, ungesättigte und aromatische cyclische Kohlenwasserstoffreste mit 2-14, vorzugsweise 5-10 Kohlenstoffatomen, wobei 1-3 Kohlenstoffatome durch Stickstoff, Sauerstoff oder Schwefel ersetzt sind. Der heterocyclische Rest kann an einen aromatischen Kohlenwasserstoffrest kondensiert sein. Geeignete Beispiele beinhalten Tetrahydrofuryl, Furyl, Carbazolyl, Pyrrolyl, Pyridinyl, Pyrazolyl, Triazolyl, Pyrimidinyl, Pyridazinyl, Oxazolyl, Thiazolyl, Imidazolyl, Indolyl, Thiophenyl, Furanyl, Tetrazolyl, 2-Pyrrolinyl, 3-Pyrrolinyl, Pyrrolindinyl, 1,3-Dioxolanyl, Imidazolidinyl, 2-Pyrazolinyl, Pyrazolidinyl, Isoxazolyl, Isothiazolyl, 1,2,3-Triazolyl, usw.

Die alicyclischen Kohlenwasserstoffreste beziehen sich auf aliphatische Reste in einem Ring aus 3-12 Kohlenstoffatomen, vorzugsweise 4-6 Kohlenstoffatomen. Beispiele für geeignete alicyclische Reste beinhalten Cyclopropyl, Cyclopropylenyl, Cyclobutyl, Cyclopentyl, Cyclohexyl, Cyclohexenyl und dergleichen.

Die Aminoreste beziehen sich auf Monoalkylaminoreste, wie Methylamino, Ethylamino, Propylamino, n-Butylamino und t-Butylamino, Dialkylaminoreste, wie Dimethylamino, Diethylamino, Dipropylamino, Dibutylamino und Diphenylamino, sowie Alkylarylaminoreste, wie Methylphenylamino und Ethylphenylamino.

Die Carbonsäurereste beziehen sich auf Carbonsäuren, Carbonsäuresalze und -ester mit 1-18, vorzugsweise 1-12 und insbesondere 2-6 Kohlenstoffatomen. Beispiele sind die geradkettigen Ameisen-, Essig-, Propion- und Buttersäurereste und der 2-Methylbuttersäurerest als verzweigtkettiger Carbonsäurerest. Beispiele für Carbonsäureesterreste sind Methylbutanoat, Ethylpropanoat, Propylbutanoat und dergleichen. Beispiele für Carbonsäuresalze sind Natriumacetat und Kaliumpropanoat.

Beispiele für Halogenatome sind F, Cl, Br und I.

Im Falle der photoaktivierbaren Struktureinheit II können Y und Z auch cyclisch miteinander verbunden sein und folgende allgemeine Strukturformeln aufweisen:

P=

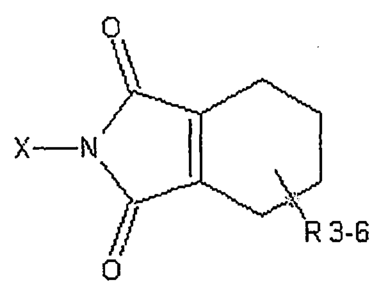

IIa

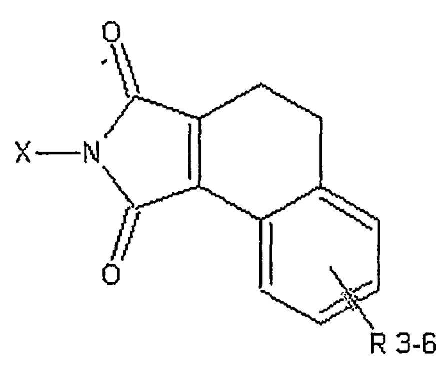

IIb

wobei die Reste X, $R_3$, $R_4$, $R_5$ und $R_6$ die vorstehend bzw. nachstehend angegebene Bedeutung haben.

Bei den Monomerresten A) mit ethylenisch ungesättigten Gruppen handelt es sich um von ethylenisch ungesättigten Monomeren abgeleitete Reste. Besonders bevorzugte Beispiele für die ethylenisch ungesättigten Reste weisen die nachfolgenden allgemeinen Strukturformeln auf:

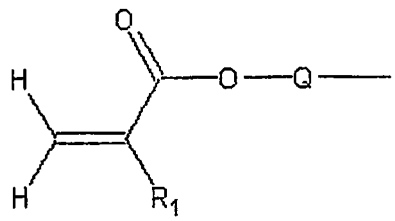

Acrylate

**oder**

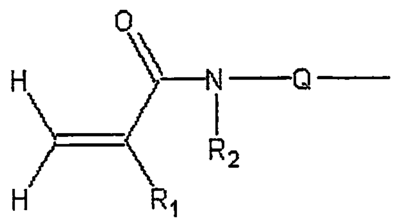

Acrylamide

**oder**

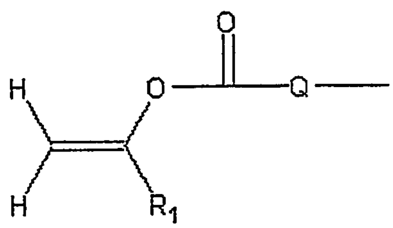

Vinylester

**oder**

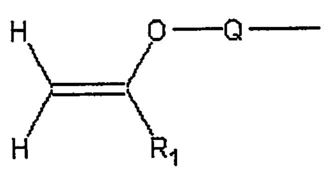

Vinylether

**oder**

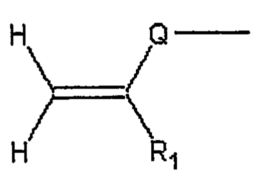

vinylische

**oder**

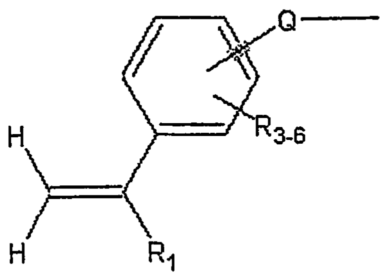

Styrole

wobei

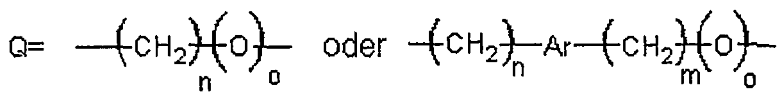

Q= … oder …

mit n, m = 0-12 und O = 0, 1, wobei Ar ein ein- oder mehrkerniger substituierter oder unsubstituierter aromatischer oder heterocyclischer aromatischer Rest ist, wobei der Rest $R_1$ H, Methyl oder Ethyl ist und wobei die Reste $R_2$, $R_3$, $R_4$, $R_5$ und $R_6$ unabhängig voneinander ausgewählt sind aus der Gruppe umfassend Alkyl-, Alkenyl-, Alkinyl, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

Beispiele für besonders geeignete monofunktionelle Monomere mit den photoaktivierbaren Struktureinheiten P in der Seitenkette sind in Tabelle 1 zusammengestellt.

**Tabelle 1**

| P | X- | Y- | Z- |
|---|---|---|---|
| I / IV / V | 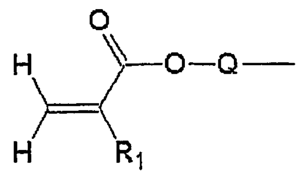 Acrylate<br>oder<br>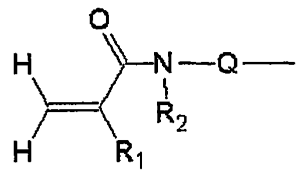 Acrylamide | R7 | - |
| II | oder<br>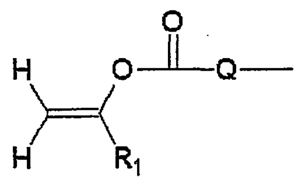 Vinylester | | R8 |
| III | oder<br>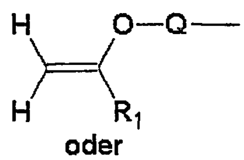 Vinylether<br>oder<br>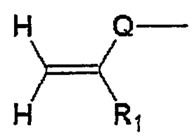 vinylische | | R8 |
| IIa, b | oder<br>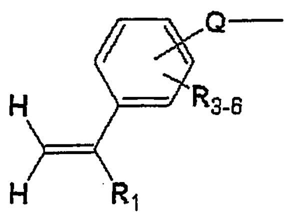 Styrole | - | - |

**Tabelle 1 (Fortsetzung)**

| P | X- | Y- | Z- |
|---|---|---|---|
| I / IV / V | R7 | 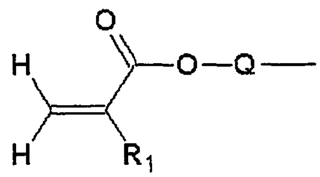 Acrylate<br>oder<br>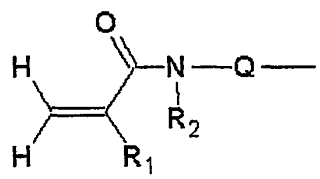 Acrylamide<br>oder | - |
| II | | 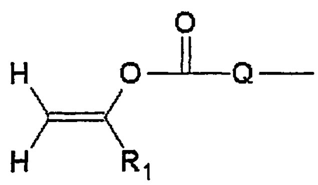 Vinylester<br>oder<br>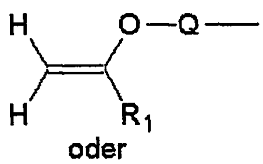 Vinylether<br>oder | R8 |
| III | | 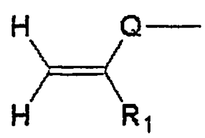 vinylische<br>oder<br>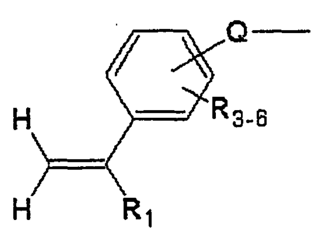 Styrole | R8 |

Die in der Tabelle 1 angegebenen Reste haben die vorstehend angegebene Bedeutung. Entsprechend haben auch die Reste $R_7$ und $R_8$ die vorstehend für die Reste $R_1$, $R_2$, $R_3$, $R_4$, $R_5$ und $R_6$ angegebenen Bedeutungen.

Die erfindungsgemäße photopolymerisierbare Zusammensetzung kann auch ein Monomergemisch aus verschiedenen ethylenisch ungesättigten Monomeren enthalten, wobei eines der ethylenisch ungesättigten Monomeren im Monomergemisch photoaktivierbare Struktureinheiten P entsprechend vorstehender Tabelle 1 aufweisen kann und die anderen ethylenisch ungesättigten monofunktionellen Monomeren im Monomergemisch nachfolgende allgemeine

Strukturеinheiten aufweisen können:

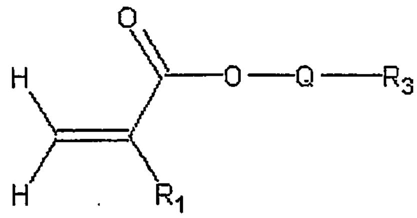

Acrylate

**oder**

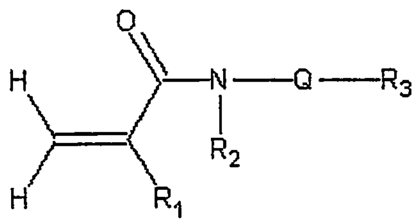

Acrylamide

**oder**

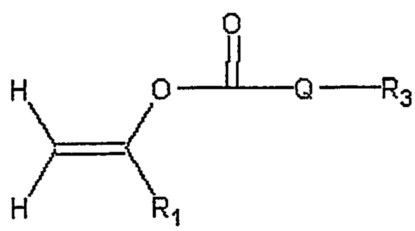

Vinylester

**oder**

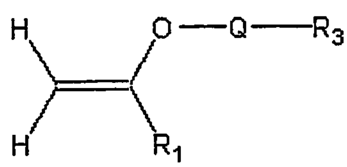

Vinylether

**oder**

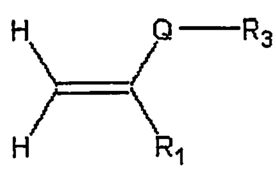

vinylische

**oder**

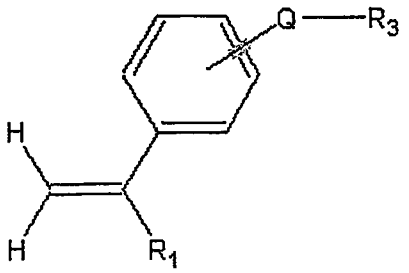

Styrole

$$Q= -(CH_2)_n-(O)_o- \quad \text{oder} \quad -(CH_2)_n-Ar-(CH_2)_m-(O)_o-$$

n, m =0-12; O = 0, 1, wobei Ar ein ein- oder mehrkerniger substituierter oder unsubstituierter aromatischer oder heterocyclischer aromatischer Rest ist,
und wobei die Reste die vorstehend angegebene Bedeutung haben.

Beispiele für im Monomergemisch enthaltene monofunktionelle Monomere mit oder ohne photoaktivierbarer Struktureinheit P sind substituierte oder unsubstituierte Styrolmonomere, Acrylsäure, α-Alkylacrylsäure, Acrylsäureester, α-Alkylacrylsäureester, deren Alkoholkomponente ein substituierter oder unsubstituierter aliphatischer oder aromatischer Rest mit 2-50 Kohlenstoffatomen sein kann, Acrylamide, α-Alkylacrylamide, wobei Alkyl die vorstehend angegebene Bedeutung hat, Vinylester, Vinylalkohol, Vinylether und sonstige substituierte vinylische Monomere, substituiert mit substituierten oder unsubstituierten aliphatischen oder aromatischen Resten mit 2-50 Kohlenstoffatomen.

Bevorzugte Beispiele sind (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth) acrylsäure-1H,1H,2H,2H-perfluoroctylester, 2,2,2-Trifluorethyl(meth)acrylat, Heptafluorpropyl(meth)acrylat, 1,1,1,3,3,3-Hexyfluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, Acrylsäure-N,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy)ethylacrylat, Hydrochinonmonomethacrylat und 2-[β-(N-Carbazolyl)propionyloxy]ethylacrylat.

Besonders bevorzugte Monomere sind N-Vinylcarbazol, Ethoxyethoxyethylacrylat, 2-Naphthylacrylat, 2-Phenoxyethylacrylat, 2-Phenoxyethylmethacrylat, Phenolethoxylatacrylat, 2-(p-Chlorphenoxy)ethylacrylat, p-Chlorphenylacrylat, Phenylacrylat, 2-Phenylethylacrylat, 2-(1-Naphthyloxy)ethylacrylat, t-Butylacrylat, Isobornylacrylat, Cyclohexylacrylat, N,N-Diethylaminoethylacrylat, Acrylamid, Ethoxyethoxyethylacrylat, 1H,1H,2H,2H-Perfluoroctylmethacrylat und Pentafluorethylacrylat.

Bei den Polymerresten B) handelt es sich um Reste abgeleitet von in Wasser und/oder organischen Lösungsmitteln (wie Chloroform, Methylenchlorid, chlorierten Kohlenwasserstoffen, Toluol, Aceton, 2-Butanon, Methanol, Ethanol und Tetrahydrofuran) löslichen polymeren Bindern.

Beispiele für Binder sind Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Polyvinylbutyral und Polyvinylformal, Butadien und Isoprenpolymere und Copolymere und Polyethylenoxide aus Polyglycolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane. Als Binder geeignete Säure-enthaltende Polymere und Copolymere beinhalten die in den US-Patentschriften 3,458,311 und 4,273,857 offenbarten. Gleichfalls geeignet sind die amphoteren polymeren Bindemittel, die in der US-Patentschrift 4,293,635 beschrieben sind. Auf diese Bindemittel wird hiermit ausdrücklich Bezug genommen.

Besonders bevorzugte Bindemittel der vorliegenden Erfindung sind Celluloseacetatbutyrat-Polymere, Acrylpolymere und Copolymere, einschließlich Polymethylmethacrylat, Methylmethacrylat/Methacrylsäure- und Methylmethacrylat/Acrylsäure-Copolymere, Terpolymere von Methylmethacrylat/$C_2$-$C_4$-Alkylacrylat oder -methacrylat/Acryl- oder Methacrylsäure, Polyvinylacetat, Polyvinylacetal, Polyvinylbutyral, Polyvinylformal und Gemische davon.

Die polymeren Binder können die photoaktivierbaren Struktureinheiten P in der Seitenkette und/oder in der

Hauptkette tragen. Die von den erfindungsgemäßen polymeren Bindern abgeleiteten Polymerreste weisen ein Gewichtsmittel des Molekulargewichts in einem Bereich von 1.000 bis 1.000.000 g/mol auf.

Besonders bevorzugte Beispiele für polymere Binder, in denen eine der photoaktivierbaren Struktureinheiten P in einer Seitenkette enthalten ist, sind Polymere, die aus den in Tabelle 1 angegebenen Monomeren hergestellt werden oder Copolymere, wobei mindestens ein Monomer aus Tabelle 1 entnommen ist und die weiteren verwendeten Monomere keine der photoaktivierbaren Struktureinheiten P enthalten und aus den vorstehend genannten Beispielen ausgewählt sind. Beispiele sind in den Tabellen 2 und 3 dargestellt.

**Tabelle 2**

| P | X- | Y- | Z- |
|---|---|---|---|
| I / IV / V | 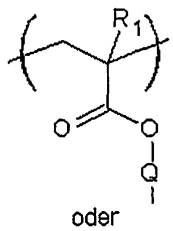 Polyacrylate<br>oder<br>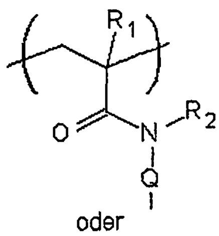 Polyacrylamide<br>oder | | - |
| II | 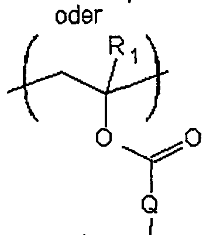 Vinylester<br>oder | R7 | R8 |
| III | 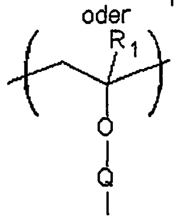 Polyvinylether<br>oder<br>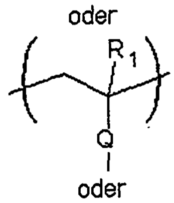 Polyvinyle<br>oder | | R8 |
| IIa, b | 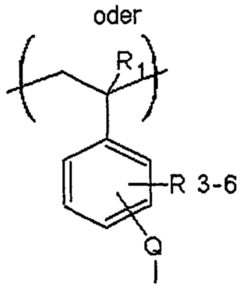 Polystyrole | - | - |

**Tabelle 3**

| P | X- | Y- | Z- |
| --- | --- | --- | --- |
| I / IV / V | 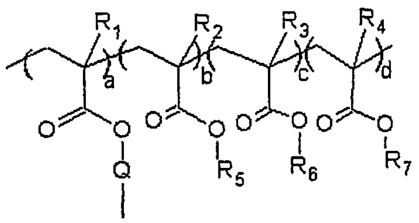 oder | | - |
| II | 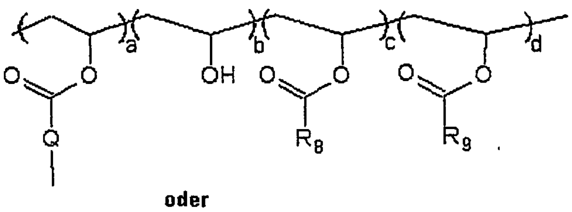 | $R_{17}$ | $R_{18}$ |
| III | oder 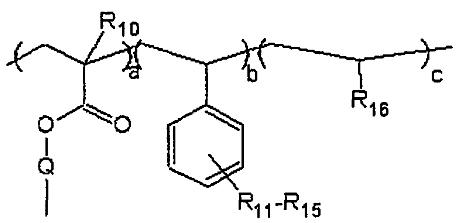 | | $R_{18}$ |
| IIa, b | a=5-50%; b, c, d=0-95% | | - |

Die in den Tabellen 2 und 3 angegebenen Reste haben die vorstehend für die Reste $R_1$ bis $R_8$ angegebene Bedeutung.

Beispiele für polymere Binder, die eine der photoaktivierbaren Struktureinheiten P in der Polymerhauptkette enthalten, sind jene mit folgenden Grundstruktureinheiten:

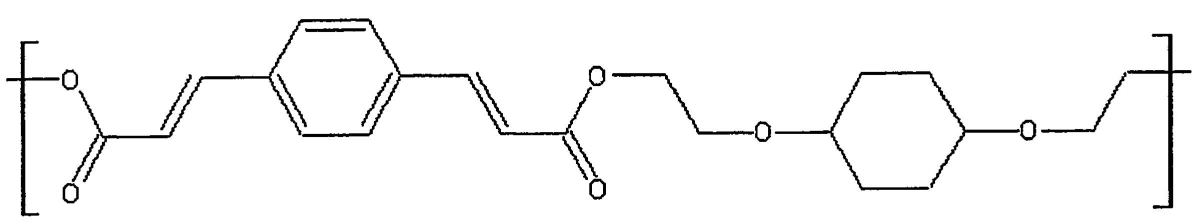

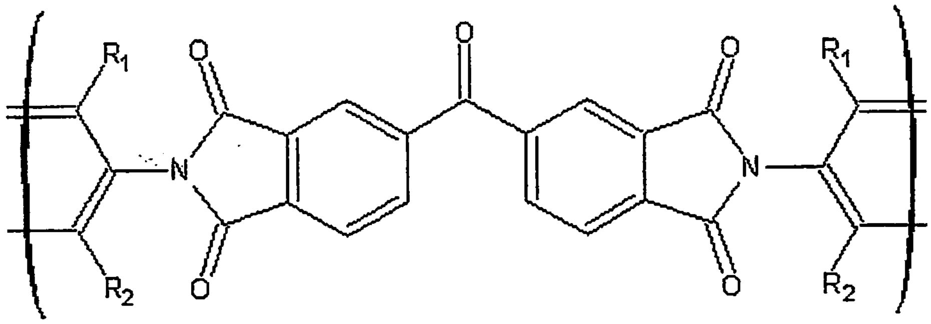

wobei und $R_1$ und $R_2$ die vorstehend angegebene Bedeutung haben.

Möglich sind auch Bindergemische, wobei eine Polymerkomponente die photoaktivierbare Struktureinheit enthält, die anderen Polymerkomponenten aber nicht.

Besonders bevorzugt sind solche Kombinationen von Bindern bzw. Bindergemischen und Monomeren bzw. Monomergemischen, die einen positiven, also verstärkenden Effekt in Bezug auf den resultierenden Brechungsunterschied haben. Dabei ist zu beachten, dass sich der Brechungsindex der photoaktivierbaren Struktureinheiten I, II und III bei der Vernetzung (insbesondere Photocycloaddition) verringert, der Brechungsindex der Struktureinheiten IV und V sich dagegen vergrößert (anderer Vernetzungsmechanismus). Daraus ergibt sich also, dass bei Verwendung von Monomeren bzw. Monomergemischen mit einem

a) hohen Brechungsindex sich die Struktureinheiten I, II und III für Binder besonders eignen, da dann die Brechungsindexmodulation durch die bei der Vernetzung eintretende Verringerung des Brechungsindex des Binders verstärkt wird. Bei einer solchen Kombination eignen sich darüber hinaus besonders solche Monomere bzw. Monomergemische, bei denen das Monomer oder eines der Monomere die Struktureinheit IV und/oder V tragen, da dann bei der Vernetzungsreaktion der Brechungsindex des Monomers oder des Monomerengemischs noch größer wird und somit die Brechungsindexmodulation noch weiter verstärkt wird. Beispiele für solche Kombinationen sind in Tabelle 4 dargestellt.

Tabelle 4

| Bindemittei (Anteil: : 25 - 75% | Monomere (Anteil: 5 - 50%) |
|---|---|
| 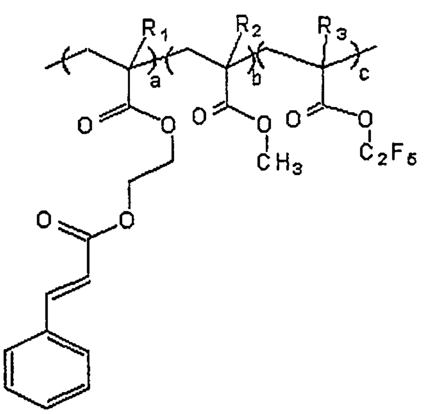<br>a= 5 - 50 %; b= 10 -95 %; c= 0 - 85 % | (Meth)acrylsäurephenylester<br>(Meth)acrylsäurebenzylester<br>(Meth)acrylsäure-2-phenoxyethylester<br>Acrylsäure-2-(p-chlorphenoxy)ethylester,<br>p-Chlorphenylacrylat<br>2-Phenylethyl(Meth)acrylat<br>Pentachlorphenylacrylat<br>p-Chlorstyrol |

(fortgesetzt)

| Bindemittei (Anteil: : 25 - 75% | Monomere (Anteil: 5 - 50%) |
|---|---|
| 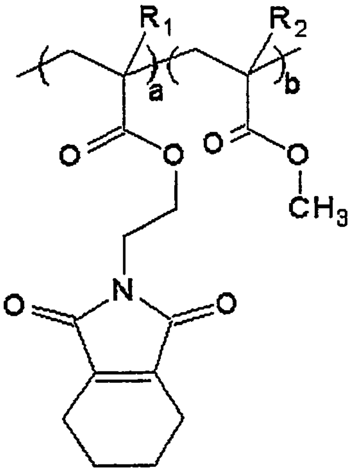<br>a = 5 - 100 %; b = 0 - 95 %; --- | • n-Vinylcarbazol,<br>• 2-Chlorstyrol<br>• 2-Bromstyrol<br>• p-Methoxystyrol<br>• Phenolethoxylatacrylat<br>• 2-(p-Chlorphenoxy)ethylacrylat<br>• 2-(1-Naphyloxy)ethylacrylat<br>• 2-[b-(N-Carbazolylpropion-yloxy]-ethylacrylat<br>• p-Chlorphenyl(meth)acrylat<br>• 2,4,6-Tribromphenyl-(meth)acrylat<br>• 2-Naphthylacrylat<br>• 4-(N,N'-Diphenylamino)-phenylacrylat |
| 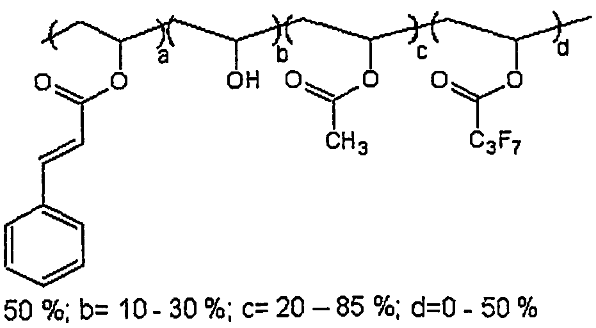<br>a= 5 - 50 %; b= 10 - 30 %; c= 20 – 85 %; d=0 - 50 % | • Acrylate und Methacrytate, die die photoaktivierbare Struktureinheit IV und/oder V enthalten<br>und Gemische der oben genannten Monomere |

(fortgesetzt)

| Bindemittei (Anteil: : 25 - 75% | Monomere (Anteil: 5 - 50%) |
|---|---|
| 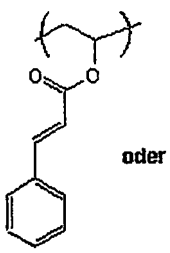 oder 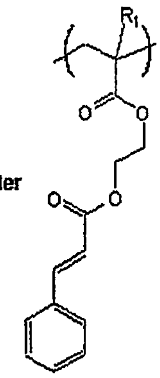 + PMMA und/oder Polyvinylacetat und/oder Celluloseacetatbutyrat und/oder Polyvinylbutyral<br>5-75% 25-95% | Monomere, wie 1. Teil der Tabelle |
| 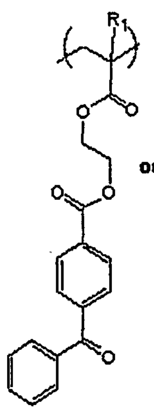 oder 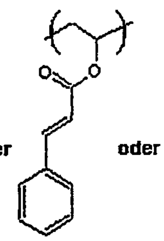 oder 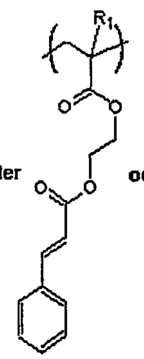 oder 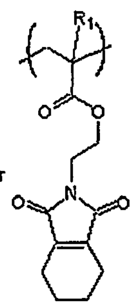 | |

b) niedrigem Brechungsindex sich die Struktureinheiten IV und V für Binder besonders eignen, da dann die Brechungsindexmodulation durch die bei der Vernetzung eintretende Erhöhung des Brechungsindex des Binders verstärkt wird. Darüber hinaus sind unter Umständen Binder geeignet, die die photoaktivierbaren Struktureinheiten I, II und III enthalten. Bei einer solchen Kombination eignen sich darüber hinaus besonders solche Monomere bzw. Monomergemische, bei denen das Monomer oder eines der Monomere die Struktureinheit I, II und/oder III tragen, da dann bei der Vernetzungsreaktion der Brechungsindex des Monomers oder des Monomerengemischs geringer wird und somit die Brechungsindexmodulation zusätzlich verstärkt wird. Beispiele für solche Kombinationen sind in Tabelle 5 dargestellt.

Tabelle 5

| Bindemittel (Anteil: 25 - 75%) | Monomere (Anteil: 5 - 60%) |
|---|---|
| 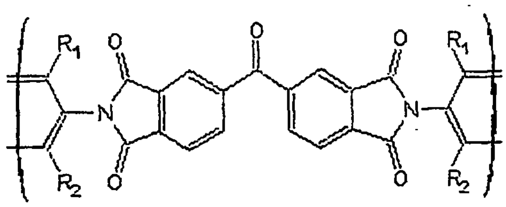<br>**oder**<br>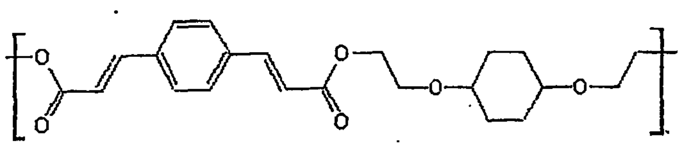 | (Meth)acrylsäurebutylester<br>(Meth)acrylsäureisobornylester<br>(Meth)acrylsäurecyclohexylester<br>(Meth)acrylsäure-1H,1H,2H,2H-perfluoroctylester<br>2,2,2-Trifluorethyl(Meth)acrylat<br>Heptafluorpropyl(Meth)acrylat<br>1,1,1,3,3,3-Hexyfluoriso-propyl-(Meth) acrylat<br>2,2,3,3-Tetrafluorpropyl-(Meth)acrylat) |
| 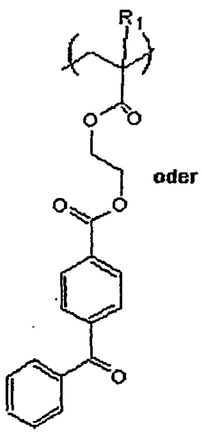 **oder** 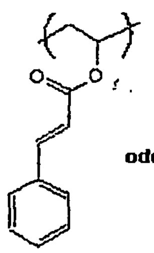 **oder** 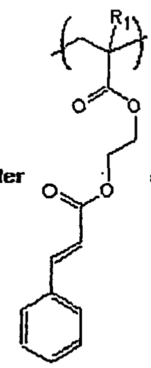 **oder** 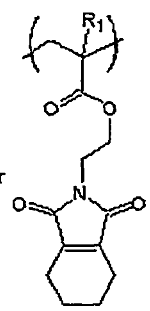 | 2,2,3,3,4,4,4-Heptafluorbutyl(Meth) acrylat<br>2,2,3,3,4,4,5,5-Octafluor-pentyl-(Meth) acrylat<br>Acrylsäure-N,N-diethylamino-ethylester<br>Acrylsäureethoxyethyoxyethyl-ester,<br>N-Vinyl-2-pyrrolidon<br>Acrylamid<br>Acrylate und Methacrylate, die die photoaktivierbaren Struktur-einheiten I, II oder III enthalten<br><br>und Gemische der oben genannten Monomere |

(fortgesetzt)

| Bindemittel (Anteil: 25 - 75%) | Monomere (Anteil: 5 - 60%) |
|---|---|
| 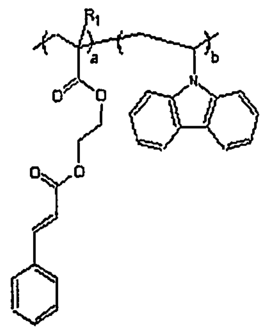 oder 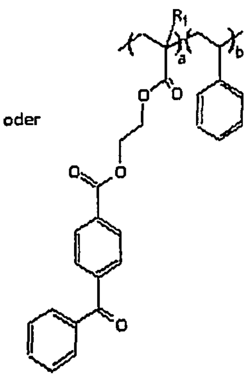 a = 25 - 75 %; b = 25 - 75 %; | |
| 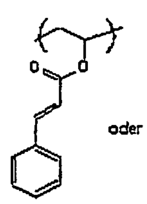 oder 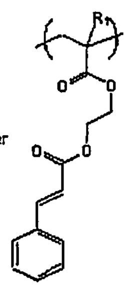 + Polystyrol und/oder Polyvinylcarbazol und/oder Polybenzylmethacrylat und/oder Poly(styrolacrylnitril) 5-75% 25-95% | Monomere wie 1. Teil der Tabelle |
| 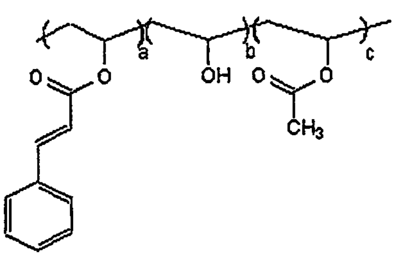 | |
| 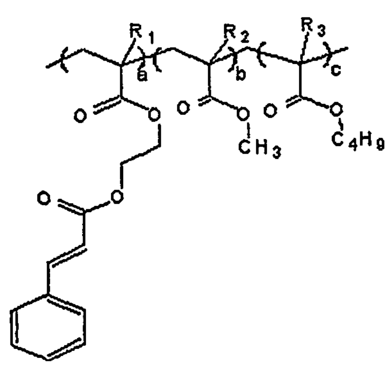 | |

Die in den Tabellen 4 und 5 angegebenen Reste haben die vorstehend angegebene Bedeutung.

Geeignete Beispiele von Monomeren in Zusammensetzungen, in denen das polymere Bindemittel die photoaktivierbare Struktureinheit P trägt, beinhalten die vorstehend genannten.

Geeignete Bindemittel in den erfindungsgemäßen Zusammensetzungen, in denen das Monomer die photoaktivierbare Struktureinheit P trägt, sind die in Wasser und/oder organischen Lösungsmittel löslichen Polymere und Copolymere, die aus den vorstehend genannten Monomeren und Comonomeren erhalten werden können.

Radikalbildende Polymerisationsintitiatoren sind bekannt, vgl. z.B. Timpe, H.J. und S. Neuenfeld, "Dyes in

photoinitiator systems", Kontakte (1990), Seiten 28-35 und Jakubiak, J. und J.F. Rabek, "Photoinitiators for visible light polymisation", Polimery (Warschau) (1999), 44, Seiten 447-461.

Zu den geeigneten radikalbildenden Polymerisationsinitiatoren, die durch UV-Strahlung aktivierbar und bei und unterhalb 185˚C inaktiv sind, gehören die substituierten oder unsubstituierten mehrkernigen Chinone - Verbindungen mit zwei intracyclischen Kohlenstoff-Atomen in einem konjugierten carbocyclischen Ringsystem, z.B. 9,10-Anthrachinon, 1-Chloranthrachinon, 2-Chloranthrachinon, 2-Methylanthrachinon, 2-Ethylanthrachinon, 2-tert-Butylanthrachinon, Octamethylanthrachinon, 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, Natrium-Salz von Anthrachinon-αsulfonsäure, 3-Chlor-2-methylanthrachinon, Retenchinon, 7,8,9,10-Tetrahydronaphthacenchinon und 1,2,3,4-Tetrahydrobenz[a]anthracen-7,12-dion. Weitere Photoinitiatoren, die ebenfalls brauchbar sind, wenn auch manche bei so niedrigen Temperaturen wie 85˚C thermisch aktiv sind, sind in US-Patent 2 760 663 beschrieben, und zu ihnen zählen vicinale Ketaldonylalkohole wie etwa Benzoin, Pivaloin, Acyloinether, z.B. Benzoinmethyl- und -ethylether, α-Kohlenwasserstoff-substituierte aromatische Acyloine, darunter α-Methylbenzoin, α-Allylbenzoin und α-Phenylbenzoin. Als Initiator verwendbar sind photoreduzierbare Farbstoffe und Reduktionsmittel wie etwa die in den US-Patenten 2 850 445, 2 875 047, 3 097 096, 3 074 974, 3 097 097, 3 145 104 und 3 579 339 offenbarten, sowie Farbstoffe aus der Klasse der Phenazine, Oxazine und Chinone; Michlers Keton, Benzophenon, 2,4,5-Triphenylimidazolyl-Dimere mit Wasserstoff-Donoren und deren Mischungen, wie beschrieben in den US-Patenten 3 427 161, 3 479 185, 3 549 367, 4 311 783, 4 622 286 und 3 784 557. Eine brauchbare Diskussion der farbstoffsensibilisierten Photopolymerisation findet sich in "Dye Sensitized Photopolymerization" von D.F: Eaton in Adv. in Photochemistry, Bd. 13, D.H. Volman, G.S. Hammond und K. Gollnick, Hrsg., Wiley-Interscience, New York, 1986, S. 427-487. In gleicher Weise sind auch die Cyclohexadienon-Verbindungen von US-Patent Nr. 4 341 860 als Initiatoren brauchbar. Zu den geeigneten Photoinitiatoren gehören CDM-HABI, d.h., 2-(o-Chlorphenyl)-4,5-bis (m-methoxyphenyl)-imidazol-Dimer; o-Cl-HABI, d.h., 2,2'-Bis(o-chlorphenyl)-4,4',5,5'-tetraphenyl-1,1'-biimidazol; und TCTM-HABI, d.h., 2,5-Bis(o-chlorphenyl)-4-(3,4-dimethoxyphenyl)-1H-imidazol-Dimer, die jeweils typischerweise mit einem Wasserstoff-Donor verwendet werden, z.B. 2-Mercaptobenzoxazol.

Zu den Sensibilisierungsmitteln, die mit Photoinitiatoren brauchbar sind, gehören Methylenblau und die in den US-Patenten 3 554 753, 3 563 750, 3 563 751, 3 647 467, 3 652 275, 4 162 162, 4 268 667, 3 351 893, 4 454 218, 4 535 052 und 4 565 769 offenbarten, auf die hierin ausdrücklich Bezug genommen wird. Zu den besonders bevorzugten Sensibilisierungsmitteln gehören die folgenden: DBC, d.h., 2,5-Bis[(4-diethylamino-2-methylphenyl)methylen]cyclopentanon, DEAW, d.h., 2,5-Bis[(4-diethylaminophenyl)methylen]cyclopentanon, und Dimethoxy-JDI, d.h., 2,3-Dihydro-5,6-dimethoxy-2-[(2,3,6,7-tetrahydro-1H,5H-benzo[i,j]chinolizin-9-yl)methylen]-1H-inden-1-on.

Die festen photopolymerisierbaren Zusammensetzungen können einen Weichmacher enthalten, um die Modulation des Brechungsindex der mit Bild versehenen Zusammensetzung zu verstärken. Weichmacher können in Mengen eingesetzt werden, die von etwa 2 bis etwa 25 Gew.-% reichen, vorzugsweise 5 bis etwa 15 Gew.-%. Zu den geeigneten Weichmachern gehören Triethylenglycol, Triethylenglycoldiacetat, Triethylenglycoldipropionat, Triethylenglycoldicaprylat, Triethylenglycoldimethylether, Triethylenglycolbis(2-ethylhexanoat), Tetraethylenglycoldiheptanoat, Polyethylenglycol, Polyethylenglycolmethylether, Isopropylnaphthalin, Diisopropylnaphthalin,Polypropylenglycol, Glyceryltributyrat, Diethyladipat, Diethylsebacinat, Dibutylsuberinat, Tributylphosphat, Tris(2-ethylhexyl)phosphat, Brij® 30 [$C_{12}H_{25}(OCH_2CH_2)_4OH$], sowie Brij® 35 [$C_{12}H_{25}(OCH_2CH_2)_{20}OH$].

Besonders bevorzugte Weichmacher zur Verwendung in einfachen Celluloseacetat-butyrat-Systemen sind Triethylenglycoldicaprylat, Tetraethylenglycoldiheptanoat, Diethyladipat, Brij® 30 und Tris(2-ethylhexyl)phosphat.

Weitere Weichmacher, die äquivalente Ergebnisse erbringen, sind dem Fachmann geläufig und können erfindungsgemäß eingesetzt werden. Falls gewünscht, können andere übliche Komponenten, die in Photopolymer-Systemen verwendet werden, mit den Zusammensetzungen und Elementen dieser Erfindung eingesetzt werden. Zu diesen Komponenten gehören: Optische Aufheller, ultraviolette Strahlung absorbierendes Material, thermische Stabilisatoren, Wasserstoff-Donoren, Sauerstoff-Fänger und Trennmittel.

Zu den für das erfindungsgemäße Verfahren brauchbaren optischen Aufhellern gehören die im hierin als Zitat angeführten US-Patent 3 854 950 offenbarten. Ein bevorzugter optischer Aufheller ist 7-(4'-Chlor-6'-diethylamino-1',3', 5'-triazin-4'-yl)amino-3-phenylcumarin. Auch ultraviolette Strahlung absorbierende Materialien, die für diese Erfindung brauchbar sind, sind im US-Patent 3 854 950 offenbart.

Zu den brauchbaren thermischen Stabilisatoren gehören: Hydrochinon, Phenidon, p-Methoxyphenol, Alkyl- und Aryl-substituierte Hydrochinone und Chinone, tert-Butylcatechin, Pyrogallol, Kupferresinat, Naphthylamine, β-Naphthol, Kupfer(I)-chlorid, 2,6-Di-tert-butyl-p-cresol, Phenothiazin, Pyridin, Nitrobenzol, Dinitrobenzol, p-Toluchinon und Chloranil. Brauchbar sind auch die im hierin angeführten US-Patent 4 168 982 beschriebenen Dinitroso-Dimere. Normalerweise ist auch ein Inhibitor für die thermische Polymerisation vorhanden, um die Stabilität bei der Lagerung der photopolymerisierbaren Zusammensetzung zu erhöhen.

Zu den als Kettenübertragungsreagenzien in den Photopolymer-Zusammensetzungen brauchbaren Wasserstoff-Donorverbindungen gehören: 2-Mercaptobenzoxazol, 2-Mercaptobenzothioazol etc. sowie verschiedene Arten

von Verbindungen, z.B. (a) Ether, (b) Ester, (c) Alkohole, (d) Verbindungen, die allylischen oder benzylischen Wasserstoff enthalten wie etwa Cumol, (e) Acetale, (f) Aldehyde, und (g) Amide, wie offenbart in Spalte 12, Zeilen 18 bis 58 in US-Patent 3 390 996, auf die hierin ausdrücklich Bezug genommen wird.

Verbindungen, die sich als Trennmittel brauchbar erwiesen haben, sind beschrieben in US-Patent 4 326 010. Ein bevorzugtes Trennmittel ist Polycaprolacton.

Die Mengen der Bestandteile in den photopolymerisierbaren Zusammensetzungen liegen innerhalb der folgenden Prozentbereiche, bezogen auf das Gesamtgewicht der photopolymerisierbaren Zusammensetzung: Monomer 5-60%, vorzugsweise 15-50%, Initiator 0,1-10%, vorzugsweise 1-5%, Bindemittel 25-75%, vorzugsweise 45-65%, Weichmacher 0-25%, vorzugsweise 5-15%, und weitere Bestandteile 0-5%.

Als Substrate können Verbindungen aus Glas, Kunststoff, insbesondere PET oder Papier verwendet werden.

**Beschreibung der Zeichnungen**

Figur 1 zeigt die Veränderung des Beugungswirkungsgrads (BWG) als Funktion der Belichtungszeit bei der Laser-Belichtung zur Erzeugung eines Hologramms wie in Beispiel 1 beschrieben.

Figur 2 zeigt die Veränderung des Beugungswirkungsgrads (BWG) als Funktion der Belichtungszeit bei der UV-Belichtung nach der Erzeugung des Hologramms wie in Beispiel 1 beschrieben.

Figur 3 zeigt die Veränderung des Beugungswirkungsgrads (BWG) als Funktion der Belichtungszeit bei der Laser-Belichtung zur Erzeugung eines Hologramms wie in Vergleichsbeispiel 1 beschrieben.

Figur 4 zeigt die Veränderung des Beugungswirkungsgrads (BWG) als Funktion der Belichtungszeit bei der UV-Belichtung nach der Erzeugung des Hologramms wie in Vergleichsbeispiel 1 beschrieben.

Figur 5 zeigt die Veränderung des Beugungswirkungsgrads (BWG) als Funktion der Belichtungszeit bei der Laser-Belichtung zur Erzeugung eines Hologramms wie in Vergleichsbeispiel 2 beschrieben.

Figur 6 zeigt die Veränderung des Beugungswirkungsgrads (BWG) als Funktion der Belichtungszeit bei der UV-Belichtung nach der Erzeugung des Hologramms wie in Vergleichsbeispiel 2 beschrieben.

Die Figuren 7, 8 und 9 zeigen jeweils die Veränderung der Temperatur (T) (Kurve A) und des Beugungswirkungsgrads (BWG) (Kurve B) als Funktion der Meßzeit bei der Temperaturschock-Behandlung zur Untersuchung der thermischen Stabilität der erzeugten Hologramme wie in Beispiel 1 (Figur 7), Vergleichsbeispiel 1 (Figur 8) und Vergleichsbeispiel 2 (Figur 9) beschrieben.

Figur 10 zeigt UV-Spektren einer sehr dünnen Schicht eines wie in Beispiel 1 beschrieben hergestellten Aufzeichnungsmaterials vor der UV-Belichtung (Kurve A) und nach der UV-Belichtung (Kurve B).

Figur 11 zeigt UV-Spektren einer sehr dünnen Schicht eines wie in Beispiel 1 beschrieben hergestellten polymeren Binders vor der UV-Belichtung (Kurve A) und nach der UV-Belichtung (Kurve B).

Figur 12 zeigt UV-Spektren einer sehr dünnen Schicht eines wie in Vergleichsbeispiel 1 beschrieben hergestellten Aufzeichnungsmaterials vor der UV-Belichtung (Kurve A) und nach der UV-Belichtung (Kurve B).

Figur 13 zeigt die Reflexionsintensitätsspektren wie in Beispiel 1 beschrieben hergestellter Reflexionshologramme nach 2-stündigem Backen bei 100˚C mit UV-Belichtung (Kurve A) und ohne UV-Belichtung (Kurve B) vor dem Backen.

Beispiele

Im Folgenden wird die Erfindung anhand von Beispielen näher erläutert.

Allgemeine Angaben

Bei der Ausführung der im Folgenden beschriebenen Beispiele werden die Grundlagen der präparativen

Chemie, insbesondere der Polymerchemie, die zum Beispiel beschrieben sind in "Reaktionen und Synthesen im organisch chemischen Praktikum und Forschungslaboratorium", L.F. Tietze, T. Eicher, Thieme-Verlag (1991) oder "Makromoleküle", Band 1 und 2, H.-G. Elias, Hüthig & Wepf Verlag (1990), als bekannt vorausgesetzt.

Verbindungen, deren Darstellung hier nicht näher beschrieben ist, sind kommerziell erhältlich.

Beispiel 1

1. Herstellung eines polymeren Binders mit photoaktivierbaren Struktureinheiten

a) Herstellung von Cinnamoyloxyethylmethacrylat (COEMA)

In einem 2000ml-Dreihalskolben mit mechanischem Rührer, Tropftrichter mit Druckausgleich und Intensivkühler mit Gasblubberer (Rückschlagventil) wurden 121,3 ml (1 mol) Hydroxyethylmethacrylat, 154,6 ml (1,1 mol) Triethylamin, 3,48 g (0,022 mol) 4-Dimehtylaminopyridin und 10 mg 2,6-Di-tert.-butyl-4-methylphenol in 600 ml Dichlormethan vorgelegt.

183,3 g (1,1 mol) Zimtsäurechlorid wurden in 400 ml Dichlormethan gelöst (klare, leicht gelbe Lösung) und in den Tropftrichter gegeben. Unter Rühren wurde die Lösung eingetropft. Gegen Ende des Zutropfens bildeten sich starker Rauch und ein weißer Niederschlag. Nach dem das Zutropfen beendet war, wurde über Nacht mit einem Heizpilz unter Rückfluss erhitzt.

In die abgekühlte Suspension wurden 120 ml entsalztes Wasser gegeben. Dadurch löste sich der Niederschlag auf, und es entstanden zwei leicht gelbliche Phasen. Die organische Phase wurde zwei Mal mit verdünnter Natronlauge, dann ein Mal mit Wasser, mit verdünnter Salzsäure und noch ein Mal mit Wasser im Scheidetrichter gewaschen. Es wurde nochmals verdünnte Natronlauge zugegeben und mindestens 12 Stunden intensiv gerührt. Anschließend wurde die organische Phase mit Wasser neutral gewaschen, abgetrennt und über Natriumsulfat getrocknet.

Das Produkt wurde zuerst über saures, dann basisches und noch ein Mal saures Aluminiumoxid gegeben und im Vakuum getrocknet.

Auf diese Weise wurden ca. 175 g Cinnamoyloxyethylmethacrylat (COEMA) als zähe, klare Flüssigkeit mit sehr leicht gelber Färbung erhalten.

b) Herstellung eines polymeren Binders (P(COEMA-co-MMA)) durch Copolymerisation von Cinnamoyloxyethylmethacrylat (COEMA) und Methylmethacrylat (MMA)

In einen Dreihalskolben mit Intensivkühler mit Gasblubberer (Rückschlagventil), Thermometer und Gaseinleitungskapillare sowie magnetischem Rührer wurden 30 g des wie unter a) beschrieben erhaltenen Cinnamoyloxyethylmethacrylats (COEMA), 70 g Methylmethacrylat (MMA) (entstabilisiert über basischem Aluminiumoxid), 0,1 g AIBN (umkristallisiert) und 150 g Toluol gegeben.

Über die Gaseinleitungskapillare wurde für ca. 30 Minuten Stickstoff in das Reaktionsgemisch geblasen. Dann wurde der Kolben in ein vorgeheiztes Ölbad getaucht und die Temperatur so reguliert, dass im Inneren des Kolbens eine Temperatur von 80˚C konstant gehalten wurde. Nach 4 Stunden wurde die Heizquelle entfernt und die Reaktion mit 4-Methoxyphenol gestoppt.

Die entstandene Lösung wurde mit 150 ml Methylethylketon verdünnt und über einen 1µm-Filter filtriert. Dann wurde das Polymer durch Eintropfen in Methanol gefällt, abfiltriert und getrocknet.

Auf diese Weise wurden 67 g eines Copolymeren aus Cinnamoyloxyethylmethacrylat und Methylmethacrylat (P(COEMA-co-MMA)) als weißes flockiges Polymer erhalten.

Die Struktur des so erhaltenen Binders kann durch folgende Formel wiedergegeben werden:

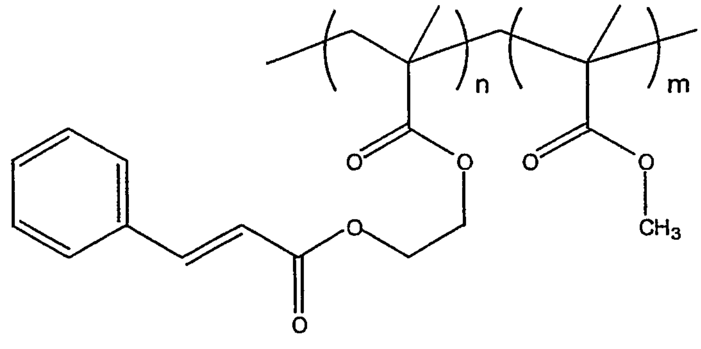

2. Herstellung eines Photoinitiators

Der Photoinitiator 2,2'-Bis(o-chlorphenyl)-4,4',5,5'-tetraphenyl-1,1'-bisimidazol (o-Cl-HABI) wurde gemäß der Vorschrift auf Seite 327 in D. Davidson, M. Weiss, M. Jelling; J. Am. Chem. Soc. 1936, 58, 319-327 hergestellt.

3. Herstellung eines Farbstoffs

Der Farbstoff 2,5-Bis[(4-diehtylaminophenyl)methylen]cyclopentanon (DEAW) wurde in entsprechender Anwendung der Synthesevorschrift für 2,5-Bis[(2,3,6,7-tetrahydro-1H,5H-benzo[i,j] chinolizin-1-yl)methylen]cyclopentanon auf Seite 5656 in M.D. Zammit, T.P. Davis, G.D. Willet, Macromolecules, 1997, 30, 5655-5659 hergestellt.

4. Herstellung einer Beschichtungslösung einer erfindungsgemäßen Zusammensetzung

In einem Gemisch aus 10,65 g Methylethylketon und 0,0563 g Methanol wurden folgende Komponenten gelöst: 4,05 g des wie unter 1. beschrieben erhaltenen Copolymeren P(COEMA-co-MMA) als polymerer Binder mit photoaktivierbaren Struktureinheiten, 1,993 g 2-Phenoxyethylacrylat (POEA) (entstabilisiert mit basischem Aluminiumoxid) als erstes Monomer, 0,854 g N-Vinylcarbazol als zweites Monomer, 0,085 g des wie unter 2. beschrieben erhaltenen 2,2'-Bis(o-chlor-phenyl)-4,4',5,5'-tetraphenyl-1,1'-bisimidazol (o-Cl-HABI) als Photoinitiator, 0,128 g 2-Mercaptobenzoxazol als Transferreagenz, 0,0071 g des wie unter 3. beschrieben erhaltenen 2,5-Bis[(4-diehtylaminophenyl)methylen]cyclopentanon (DEAW) als Farbstoff und 0,000712 g 4-Methoxyphenol als Stabilisator.

Von den genannten Komponenten wurden zunächst das Copolymer und die Lösungsmittel in ein braunes Schraubdeckelglas eingewogen und durch magnetische Rührung die vollständige Auflösung herbeigeführt. Danach wurden die übrigen Komponenten zugegeben, das Glas in Aluminiumfolie verpackt, unter Stickstoff gesetzt und das Gemisch gerührt bis alle Stoffe gelöst waren. Gegebenenfalls ungelöst bleibende Restanteile von Feststoffen wurden durch Filtration mit einem 0,45μm-5μm Teflon-Spritzenfilter entfernt.

5. Herstellung eines holographischen Aufzeichnungsmaterials

Die wie unter 4. beschrieben erhaltene Beschichtungslösung wurde in einer Flowbox mit Hilfe eines automatischen Filmziehgeräts (Modell Coatmaster 509 MC der Firma Erichsen) auf PET-Folie aufgebracht. Als Rakel wurde ein stufenlos einstellbares Modell verwendet. Die verwendeten Spalthöhen betrugen 90 - 175 μm. Nach dem vollständigen Abdampfen der Lösungsmittel betrugen die Schichtdicken ungefähr 34 - 43 μm.

Für die nachfolgend beschriebenen Untersuchungen wurde die so beschichtete PET-Folie in Streifen geschnitten und mit der beschichteten Seite nach unten auf Objektglasträger appliziert, um eine Probe eines holographischen Aufzeichnungsmaterials zu erhalten.

Für praktische Anwendungen konnte die Schicht des holographischen Aufzeichnungsmaterials nach dem vollständigen Trocknen auch mit einer zweiten PET-Folie laminiert werden.

6. Erzeugung eines Hologramms

a) Laser-Belichtung zur Erzeugung eines holographischen Gittermusters

In der wie unter 5. beschrieben erhaltenen Probe wurde ein Hologramm durch Laser-Belichtung erzeugt. Dazu wurde der Objektglasträger mit der Probe in einen Probenhalter mit der Glasseite zur Einfallsrichtung des Laser-Lichts eingelegt. Zur Belichtung wurden zwei Laserstrahlen mit einer Wellenlänge von 532 nm (Laserquelle Modell Verdi der Firma Coherent) symmetrisch unter einem Winkel von jeweils etwa 17.2 Grad zum Lot auf die Probe eingestrahlt und erzeugten durch Interferenz ein Gittermuster mit einem Linienabstand von 0.9 μm.

Zur Messung des Beugungswirkungsgrads (BWG) und damit zur Verfolgung der Entstehung des holographischen Gittermusters während der Laser-Belichtung wurde zusätzlich ein Meßstrahl eines HeNe-Laser mit einer Wellenlänge von 633 nm unter dem für die Rekonstruktion des Gitters angepaßten Winkel von 20.6 Grad auf die Probe eingestrahlt. Der an dem Gitter gebeugte HeNe-Laserlichtstrahl wurde von einem Detektor erfaßt und seine Intensität gemessen.

Der Beugungswirkungsgrad berechnet sich aus dem Verhältnis der Intensität des gebeugten Laserstrahls (Ig) zur Gesamtintensität des gebeugten und ungebeugten Laserstrahls ($Ig + I_u$) gemäß folgender Gleichung:

$$BWG = \frac{I_g}{I_u + I_g}$$

Die gemessene Veränderung des Beugungswirkungsgrads als Funktion der Belichtungszeit ist in Figur 1 dargestellt.

Die Probe wurde so belichtet, daß auch durch eine längere Belichtungszeit oder höhere Intensitäten keine weitere Steigerung des Beugungswirkungsgrads zu erreichen war. Dies läßt sich im Verlauf der Belichtungskurve (BWG als Funktion der Belichtungszeit, Figur 1) erkennen, welche zunächst stark ansteigt und dann immer weiter abflacht bis sie nahezu horizontal verläuft.

b) UV-Belichtung nach der Erzeugung des Hologramms

Nach der Laser-Belichtung zur Erzeugung des Hologramms wurde die Probe mit UV-Licht (Lichtquelle: Modell Lightningcure 2000 der Firma Hamamatsu) bestrahlt. Das UV-Licht hatte am Bestrahlungsort bei 280 nm eine Intensität von 250 $mW/cm^2$.

Hierbei wurde ebenfalls die Veränderung des Beugungswirkungsgrades als Funktion der Belichtungszeit erfaßt. Die Messung erfolge wie unter a) beschrieben. Der gemessene Verlauf ist in Figur 2 dargestellt.

Anhand des Beugungswirkungsgrads (BWG) und der Schichtdicke d läßt sich mit Hilfe der Kogelnik-Theorie (siehe "Coupled Wave Theory for Thick Hologram Gratings", The Bell System Technical Journal vom 23. 05. 1969) die Brechungsindexamplitude ($\Delta$n) der Gitterstruktur gemäß folgender Formel berechnen:

$$\Delta n = \arcsin(\sqrt{BWG}) \cdot \lambda \cdot \frac{\cos\varphi \cdot \cos\gamma}{\pi \cdot d}$$

Dabei sind:

$$\varphi = 0.5 \cdot (\alpha_m - \beta_m)$$

$$\gamma = \alpha_m - \varphi$$

$\alpha_m$ = arcsin (sin ($\alpha$)/n), $\beta_m$ = arcsin (sin ($\beta$)/n)
$\alpha$ = Einfallswinkel des 1. Strahls
$\beta$ = Einfallswinkel des 2. Strahls
n = Brechungsindex des Aufzeichnungsmaterials

Die vor und nach der UV-Belichtung gemessenen Werte des Beugungswirkungsgrads (BWG) und der Brechungsindexamplitude $\Delta$n) sind zusammen mit den entsprechenden Ergebnissen für die nachfolgend beschriebenen Vergleichsbeispiele in der Tabelle 1 zusammengefaßt.

Tabelle 1

| | Schichtdikke (µm) | BWG vor der UV-Belichtung (%) | BWG nach der UV-Belichtung (%) | $\Delta$n vor der UV-Belichtung | $\Delta$n nach der UV-Belichtung |
|---|---|---|---|---|---|
| Beispiel 1 | 34 | 82,80 | 96,34 | 0,0089 | 0,0136 |
| Vergleichsbeispiel 1 | 41 | 87,13 | 83,40 | 0,0080 | 0,0074 |
| Vergleichsbeispiel 2 | 35 | 75,23 | 59,34 | 0,0074 | 0,0057 |

7. Nachweis der Vernetzung des polymeren Binders während der UV-Belichtung

Um nachzuweisen, daß der polymere Binder mit photoaktivierbaren Struktureinheiten durch die UV-Belichtung vernetzt, wurde eine dünne Schicht des Aufzeichnungsmaterials UV-spektroskopisch untersucht.

Die vor und nach der wie unter 6. b) beschrieben durchgeführten UV-Belichtung aufgenommenen UV-Spektren sind in Figur 10 gargestellt (Kurve A: vor der Belichtung, Kurve B: nach der Belichtung).

Zum Vergleich wurden auch W-Spektren einer dünnen Schicht des wie unter 1. beschrieben hergestellten polymeren Binders (ohne Zusatz der weiteren Komponenten des Aufzeichnungsmaterials) vor und nach einer wie unter 6. b) beschrieben durchgeführten UV-Belichtung aufgenommenen. Diese Spektren sind in Figur 11 dargestellt (Kurve A: vor der Belichtung, Kurve B: nach der Belichtung).

Das W-Absorptionsspektrum des reinen wie unter 1. beschrieben hergestellten Binders zeigt vor der UV-Belichtung eine Bande bei 280 nm, die für die Doppelbindung in der von der Zimtsäure abgeleiteten Struktureinheit des Binders charakteristisch ist.

Der Vergleich der in den Figuren 10 und 11 dargestellten Spektren zeigt, daß die UV-Absorption auch beim holographischen Aufzeichnungsmaterial im Bereich von 280 nm durch die UV-Belichtung abnimmt. Diese Beobachtung belegt, daß die von der Zimtsäure abgeleitete photoaktivierbare Struktureinheit des Binders während der UV-Belichtung an einer Vernetzungsreaktion teilnimmt.

Zum weiteren Vergleich wurden entsprechende Spektren auch für eine dünne Schicht eines wie im folgenden Vergleichsbeispiel 1 beschrieben hergestellten Aufzeichnungsmaterials vor und nach einer wie unter 6. b) beschrieben durchgeführten UV-Belichtung aufgenommenen. Diese Spektren sind in Figur 12 dargestellt (Kurve A: vor der Belichtung, Kurve B: nach der Belichtung). Hier ist die Abnahme der UV-Absorption im Bereich von 280 nm durch die UV-Belichtung wesentlich schwächer und nur auf die Ausbleichung des Photoinitiators zurückzuführen.

8. Untersuchung der thermischen Stabilität des erzeugten Hologramms

a) Temperaturschock-Behandlung

Nach der UV-Belichtung wurde die Probe noch einer kurzzeitigen thermischen Belastung (Temperaturschock) ausgesetzt. Dazu wurde die Probe innerhalb von einer Minute mit Hilfe eines Warmluftgebläses auf etwa 100˚C erwärmt. Nach Erreichen dieser Temperatur wurde das Gebläse ausgeschaltet, so daß sich die Probe wieder abkühlte. Während der Erwärmung und der anschließenden Abkühlung wurden die Temperatur und der Beugungswirkungsgrad der Probe erfaßt. Die Veränderungen dieser Größen als Funktion der Meßzeit sind in Figur 7 (Kurve A: Temperatur, Kurve B: BWG) dargestellt. Die Gesamtmeßzeit betrug 10 min.

Die vor der Temperaturschock-Behandlung und nach dem Abkühlen gemessenen Werte des Beugungswirkungsgrads sind zusammen mit den entsprechenden Ergebnissen für die nachfolgend beschriebenen Vergleichsbeispiele in der Tabelle 2 zusammengefaßt.

Tabelle 2

| | BWG vor der Temperaturschock-Behandlung (%) | BWG nach der Temperaturschock-Behandlung |
|---|---|---|
| Beispiel 1 | 96,30 | 95,80 |
| Vergleichsbeispiel 1 | 83,40 | 7,30 |
| Vergleichsbeispiel 2 | 59,30 | 47,30 |

Der starke Abfall des Beugungswirkungsgrades bei Vergleichsbeispiel 1 erklärt sich u. a. dadurch, daß der Meßwinkel konstant gelassen worden ist, der optimale Rekonstruktionswinkel sich aber durch den Temperatureinfluß verschoben hat. Als optimaler Rekonstruktionswinkel wird der Einfallswinkel bezeichnet, unter dem der maximale Beugungswirkungsgrad gemessen wird.

b) Ausbacken

Auch die Wirkung einer längerdauernden Temperaturerhöhung (Bakken) wurde untersucht. Dazu wurde die Probe nach der UV-Belichtung zwei Stunden lang in einem Ofen bei 100˚C gebacken.

Danach wurde der maximale Beugungswirkungsgrad im optimalen Rekonstruktionswinkel nochmals vermessen. Die Meßwerte und die daraus berechneten Brechungsindexamplituden (Δn) sind zusammen mit den entsprechenden Ergebnissen für die nachfolgend beschriebenen Vergleichsbeispiele in der Tabelle 3 zusammengefaßt.

Tabelle 3

| | BWG vor dem Backen (%) | BWG nach dem Backen (%) | Δn nach dem Backen |
|---|---|---|---|
| Beispiel 1 | 96,34 | 94,02 | 0,0122 |
| Vergleichsbeispiel 1 | 83,40 | 94,36 | 0,0100 |
| Vergleichsbeispiel 2 | 59,34 | 83,66 | 0,0086 |

9. Erzeugung eines Reflexionshologramms und dessen Untersuchung

In einer wie unter 5. beschrieben hergestellten Probe wurde auch ein Reflexionshologramms erzeugt.

Dabei wurde ein erster Laser-Strahl von vorne und ein zweiter Laser-Strahl von hinten auf die Probe eingestrahlt. Dadurch liegen die Gitterebenen der Interferenzstruktur nahezu parallel zu der Oberfläche der Schicht des Aufzeichnungsmaterials. Dies hat zur Folge, daß die einzelnen Gitterebenen eingestrahltes Licht reflektieren, allerdings abhängig vom Abstand der Gitterebenen nur eine bestimmte Wellenlänge, die die sogenannte Bragg-Bedingung erfüllt. Nimmt z.B. der Abstand der Gitterebenen durch eine nachträgliche Behandlung ab, so wird danach Licht mit einer kürzeren Wellenlänge als die des vor der Behandlung reflektierten Lichts reflektiert.

Bei der Laser-Belichtung zur Erzeugung des Reflexionshologramms fiel der vordere Strahl senkrecht mit 0 Grad und der hintere schräg unter 45 Grad zum Lot auf die Probe. Die Wellenlängen der eingesetzten Laser-Strahlen betrug jeweils 532 nm.

Nach der Laser-Belichtung wurde bei einer Probe eine Un-Belichtung wie oben unter 6. b) beschrieben durchgeführt, während bei einer anderen Probe keine UV-Belichtung durchgeführt wurde. Dann wurden beide Proben 2 Stunden lang bei 100˚C im Ofen gebacken. Anschließend wurden die Reflexionsintensitätsspektren der beiden Proben aufgenommen. Diese sind in Figur 13 dargestellt (Kurve A: mit UV-Belichtung vor dem Backen, Kurve B: ohne UV-Belichtung vor dem Backen).

Der Vergleich der in Figur 13 dargestellten Spektren zeigt, daß sich die Peakwellenlänge bei der vor dem Backen UV-belichteten Probe mit 516 nm nur geringfügig gegenüber der Wellenlänge der Aufzeichnungsstrahlung (532 nm) verändert hat, während sich die Peakwellenlänge bei der nicht UV-belichteten Probe mit 481 nm deutlich zu kürzeren Wellenlängen verschoben hat.

Vergleichsbeispiel 1

1. Herstellung eines polymeren Binders ohne photoaktivierbare Struktureinheiten

Bei diesem Vergleichsbeispiel wurde ein Binder (P(BzMA-co-MMA)) verwendet, der durch Copolymerisation von Benzylmethacrylat (BzMA) (Anteil ca. 18 Gew.-%) und Methylmethacrylat erhalten wurde. Die Herstellung erfolgte analog der oben beschriebenen Herstellung von P(COEMA-co-MMA).

Die Struktur des hier verwendeten Binders kann durch folgende Formel wiedergegeben werden:

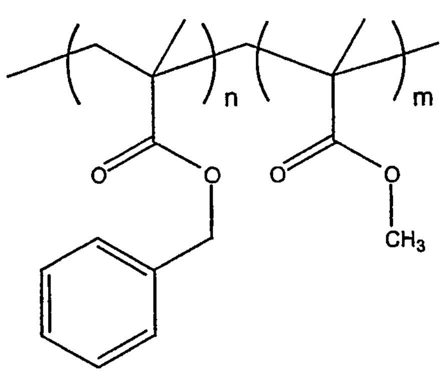

2. Herstellung einer Beschichtungslösung

Eine Beschichtungslösung wurde durch Auflösen folgender Komponenten in 2.0 g Methylethylketon erhalten: 2,5 g des wie unter 1. beschrieben erhaltenen Copolymeren P(BzMA-co-MMA) als polymerer Binder ohne photoaktivierbare Struktureinheiten, 1,24 g 2-Phenoxyethylacrylat (POEA) (entstabilisiert mit basischem Aluminiumoxid) als erstes Monomer, 0,528 g N-Vinylcarbazol als zweites Monomer, 0,053 g des wie oben beschrieben erhaltenen 2,2'-Bis(o-chlor-phenyl)-4,4',5,5'-tetraphenyl-1,1'-bisimidazol (o-Cl-HABI) als Photoinitiator, 0,079 g 2-Mercaptobenzoxazol als Transferreagenz, 0,0066 g des wie oben beschrieben erhaltenen 2,5-Bis[(4-diehtylaminophenyl)methylen]cyclopentanon (DEAW) als Farbstoff und 0,00044 g 4-Methoxyphenol als Stabilisator.

3. Herstellung eines holographischen Aufzeichnungsmaterials

Unter Verwendung der wie unter 2. beschrieben erhaltenen Beschichtungslösung wurde eine Probe eines holographischen Aufzeichnungsmaterials wie bei Beispiel 1 unter 5. beschreiben hergestellt.

4. Erzeugung eines Hologramms und dessen Untersuchung

In der wie unter 3. beschrieben hergestellten Probe wurde, wie bei Beispiel 1 beschreiben, ein Hologramm erzeugt und die Probe anschließend einer UV-Belichtung unterworfen. Der Beugungswirkungsgrad als Funktion der Belichtungszeit wurde während der Laser- und der UV-Belichtung gemessen; die gemessenen Verläufe sind in den Figuren 3 und 4 dargestellt. Die gemessenen Veränderungen des Beugungswirkungsgrads und der Brechungsindexamplitude während der UV-Belichtung sind in Tabelle 1 angegeben. Die thermische Stabilität des Hologramms wurde wie bei Beispiel 1 unter 8. beschrieben untersucht. Die Ergebnisse sind in der Figur 8 dargestellt und in den Tabellen 2 und 3 angegeben.

Vergleichsbeispiel 2

Bei diesem Vergleichsbeispiel wurde als Binder Celluloseacetatbutyrat (CAB) verwendet.

1. Herstellung einer Beschichtungslösung

Eine Beschichtungslösung wurde durch Auflösen folgender Komponenten in einem Gemisch aus 6.67 g Methylethylketon und 0.0312 g Methanol erhalten: 2,018 g Celluloseacetatbutyrat (CAB), 1,811 g 2-Phenoxyethylacrylat (POEA) (entstabilisiert mit basischem Aluminiumoxid) als Monomer, 0,047 g des wie oben beschrieben erhaltenen 2,2'-Bis(o-chlor-phenyl)-4,4',5,5'-tetraphenyl-1,1'-bisimidazol (o-Cl-HABI) als Photoinitiator, 0,071 g 2-Mercaptobenzoxazol als Transferreagenz, 0,0039 g des wie oben beschrieben erhaltenen 2,5-Bis[(4-diehtylaminophenyl)methylen]cyclopentanon (DEAW) als Farbstoff und 0,000395 g 4-Methoxyphenol als Stabilisator.

2. Herstellung eines holographischen Aufzeichnungsmaterials

Unter Verwendung der wie unter 1. beschrieben erhaltenen Beschichtungslösung wurde ein Probe eines holographischen Aufzeichnungsmaterials wie bei Beispiel 1 unter 5. beschreiben hergestellt.

3. Erzeugung eines Hologramms und dessen Untersuchung

In der wie unter 2. beschrieben hergestellten Probe wurde, wie bei Beispiel 1 beschreiben, ein Hologramm erzeugt und die Probe anschließend einer UV-Belichtung unterworfen. Der Beugungswirkungsgrad als Funktion der Belichtungszeit wurde während der Laser- und der UV-Belichtung gemessen; die gemessenen Verläufe sind in den Figuren 5 und 6 dargestellt. Die gemessenen Veränderungen des Beugungswirkungsgrads und der Brechungsindexamplitude während der UV-Belichtung sind in Tabelle 1 angegeben. Die thermische Stabilität des Hologramms wurde wie bei Beispiel 1 unter 8. beschrieben untersucht. Die Ergebnisse sind in der Figur 9 dargestellt und in den Tabellen 2 und 3 angegeben.

Vergleich der Ergebnisse

Beispiel 1 zeigt, daß die erfindungsgemäße Zusammensetzung mit vernetzungsfähigem Binder zur Herstellung eines holographischen Aufzeichnungsmaterials zur Erzeugung von Transmissions- und Reflexionshologrammen geeignet ist.

Die experimentell nachgewiesene Vernetzung durch die UV-Belichtung bringt verschiedene Vorteile: Im Gegensatz zu den Aufzeichnungsmaterialien der Vergleichsbeispiele, muß das Aufzeichnungsmaterial aus einer erfindungsgemäßen Zusammensetzung nicht gebacken werden, damit es nach dem Belichten längerfristig stabil seinen ursprünglichen Beugungswirkungsgrad und Rekonstruktionswinkel beibehält.

Der Vergleich der Meßergebnisse bei der UV-Belichtung nach der Erzeugung des Hologramms (Tabelle 1) zeigt, daß der Beugungswirkungsgrad und die Brechungsindexamplitude (Δn) bei dem Aufzeichnungsmaterial aus einer erfindungsgemäßen Zusammensetzung weiter ansteigen, während sie bei den Vergleichsbeispielen abnehmen.

Die Untersuchungen der thermischen Stabilität zeigen, daß das Aufzeichnungsmaterial aus einer erfindungsgemäßen Zusammensetzung im Gegensatz zu denen der Vergleichsbeispiele nach der Abkühlung seine ursprünglichen Eigenschaften im wesentlichen beibehält.

Die Untersuchungen der Reflexionshologramme zeigen, daß das Aufzeichnungsmaterial aus einer erfindungsgemäßen Zusammensetzung nach der UV-Belichtung mechanisch stabiler ist, d.h. z.B. nicht merklich schrumpft und die Reflexionshologramme demgemäß keine Verschiebung der Wellenlänge des reflektierten Lichts zeigen.

## Patentansprüche

**1.** Photopolymerisierbare Zusammensetzung umfassend:

a) 25-75 Gew.-% eines in Wasser und/oder organischen Lösungsmitteln löslichen polymeren Binders oder eines Bindergemisches aus verschiedenen in Wasser und/oder organischen Lösungsmitteln löslichen polymeren Bindern,
b) 5-60 Gew.-% eines ethylenisch ungesättigten monofunktionellen Monomers oder eines Monomergemisches aus verschiedenen ethylenisch ungesättigten monofunktionellen Monomeren und
c) 0,1-10 Gew.-% eines Photoinitiatorsystems, das die Polymerisation des oder der ungesättigten Monomeren bei der Einwirkung einer Strahlung aktiviert,

**dadurch gekennzeichnet, dass** der polymere Binder und/oder das ethylenisch ungesättigte monofunktionelle Monomere bzw. mindestens ein Binder im Bindergemisch und/oder mindestens eines der ethylenisch ungesättigten monofunktionellen Monomeren im Monomergemisch photoaktivierbare Struktureinheiten aufweist, die zu einer durch Strahlung induzierten Vernetzungsreaktion befähigt sind, wobei die photoaktivierbare Struktureinheit in der Polymerhauptkette und/oder in einer oder mehreren Seitenketten des polymeren Binders und/oder in einer oder mehreren Seitenketten des Monomers enthalten ist, wobei die Vernetzungsreaktion nach der Polymerisation zur holographischen Belichtung erfolgt und im Wesentlichen nicht durch Strahlung der Wellenlänge erfolgt, die für die Polymerisation des ungesättigten Monomers verwendet wird, und wobei der polymere Binder und/oder das ethylenisch ungesättigte monofunktionelle Monomere bzw. mindestens einer der polymeren Binder im Bindergemisch und/oder mindestens eines der ethylenisch ungesättigten monofunktionellen Monomeren im Monomergemisch photoaktivierbare Struktureinheiten P der nachstehenden allgemeinen Formeln I bis V aufweist

P=

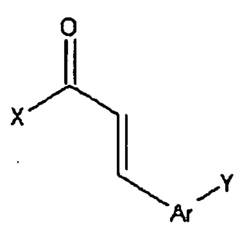

I

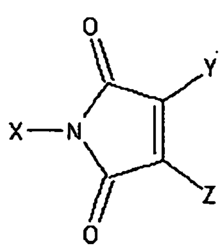

II

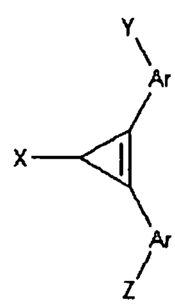

III

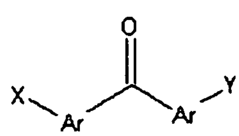

IV

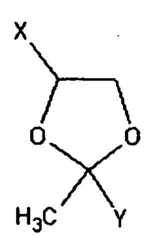

V

wobei Ar ein ein- oder mehrkerniger substituierter oder unsubstituierter aromatischer oder heterocyclischer aromatischer Rest, insbesondere

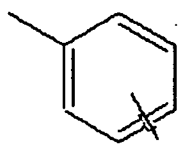

oder

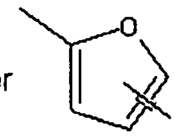

ist und wobei X, Y und Z gleich oder verschieden sind und unabhängig voneinander ausgewählt sind aus

A) Monomerresten, die ethylenisch ungesättigte Gruppen enthalten, die zur Polymerisation befähigt sind oder
B) Polymerresten, die von in Wasser und/oder organischen Lösungsmitteln löslichen polymeren Bindern abgeleitet sind und
C) Resten, unabhängig voneinander ausgewählt aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

**2.** Photopolymerisierbare Zusammensetzung nach Anspruch 1, wobei die monofunktionellen Monomerreste A) die nachfolgenden allgemeinen Strukturformeln aufweisen

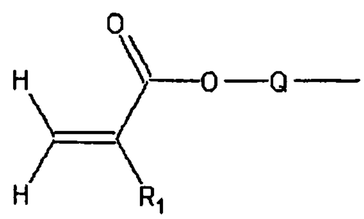

Acrylate

oder

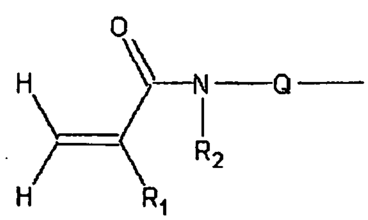

Acrylamide

oder

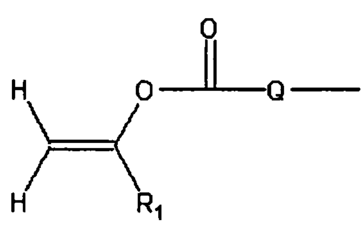

Vinylester

oder

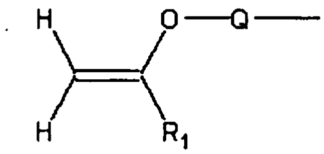

Vinylether

oder

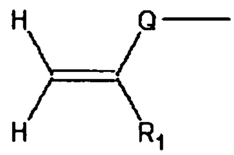

vinylische

oder

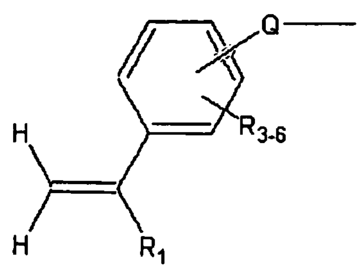

Styrole

wobei

$$Q = -(CH_2)_n-(O)_o- \quad \text{oder} \quad -(CH_2)_n-Ar-(CH_2)_m-(O)_o-$$

mit n, m = 0-12 und o = 0, 1, wobei Ar ein ein- oder mehrkerniger substituierter oder unsubstituierter aromatischer oder heterocyclischer aromatischer Rest ist,
wobei der Rest $R_1$ H, Methyl oder Ethyl ist und
wobei die Reste $R_2$, $R_3$, $R_4$, $R_5$ und $R_6$ unabhängig voneinander ausgewählt sind aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

**3.** Photopolymerisierbare Zusammensetzung nach Anspruch 1 oder 2, wobei die Polymerreste B) ausgewählt sind aus der Gruppe umfassend Celluloseacetatbutyrat-Polymere, Acrylpolymere und Copolymere, einschließlich Polymethylmethacrylat, Methylmethacrylat/Methacrylsäure- und Methylmethacrylat/Acrylsäure-Copolymere, Terpolymere von Methylmethacrylat/$C_2$-$C_4$-Alkylacrylat oder -methacrylat/Acryl- oder Methacrylsäure, Polyvinylacetat, Polyvinylacetal, Polyvinylbutyral, Polyvinylformal und Gemische davon.

**4.** Photopolymerisierbare Zusammensetzung nach einem der Ansprüche 1 bis 3, wobei der polymere Binder ausgewählt ist aus der Gruppe umfassend Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Polyvinylbutyral und Polyvinylformal, Butadien und Isoprenpolymere und Copolymere und Polyethylenoxide aus Polyglycolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane.

**5.** Photopolymerisierbare Zusammensetzung nach einem der Ansprüche 1 bis 4, wobei das oder die ethylenisch ungesättigten monofunktionellen Monomeren auswählt sind aus der Gruppe umfassend (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1H,1H,2H,2H-perfluoroctylester, 2,2,2-Trifluorethyl(meth)acrylat, Heptafluorpropyl(meth)acrylat, 1,1,1,3,3,3-Hexafluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, Acrylsäüre-N,N-diethylaminoethylester, Acrylsäureethoxyethyoxyethylester, Acrylsäure-2-(p-chlorphenoxy) ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy)ethylacrylat, Hydrochinonmonomethacrylat und 2-[β-(N-Carbazolyl) propionyloxy]ethylacrylat.

**6.** Element, enthaltend ein Hologramm, gebildet durch die Einwirkung einer eine holographische Information tragenden, modulierten Strahlung, umfassend ein Substrat, das eine photopolymerisierbare Zusammensetzung trägt, die ursprünglich aus

a) einem in Wasser und/oder organischen Lösungsmitteln löslichen polymeren Binder oder einem Bindergemisch aus verschiedenen in Wasser und/oder organischen Lösungsmitteln löslichen polymeren Bindern,
b) einem ethylenisch ungesättigten monofunktionellen Monomer oder einem Monomergemisch aus verschiedenen ethylenisch ungesättigten monofunktionellen Monomeren und
c) einem Photoinitiatorsystem, dass die Polymerisation des oder der ungesättigten Monomeren bei der Einwirkung einer Strahlung aktiviert, bestand,

**dadurch gekennzeichnet, dass** der polymere Binder und/oder das ethylenisch ungesättigte monofunktionelle Monomere bzw. mindestens ein Binder im Bindergemisch und/oder mindestens eines der ethylenisch ungesättigten monofunktionellen Monomeren im Monomergemisch photoaktivierbare Struktureinheiten aufweist, die zu einer durch Strahlung induzierten Vernetzungsreaktion befähigt sind, wobei die photoaktivierbare Struktureinheit in der Polymerhauptkette und/oder in einer oder mehreren Seitenketten des polymeren Binders und/oder in einer oder mehreren Seitenketten des Monomers enthalten ist, wobei die Vernetzungsreaktion nach der Polymerisation zur holographischen Belichtung erfolgt und im Wesentlichen nicht durch Strahlung der Wellenlänge erfolgt, die für die Polymerisation des ungesättigten Monomers verwendet wird, und wobei der polymere Binder und/oder das ethylenisch ungesättigte Monomere bzw. mindestens einer der polymeren Binder im Bindergemisch und/oder mindestens eines der ethylenisch ungesättigten Monomeren im Monomergemisch photoaktivierbare Struktureinheiten P der nachstehenden allgemeinen Formeln I bis V aufweist

P=

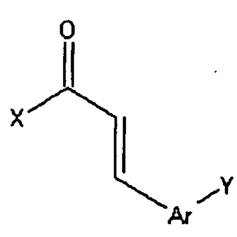

I

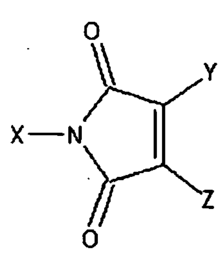

II

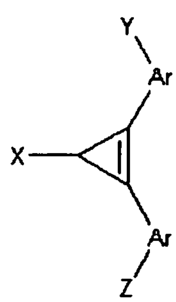

III

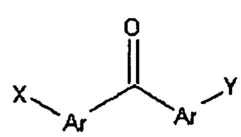

IV

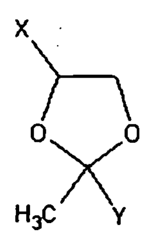

V

wobei Ar ein ein- oder mehrkerniger substituierter oder unsubstituierter aromatischer oder heterocyclischer aroma-

tischer Rest, insbesondere

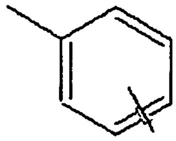

oder

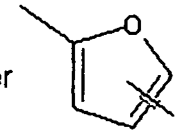

ist und wobei X, Y und Z gleich oder verschieden sind und unabhängig voneinander ausgewählt sind aus

A) Monomerresten, die ethylenisch ungesättigte Gruppen enthalten, die zur Polymerisation befähigt sind oder
B) Polymerresten, die von in Wasser und/oder organischen Lösungsmitteln löslichen polymeren Bindern abgeleitet sind und
C) Resten, unabhängig voneinander ausgewählt aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

7. Element nach Anspruch 6, wobei die Monomerreste die nachfolgenden allgemeinen Strukturformeln aufweisen

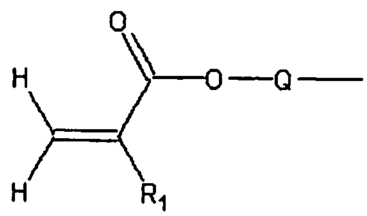

Acrylate

oder

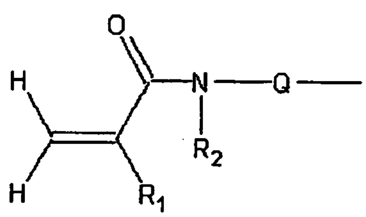

Acrylamide

oder

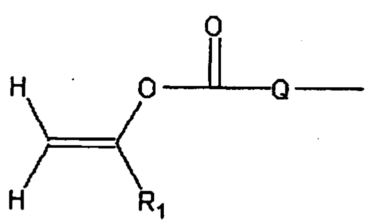

Vinylester

oder

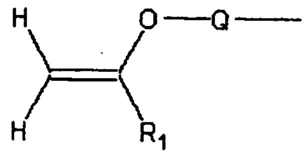

Vinylether

oder

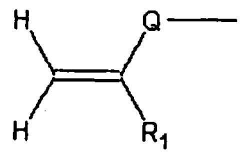

vinylische

oder

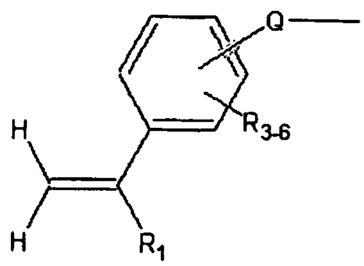

Styrole

wobei

$$Q = -(CH_2)_n-(O)_o- \quad \text{oder} \quad -(CH_2)_n-Ar-(CH_2)_m-(O)_o-$$

mit n, m = 0-12 und o = 0, 1, wobei Ar ein ein- oder mehrkerniger substituierter oder unsubstituierter aromatischer oder heterocyclischer aromatischer Rest ist,
wobei der Rest $R_1$ H, Methyl oder Ethyl ist und
wobei die Reste $R_2$, $R_3$, $R_4$, $R_5$ und $R_6$ unabhängig voneinander ausgewählt sind aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

**8.** Element nach Anspruch 6 oder 7, wobei die Polymerreste B) ausgewählt sind aus der Gruppe umfassend Celluloseacetatbutyrat-Polymere, Acrylpolymere und Copolymere, einschließlich Polymethylmethacrylat, Methylmethacrylat/Methacrylsäure- und Methylmethacrylat/Acrylsäure-Copolymere, Terpolymere von Methylmethacrylat/$C_2$-$C_4$-Alkylacrylat oder -methacrylat/Acryl- oder Methacrylsäure, Polyvinylacetat, Polyvinylacetal, Polyvinylbutyral, Polyvinylformal und Gemische davon.

**9.** Element nach einem der Ansprüche 6 bis 8, wobei der polymere Binder ausgewählt ist aus der Gruppe umfassend

Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Polyvinylbutyral und Polyvinylformal, Butadien und Isoprenpolymere und Copolymere und Polyethylenoxide aus Polyglycolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane.

**10.** Element nach einem der Ansprüche 6 bis 9, wobei das oder die ethylenisch ungesättigten monofunktionellen Monomeren auswählt sind aus der Gruppe umfassend (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1H,1H,2H,2H-perfluoroctylester, 2,2,2-Trifluorethyl(meth)acrylat, Heptafluorpropyl(meth)acrylat, 1,1,1,3,3,3-Hexafluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, Acrylsäure-N,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy)ethylacrylat, Hydrochinonmonomethacrylat und 2-[β-(N-Carbazolyl)propionyloxy]ethylacrylat.

**11.** Verfahren zur Bildung eines lichtbeständigen Hologramms in einer photopolymerisierbaren Schicht auf einer Substratoberfläche, umfassend die folgenden Schritte:

(A) die Einwirkung einer eine holographische Information tragenden modulierten Strahlung auf eine photopolymerisierbare Schicht, die

a) einen in Wasser und/oder organischen Lösungsmitteln löslichen polymeren Binder oder ein Bindergemisch aus verschiedenen in Wasser und/oder organischen Lösungsmitteln löslichen polymeren Bindern,
b) ein ethylenisch ungesättigtes monofunktionelles Monomer oder ein Monomergemisch aus verschiedenen ethylenisch ungesättigten monofunktionellen Monomeren und
c) ein Photoinitiatorsystem, dass die Polymerisation des oder der ungesättigten Monomeren bei der Einwirkung einer Strahlung aktiviert, umfasst,

(B) die Einwirkung von Strahlung auf die photopolymerisierbare Schicht insgesamt,

**dadurch gekennzeichnet, dass** die Wellenlänge der in Schritt (B) verwendeten Strahlung von der zur Einschreibung der holographischen Information verwendeten Strahlung in Schritt (A) verschieden ist und weiter **dadurch gekennzeichnet, dass** der
polymere Binder bzw. mindestens einer der polymeren Binder
im Bindergemisch und/oder das ethylenisch ungesättigte monofunktionelle Monomere bzw. mindestens eines der ethylenisch ungesättigten monofunktionellen Monomeren im Monomergemisch photoaktivierbare Struktureinheiten aufweist, die zu einer durch Strahlung induzierten Vernetzungsreaktion befähigt sind, wobei die photoaktivierbare Struktureinheit in der Polymerhauptkette und/oder in einer oder mehreren Seitenketten des polymeren Binders und/oder in einer oder mehreren Seitenketten des Monomers enthalten ist, wobei die Vernetzungsreaktion nach der Polymerisation zur holographischen Belichtung erfolgt und im Wesentlichen nicht durch Strahlung der Wellenlänge erfolgt, die für die Polymerisation des ungesättigten monofunktionellen Monomers verwendet wird, und wobei der polymere Binder und/oder das ethylenisch ungesättigte monofunktionelle Monomere bzw. mindestens einer der polymeren Binder im Bindergemisch und/oder mindestens eines der ethylenisch ungesättigten monofunktionellen Monomeren im Monomergemisch photoaktivierbare Struktureinheiten P der nachstehenden allgemeinen Formeln I bis V aufweist

P= 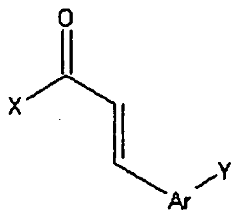 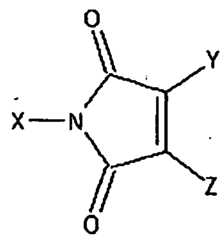 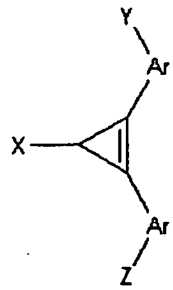 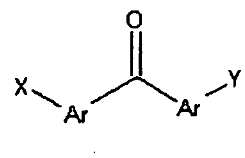 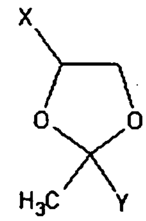

I II III IV V

wobei Ar ein ein- oder mehrkerniger substituierter oder unsubstituierter aromatischer oder heterocyclischer aromatischer Rest, insbesondere

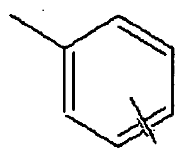 oder 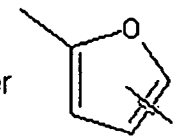

ist und wobei X, Y und Z gleich oder verschieden sind und unabhängig voneinander ausgewählt sind aus

A) Monomerresten, die ethylenisch ungesättigte Gruppen enthalten, die zur Polymerisation befähigt sind oder
B) Polymerresten, die von in Wasser und/oder organischen Lösungsmitteln löslichen polymeren Bindern abgeleitet sind und
C) Resten, unabhängig voneinander ausgewählt aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

**12.** Verfahren nach Anspruch 11, wobei im Schritt (A) Strahlung im sichtbaren Wellenlängenbereich (400-800 nm) und im Schritt (B) UV-Strahlung (150-400 nm) verwendet wird.

**13.** Verfahren nach einem der Ansprüche 11 oder 12, wobei die Monomerreste die nachfolgenden allgemeinen Strukturformeln aufweisen

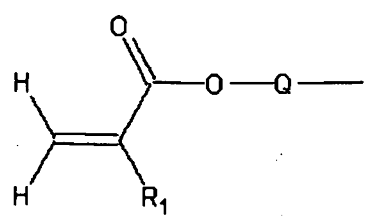 Acrylate

oder

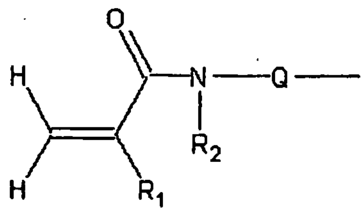

Acrylamide

oder

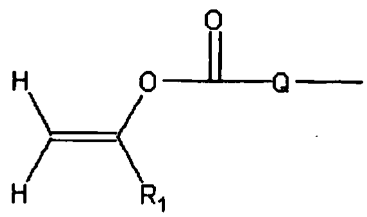

Vinylester

oder

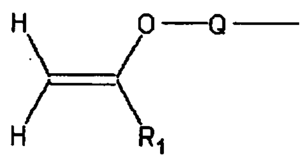

Vinylether

oder

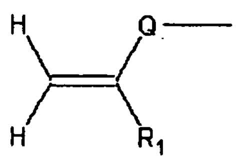

vinylische

oder

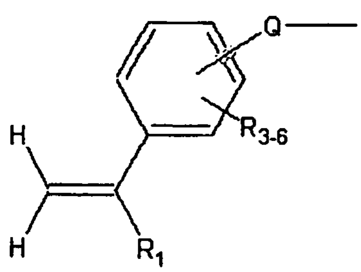

Styrole

wobei

$$Q= -(CH_2)_n(O)_o- \quad \text{oder} \quad -(CH_2)_n-Ar-(CH_2)_m(O)_o-$$

mit n, m = 0-12 und o= 0, 1, wobei Ar ein ein- oder mehrkerniger substituierter oder unsubstituierter aromaticher oder heterocyclischer aromatischer Rest ist,
wobei der Rest $R_1$ H, Methyl oder Ethyl ist und
wobei die Reste $R_2$, $R_3$, $R_4$, $R_5$ und $R_6$ unabhängig voneinander ausgewählt sind aus der Gruppe umfassend Alkyl-, Alkenyl-, Alkinyl-, Alkoxy-, Acyl- und Acyloxyreste, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatisch-aromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

**14.** Verfahren nach einem der Ansprüche 11 oder 13, wobei die Polymerreste B) ausgewählt sind aus der Gruppe umfassend Celluloseacetatbutyrat-Polymere, Acrylpolymere und Copolymere, einschließlich Polymethylmethacrylat, Methylmethacrylat/Methacrylsäure- und Methylmethacrylat/Acrylsäure-Copolymere, Terpolymere von Methylmethacrylat/$C_2$-$C_4$-Alkylacrylat oder -methacrylat/Acryl- oder Methacrylsäure, Polyvinylacetat, Polyvinylacetal, Polyvinylbutyral, Polyvinylformal und Gemische davon.

**15.** Verfahren nach einem der Ansprüche 11 bis 14, wobei der polymere Binder ausgewählt ist aus der Gruppe umfassend Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Polyvinylbutyral und Polyvinylformal, Butadien und Isoprenpolymere und Copolymere und Polyethylenoxide aus Polyglycolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane.

**16.** Verfahren nach einem der Ansprüche 11 bis 15, wobei das oder die ethylenisch ungesättigten monofunktionellen Monomeren auswählt sind aus der Gruppe umfassend (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1H,1H,2H,2H-perfluoroctylester, 2,2,2-Trifluorethyl(meth)acrylat, Heptafluorpropyl(meth)acrylat, 1,1,1,3,3,3-Hexafluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, Acrylsäure-N,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy)ethylacrylat, Hydrochinonmonomethacrylat und 2-[β-(N-Carbazolyl)propionyloxy]ethylacrylat.

## Claims

**1.** A photopolymerizable composition comprising:

a) 25 - 75% by weight of a polymeric binder soluble in water and/or organic solvents or of a binder mixture comprising various polymeric binders soluble in water and/or organic solvents,
b) 5 - 60% by weight of an ethylenically unsaturated monofunctional monomer or of a monomer mixture comprising various ethylenically unsaturated monofunctional monomers and
c) 0.1 - 10% by weight of a photoinitiator system which activates the polymerization of the unsaturated monomer or of the unsaturated monomers under the action of a radiation,

**characterized in that** the polymeric binder and/or the ethylenically unsaturated monofunctional monomer or at least one binder in the binder mixture and/or at least one of the ethylenically unsaturated monofunctional monomers in the monomer mixture has photoactivatable structural units which are capable of undergoing a crosslinking reaction induced by radiation, the photoactivatable structural unit being contained in the polymer main chain and/or in one or more side chains of the polymeric binder and/or in one or more side chains of the monomer, the crosslinking reaction taking place after the polymerization for the holographic exposure and substantially not being effected by radiation of the wavelength which is used for the polymerization of the unsaturated monomer, and the polymeric binder and/or the ethylenically unsaturated monofunctional monomer or at least one of the polymeric binders in the

binder mixture and/or at least one of the ethylenically unsaturated monofunctional monomers in the monomer mixture having photoactivatable structural units P of the following general formulae I to V

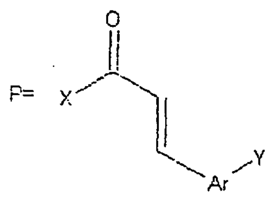 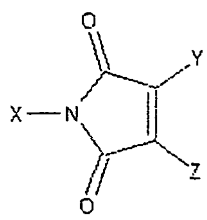 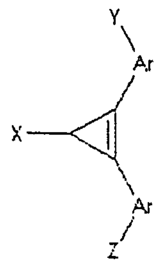 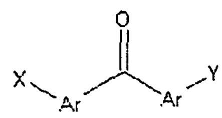 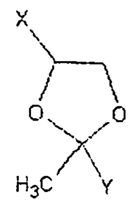

I II III IV V

in which Ar is a mononuclear or polynuclear substituted or unsubstituted aromatic or heterocyclic aromatic radical, in particular

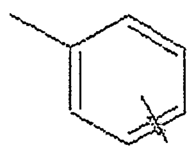

or

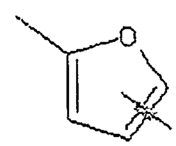

and in which X, Y and Z are identical or different and, independently of one another, are selected from

A) monomer radicals which contain ethylenically unsaturated groups which are capable of polymerization or
B) polymer radicals which are derived from polymeric binders soluble in water and/or organic solvents and
C) radicals selected, independently of one another, from the group consisting of alkyl, alkenyl, alkynyl, alkoxy, acyl and acyloxy radicals, which can be straight-chain or branched, unsubstituted or substituted, substituted or unsubstituted aryloxy radicals, substituted or unsubstituted aromatic radicals or heterocyclic radicals, unsubstituted or substituted alicyclic hydrocarbon radicals, aliphatic, aromatic and aliphatic-aromatic amino, carboxy, amido and imido radicals, hydroxyl, amino, cyano, nitro, halogen atoms or hydrogen atoms and combinations of the abovementioned radicals, it being possible for the substituted radicals to be substituted by $C_1$-$C_{12}$ alkyl, $C_1$-$C_{12}$ alkoxy, hydroxyl, carboxyl, carbonyl, amino, amido or imido radicals, halogen atoms, aromatic radicals or combinations thereof.

**2.** The photopolymerizable composition as claimed in claim 1, the monofunctional monomer radicals A) having the following general structural formulae

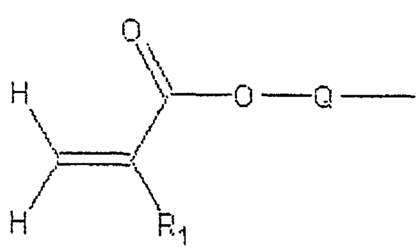

Acrylates

or

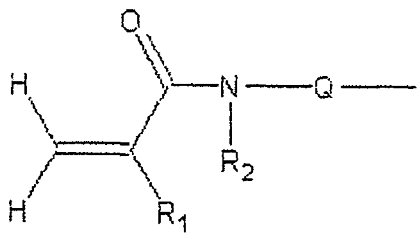

Acrylamides

or

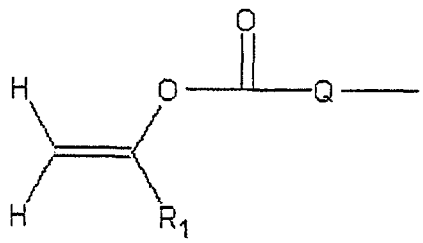

Vinyl esters

or

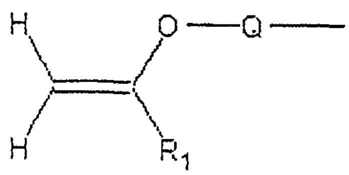

Vinyl ethers

or

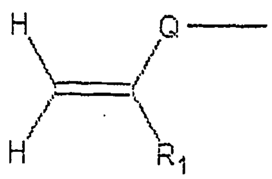

Vinylics

or

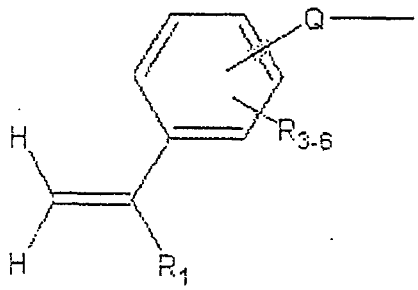

Styrenes

in which

$$Q= -(CH_2)_n-(O)_o- \quad \text{or} \quad -(CH_2)_n-Ar-(CH_2)_m-(O)_o-$$

where n, m = 0-12 and o = 0, 1, Ar being a mononuclear or polynuclear substituted or unsubstituted aromatic or heterocyclic aromatic radical,
in which the radical $R_1$ is H, methyl or ethyl and
in which the radicals $R_2$, $R_3$, $R_4$, $R_5$ and $R_6$, independently of one another, are selected from the group comprising alkyl, alkenyl, alkynyl, alkoxy, acyl and acyloxy radicals, which may be straight-chain or branched, unsubstituted or substituted, substituted or unsubstituted aryloxy radicals, substituted or unsubstituted aromatic radicals or heterocyclic radicals, unsubstituted or substituted alicyclic hydrocarbon radicals, aliphatic, aromatic and aliphatic-aromatic amino, carboxyl, amido and imido radicals, hydroxyl, amino, cyano, nitro, halogen atoms or hydrogen atoms and combinations of the abovementioned radicals, it being possible for the substituted radicals to be substituted by $C_1$-$C_{12}$ alkyl, $C_1$-$C_{12}$ alkoxy, hydroxyl, carboxyl, carbonyl, amino, amido or imido radicals, halogen atoms, aromatic radicals or combinations thereof.

**3.** The photopolymerizable composition as claimed in claim 1 or 2, the polymer radicals B) being selected from the group comprising cellulose acetate butyrate polymers, acrylic polymers and copolymers, including polymethyl methacrylate, methyl methacrylate/methacrylic acid and methyl methacrylate/acrylic acid copolymers, terpolymers of methyl methacrylate/$C_2$-$C_4$-alkyl acrylate or methacrylate/acrylic or methacrylic acid, polyvinyl acetate, polyvinylacetal, polyvinylbutyral, polyvinylformal and mixtures thereof.

**4.** The photopolymerizable composition as claimed in any of claims 1 to 3, the polymeric binder being selected from the group comprising polymethyl methacrylate and polyethyl methacrylate, polyvinyl esters, such as polyvinyl acetate, polyvinyl acetate/acrylate, polyvinyl acetate/methacrylate and partially hydrolyzed polyvinyl acetate, ethylene/vinyl acetate copolymers, polyvinylbutyral and polyvinylformal, butadiene and isoprene polymers and copolymers and polyethylene oxides obtained from polyglycols having an average molecular weight of about 1 000 to 1 000 000 g/mol, epoxides, such as epoxides containing acrylate or methacrylate radicals, polystyrenes, cellulose esters, such as cellulose acetate, cellulose acetate succinate and cellulose acetate butyrate, cellulose ethers, such as methylcellulose and ethylcellulose, polycondensates, such as polycarbonates, polyesters, polyamides, such as N-methoxymethylpolyhexamethyleneadipamide, polyimides and polyurethanes.

**5.** The photopolymerizable composition as claimed in any of claims 1 to 4, the ethylenically unsaturated monofunctional monomer or monomers being selected from the group comprising butyl (meth)acrylate, phenyl (meth)acrylate, benzyl (meth)acrylate, isobornyl (meth)acrylate, cyclohexyl (meth)acrylate, 2-phenoxyethyl (meth)acrylate, 1H,1H,2H,2H-perfluorooctyl (meth)acrylate, 2,2,2-trifluoroethyl (meth)acrylate, heptafluoropropyl (meth)acrylate, 1,1,1,3,3,3-hexafluoroisopropyl (meth)acrylate, 2,2,3,3-tetrafluoropropyl (meth)acrylate, 2,2,3,3,4,4,4-heptafluorobutyl (meth)acrylate, 2,2,3,3,4,4,5,5-octafluoropentyl (meth)acrylate, N,N-diethylaminoethyl acrylate, ethoxyethoxyethyl acrylate, 2-(p-chlorophenoxy)ethyl acrylate, p-chlorophenyl acrylate, 2-phenylethyl (meth)acrylate, pentachlorophenyl acrylate, phenyl acrylate, p-chlorostyrene, n-vinylcarbazole, 1-vinyl-2-pyrrolidone, 2-chlorostyrene, 2-bromostyrene, methoxystyrene, phenol ethoxylate acrylate, 2-(p-chlorophenoxy)ethyl acrylate, 2-(1-naphthyloxy)ethyl

acrylate, hydroquinone monomethacrylate and 2-[β-(N-carbazolyl)-propionyloxy]ethyl acrylate.

**6.** An element containing a hologram formed by the action of modulated radiation carrying holographic information, comprising a substrate which carries a photopolymerizable composition which originally consisted of

a) a polymeric binder soluble in water and/or organic solvents or a binder mixture comprising various polymeric binders soluble in water and/or organic solvents,
b) an ethylenically unsaturated monofunctional monomer or a monomer mixture comprising various ethylenically unsaturated monofunctional monomers and
c) a photoinitiator system that activates the polymerization of the unsaturated monomer or of the unsaturated monomers under the action of a radiation,

**characterized in that** the polymeric binder and/or the ethylenically unsaturated monofunctional monomer or at least one binder in the binder mixture and/or at least one of the ethylenically unsaturated monofunctional monomers in the monomer mixture has photoactivatable structural units which are capable of undergoing a crosslinking reaction induced by radiation, the photoactivatable structural unit being contained in the polymer main chain and/or in one or more side chains of the polymeric binder and/or in one or more side chains of the monomer, the crosslinking reaction taking place after the polymerization for the holographic exposure and substantially not being effected by radiation of the wavelength which is used for the polymerization of the unsaturated monomer, and the polymeric binder and/or the ethylenically unsaturated monomer or at least one of the polymeric binders in the binder mixture and/or at least one of the ethylenically unsaturated monomers in the monomer mixture having photoactivatable structural units P of the following general formulae I to V

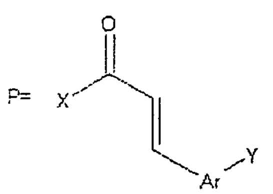
I
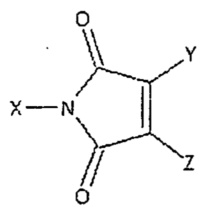
II
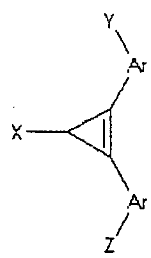
III
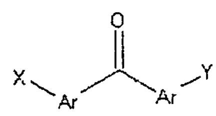
IV
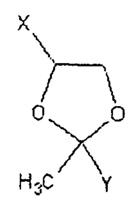
V

in which Ar is a mononuclear or polynuclear substituted or unsubstituted aromatic or heterocyclic aromatic radical, in particular

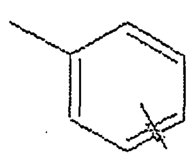
or
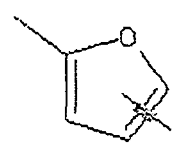

and in which X, Y and Z are identical or different and, independently of one another, are selected from

A) monomer radicals which contain ethylenically unsaturated groups which are capable of polymerization or
B) polymer radicals which are derived from polymeric binders soluble in water and/or organic solvents and
C) radicals selected, independently of one another, from the group comprising alkyl, alkenyl, alkynyl, alkoxy, acyl and acyloxy radicals, which may be straight-chain or branched, unsubstituted or substituted, substituted or unsubstituted aryloxy radicals, substituted or unsubstituted aromatic radicals or heterocyclic radicals, unsubstituted or substituted alicyclic hydrocarbon radicals, aliphatic, aromatic or aliphatic-aromatic amino, carboxyl, amido and imido radicals, hydroxyl, amino, cyano, nitro, halogen atoms or hydrogen atoms and combinations of the abovementioned radicals, it being possible for the substituted radicals to be substituted by $C_1$-$C_{12}$ alkyl, $C_1$-$C_{12}$ alkoxy, hydroxyl, carboxyl, carbonyl, amino, amido or imido radicals, halogen atoms, aromatic radicals or combinations thereof.

**7.** The element as claimed in claim 6, the monomer radicals having the following general structural formulae

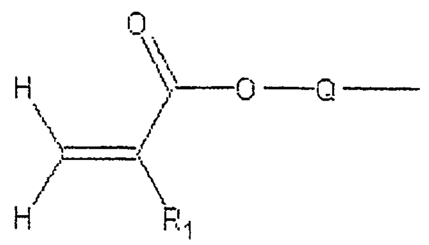

Acrylates

or

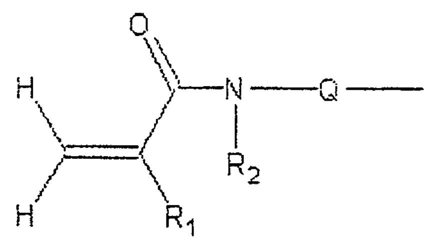

Acrylamides

or

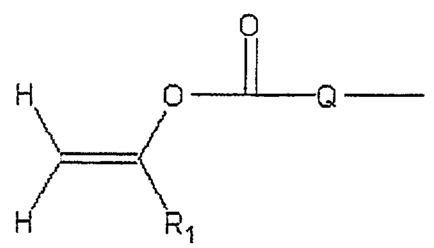

Vinyl esters

or

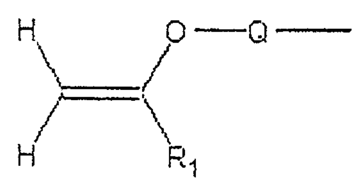

Vinyl ethers

or

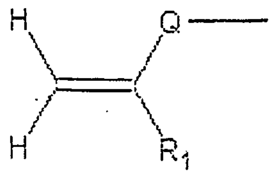

Vinylics

or

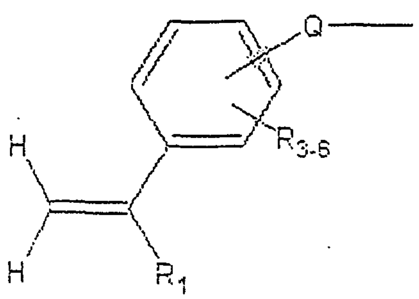

Styrenes

in which

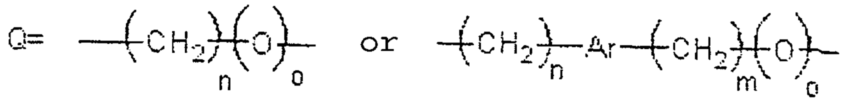

where n, m = 0-12 and o = 0, 1, Ar being a mononuclear or polynuclear substituted or unsubstituted aromatic or heterocyclic aromatic radical,
in which the radical $R_1$ is H, methyl or ethyl and
in which the radicals $R_2$, $R_3$, $R_4$, $R_5$ and $R_6$, independently of one another, are selected from the group comprising alkyl, alkenyl, alkynyl, alkoxy, acyl and acyloxy radicals, which may be straight-chain or branched, unsubstituted or substituted, substituted or unsubstituted aryloxy radicals, substituted or unsubstituted aromatic radicals or heterocyclic radicals, unsubstituted or substituted alicyclic hydrocarbon radicals, aliphatic, aromatic and aliphatic-aromatic amino, carboxyl, amido and imido radicals, hydroxyl, amino, cyano, nitro, halogen atoms or hydrogen atoms and combinations of the abovementioned radicals, it being possible for the substituted radicals to be substituted by $C_1$-$C_{12}$ alkyl, $C_1$-$C_{12}$ alkoxy, hydroxyl, carboxyl, carbonyl, amino, amido or imido radicals, halogen atoms, aromatic radicals or combinations thereof.

**8.** The element as claimed in claim 6 or 7, the polymer radicals B) being selected from the group comprising cellulose acetate butyrate polymers, acrylic polymers and copolymers, including polymethyl methacrylate, methyl methacrylate/methacrylic acid and methyl methacrylate/acrylic acid copolymers, terpolymers of methyl methacrylate/$C_2$-$C_4$-alkyl acrylate or methacrylate/acrylic or methacrylic acid, polyvinyl acetate, polyvinylacetal, polyvinylbutyral, polyvinylformal and mixtures thereof.

**9.** The element as claimed in any of claims 6 to 8, the polymeric binder being selected from the group comprising polymethyl methacrylate and polyethyl methacrylate, polyvinyl esters, such as polyvinyl acetate, polyvinyl acetate/acrylate, polyvinyl acetate/methacrylate and partially hydrolyzed polyvinyl acetate, ethylene/vinyl acetate copolymers, polyvinylbutyral and polyvinylformal, butadiene and isoprene polymers and copolymers and polyethylene oxides obtained from polyglycols having an average molecular weight of about 1 000 to 1 000 000 g/mol, epoxides, such as epoxides containing acrylate or methacrylate radicals, polystyrenes, cellulose esters, such as cellulose acetate, cellulose acetate succinate and cellulose acetate butyrate, cellulose ethers, such as methylcellulose and ethylcellulose, polycondensates, such as polycarbonates, polyesters, polyamides, such as N-methoxymethylpolyhexamethyleneadipamide, polyimides and polyurethanes.

**10.** The element as claimed in any of claims 6 to 9, the ethylenically unsaturated monofunctional monomer or monomers being selected from the group comprising butyl (meth)acrylate, phenyl (meth)acrylate, benzyl (meth)acrylate, isobornyl (meth)acrylate, cyclohexyl (meth)acrylate, 2-phenoxyethyl (meth)acrylate, 1H,1H,2H,2H-perfluorooctyl (meth)acrylate, 2,2,2-trifluoroethyl (meth)acrylate, heptafluoropropyl (meth)acrylate, 1,1,1,3,3,3-hexafluoroisopropyl (meth)acrylate, 2,2,3,3-tetrafluoropropyl (meth)acrylate, 2,2,3,3,4,4,4-heptafluorobutyl (meth)acrylate, 2,2,3,3,4,4,5,5-octafluoropentyl (meth)acrylate, N,N-diethylaminoethyl acrylate, ethoxyethoxyethyl acrylate, 2-(p-chlorophenoxy)ethyl acrylate, p-chlorophenyl acrylate, 2-phenylethyl (meth)acrylate, pentachlorophenyl acrylate, phenyl acrylate, p-chlorostyrene, n-vinylcarbazole, 1-vinyl-2-pyrrolidone, 2-chlorostyrene, 2-bromostyrene, methoxystyrene, phenol ethoxylate acrylate, 2-(p-chlorophenoxy)ethyl acrylate, 2-(1-naphthyloxy)ethyl acrylate, hydroquinone monomethacrylate and 2-[β-(N-carbazolyl)propionyloxy]ethyl acrylate.

**11.** A process for the formation of a lightfast hologram in a photopolymerizable layer on a substrate surface, comprising the following steps:

(A) the action of a modulated radiation carrying holographic information on a photopolymerizable layer which comprises

a) a polymeric binder soluble in water and/or organic solvents or a binder mixture comprising various polymeric binders soluble in water and/or organic solvents,
b) an ethylenically unsaturated monofunctional monomer or a monomer mixture comprising various ethylenically unsaturated monofunctional monomers and
c) a photoinitiator system that activates the polymerization of the unsaturated monomer or monomers under the action of a radiation,

(B) the action of radiation on the photopolymerizable layer as a whole,

**characterized in that** the wavelength of the radiation used in step (B) is different from the radiation used for recording the holographic information in step (A), and furthermore **characterized in that** the polymeric binder or at least one of the polymeric binders in the binder mixture and/or the ethylenically unsaturated monofunctional monomer or at least one of the ethylenically unsaturated monofunctional monomers in the monomer mixture has photoactivatable structural units which are capable of undergoing crosslinking reaction induced by radiation, the photoactivatable structural unit being contained in the polymer main chain and/or in one or more side chains of the polymeric binder and/or in one or more side chains of the monomer, the crosslinking reaction taking place after the polymerization of the holographic exposure and substantially not being effected by radiation of the wavelength which is used for the polymerization of the unsaturated monofunctional monomer, and the polymeric binder and/or the ethylenically unsaturated monofunctional monomer or at least one of the polymeric binders in the binder mixture and/or at least one of the ethylenically unsaturated monofunctional monomers in the monomer mixture having photoactivatable structural units P of the following general formulae I to V

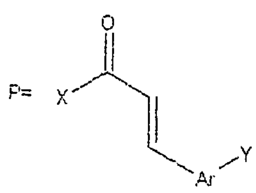
I

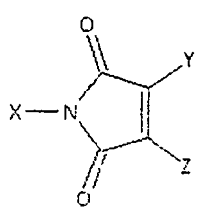
II

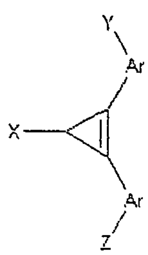
III

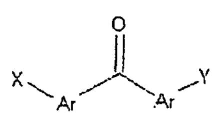
IV

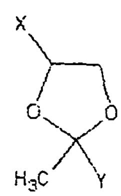
V

in which Ar is a mononuclear or polynuclear substituted or unsubstituted aromatic or heterocyclic aromatic radical, in particular

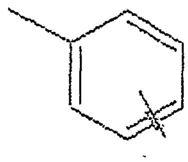

or

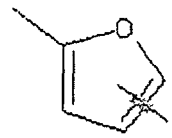

and in which X, Y and Z are identical or different and, independently of one another, are selected from

A) monomer radicals which contain ethylenically unsaturated groups which are capable of polymerization or
B) polymer radicals which are derived from polymeric binders soluble in water and/or organic solvents and
C) radicals selected, independently of one another, from the group comprising alkyl, alkenyl, alkynyl, alkoxy, acyl and acyloxy radicals, which may be straight-chain or branched, unsubstituted or substituted, substituted or unsubstituted aryloxy radicals, substituted or unsubstituted aromatic radicals or heterocyclic radicals, unsubstituted or substituted alicyclic hydrocarbon radicals, aliphatic, aromatic and aliphatic-aromatic amino, carboxyl, amido and imido radicals, hydroxyl, amino, cyano, nitro, halogen atoms or hydrogen atoms and combinations of the abovementioned radicals, it being possible for the substituted radicals to be substituted by $C_1$-$C_{12}$ alkyl, $C_1$-$C_{12}$ alkoxy, hydroxyl, carboxyl, carbonyl, amino, amido or imido radicals, halogen atoms, aromatic radicals or combinations thereof.

**12.** The process as claimed in claim 11, radiation in the visible wavelength range (400-800 nm) being used in step (A) and UV radiation (150-400 nm) being used in step (B).

**13.** The process as claimed in any of claims 11 or 12, the monomer radicals having the following general structural formulae

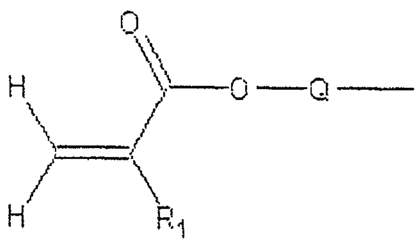

Acrylates

or

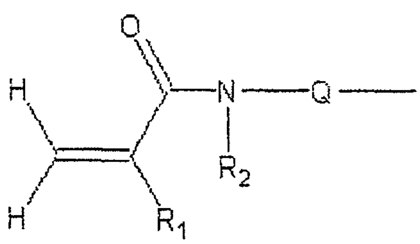

Acrylamides

or

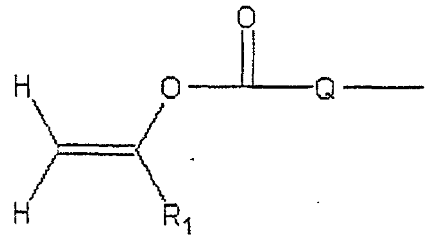

Vinyl esters

or

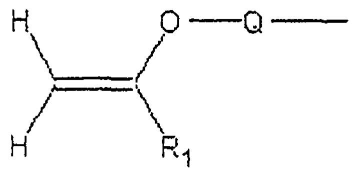

Vinyl ethers

or

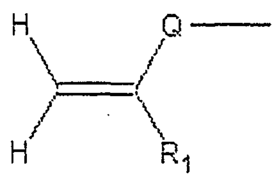

Vinylics

or

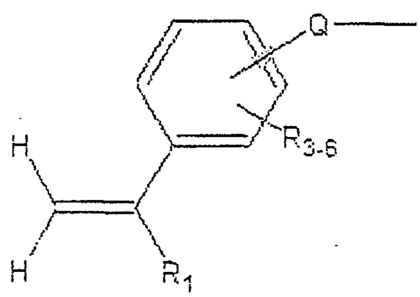

Styrenes

in which

Q= 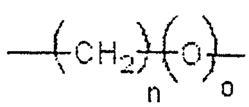 or 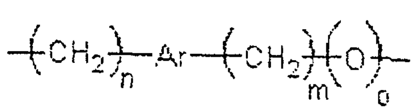

where n, m = 0-12 and o = 0, 1, Ar being a mononuclear or polynuclear substituted or unsubstituted aromatic or

heterocyclic aromatic radical,
in which the radical $R_1$ is H, methyl or ethyl and
in which the radicals $R_2$, $R_3$, $R_4$, $R_5$ and $R_6$, independently of one another, are selected from the group comprising alkyl, alkenyl, alkynyl, alkoxy, acyl and acyloxy radicals, which may be straight-chain or branched, unsubstituted or substituted, substituted or unsubstituted aryloxy radicals, substituted or unsubstituted aromatic radicals or heterocyclic radicals, unsubstituted or substituted alicyclic hydrocarbon radicals, aliphatic, aromatic and aliphatic-aromatic amino, carboxyl, amido and imido radicals, hydroxyl, amino, cyano, nitro, halogen atoms or hydrogen atoms and combinations of the abovementioned radicals, it being possible for the substituted radicals to be substituted by $C_1$-$C_{12}$ alkyl, $C_1$-$C_{12}$ alkoxy, hydroxyl, carboxyl, carbonyl, amino, amido or imido radicals, halogen atoms, aromatic radicals or combinations thereof.

**14.** The process as claimed in either of claims 11 and 13, the polymer radicals B) being selected from the group comprising cellulose acetate butyrate polymers, acrylic polymers and copolymers, including polymethyl methacrylate, methyl methacrylate/methacrylic acid and methyl methacrylate/acrylic acid copolymers, terpolymers of methyl methacrylate/$C_2$-$C_4$-alkyl acrylate or methacrylate/acrylic or methacrylic acid, polyvinyl acetate, polyvinylacetal, polyvinylbutyral, polyvinylformal and mixtures thereof.

**15.** The process as claimed in any of claims 11 to 14, the polymeric binder being selected from the group comprising polymethyl methacrylate and polyethyl methacrylate, polyvinyl esters, such as polyvinyl acetate, polyvinyl acetate/acrylate, polyvinyl acetate/methacrylate and partially hydrolyzed polyvinyl acetate, ethylene/vinyl acetate copolymers, polyvinylbutyral and polyvinylformal, butadiene and isoprene polymers and copolymers and polyethylene oxides obtained from polyglycols having an average molecular weight of about 1 000 to 1 000 000 g/mol, epoxides, such as epoxides containing acrylate or methacrylate radicals, polystyrenes, cellulose esters, such as cellulose acetate, cellulose acetate succinate and cellulose acetate butyrate, cellulose ethers, such as methylcellulose and ethylcellulose, polycondensates, such as polycarbonates, polyesters, polyamides, such as N-methoxymethylpolyhexamethyleneadipamide, polyimides and polyurethanes.

**16.** The process as claimed in any of claims 11 to 15, the ethylenically unsaturated monofunctional monomer or monomers being selected from the group comprising butyl (meth)acrylate, phenyl (meth)acrylate, benzyl (meth)acrylate, isobornyl (meth)acrylate, cyclohexyl (meth)acrylate, 2-phenoxyethyl (meth)acrylate, 1H,1H,2H,2H-perfluorooctyl (meth)acrylate, 2,2,2-trifluoroethyl (meth)acrylate, heptafluoropropyl (meth)acrylate, 1,1,1,3,3,3-hexafluoroisopropyl (meth)acrylate, 2,2,3,3-tetrafluoropropyl (meth)acrylate, 2,2,3,3,4,4,4-heptafluorobutyl (meth)acrylate, 2,2,3,3,4,4,5,5-octafluoropentyl (meth)acrylate, N,N-diethylaminoethyl acrylate, ethoxyethoxyethyl acrylate, 2-(p-chlorophenoxy)ethyl acrylate, p-chlorophenyl acrylate, 2-phenylethyl (meth)acrylate, pentachlorophenyl acrylate, phenyl acrylate, p-chlorostyrene, n-vinylcarbazole, 1-vinyl-2-pyrrolidone, 2-chlorostyrene, 2-bromostyrene, methoxystyrene, phenol ethoxylate acrylate, 2-(p-chlorophenoxy)ethyl acrylate, 2-(1-naphthyloxy)ethyl acrylate, hydroquinone monomethacrylate and 2-[β-(N-carbazolyl)-propionyloxy]ethyl acrylate.

## Revendications

**1.** Composition photopolymérisable comprenant :

a) 25 à 75 % en poids d'un liant polymère soluble dans l'eau et/ou dans des solvants organiques ou d'un mélange de liants constitué de différents liants polymères solubles dans l'eau et/ou dans des solvants organiques,
b) 5 à 60 % en poids d'un monomère monofonctionnel insaturé éthyléniquement ou d'un mélange de monomère constitué de différents monomères monofonctionnels insaturés éthyléniquement et
c) 0,1 à 10 % en poids d'un système photoinitiateur, qui active la polymérisation du ou des monomères insaturés lors de l'incidence d'un rayon,

**caractérisée en ce que** le liant polymère et/ou le monomère monofonctionnel insaturé éthyléniquement ou au moins un liant dans le mélange de liants et/ou au moins un des monomères monofonctionnels insaturés éthyléniquement dans le mélange de monomères présente des motifs structurels photoactivables, qui sont susceptibles d'une réaction de réticulation induite par rayonnement, où le motif structurel photoactivable est présent dans la chaîne principale du polymère et/ou dans une ou plusieurs des chaînes latérales du liant polymère et/ou dans une ou plusieurs des chaînes latérales du monomère, où la réaction de réticulation s'effectue après la polymérisation pour l'impression holographique et ne se fait pas pour l'essentiel par irradiation de la même longueur d'ondes que

celle utilisée pour la polymérisation du monomère insaturé, et où le liant polymère et/ou le monomère monofonctionnel insaturé éthyléniquement ou au moins un des liants polymères dans le mélange de liants et/ou au moins un des monomères monofonctionnels insaturés éthyléniquement dans le mélange de monomères présente des motifs structuraux photoactivables P des formules générales I à IV ci-après :

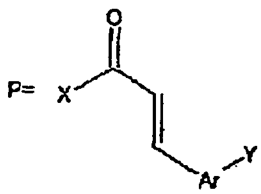

I

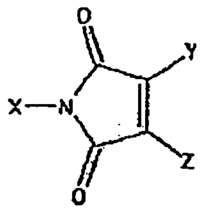

II

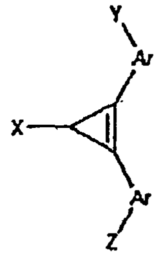

III

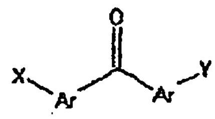

IV

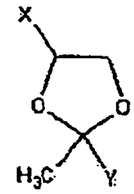

V

où Ar est un radical aromatique ou aromatique hétérocyclique substitué ou non substitué à un ou plusieurs noyaux, en particulier

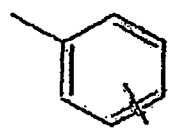

ou

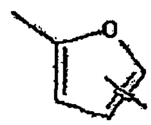

et où X, Y et Z sont identiques ou différents et choisis indépendamment les uns des autres parmi :

A) les radicaux monomères, qui comprennent des groupements insaturés éthylèniquement susceptibles de polymérisation et
B) les radicaux polymères qui sont dérivés de liants polymères solubles dans l'eau et/ou dans les solvants organiques et
C) les radicaux qui sont choisis, indépendamment les uns des autres, dans le groupe comprenant les radicaux alkyle, alcényle, alcinyle, alcoxy, acyle et acyloxy, qui peuvent être linéaires ou ramifiés, substitués ou non substitués, les radicaux aryloxy substitués ou non substitués, les radicaux aromatiques ou les radicaux hétérocycliques substitués ou non substitués, les radicaux hydrocarbonés alicycliques substitués ou non substitués, les radicaux amino, acide carboxylique, amido et imido aliphatiques, aromatiques et aliphatiques - aromatiques, les atomes d'hydroxy, d'amino, de cyano, de nitro et d'halogène ou les atomes d'hydrogène, et des combinaisons des radicaux cités précédemment, où les radicaux substitués peuvent être substitués par des radicaux alkyle en $C_1$-$C_{12}$, alcoxy en $C_1$-$C_{12}$, hydroxy, carboxy, carbonyle, amino, amido, imido, des atomes d'halogène, des radicaux aromatiques ou des combinaisons de ceux-ci.

**2.** Composition photopolymérisable selon la revendication 1, dans laquelle les radicaux monomères monofonctionnels A) présentent les formules structurelles générales suivantes :

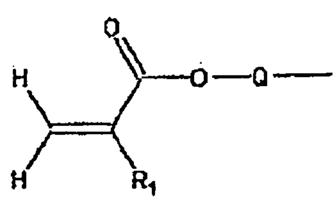

acrylate

or

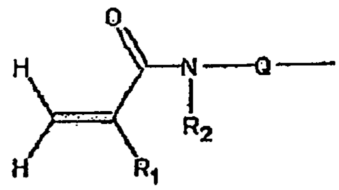

acrylamide

or

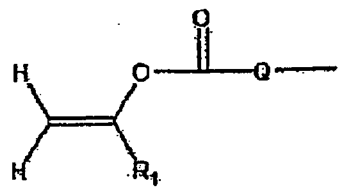

ester vinylique

or

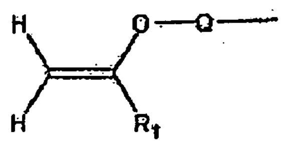

éther vinylique

or

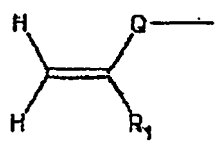

vinylique

or

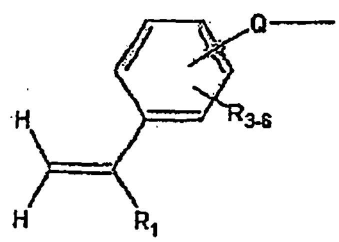

styrène

dans lesquelles

$$Q = -(CH_2)_n-(O)_o- \quad \text{ou} \quad -(CH_2)_n-Ar-(CH_2)_m-(O)_o-$$

avec n, m = 0 - 12 et o = 0, 1, où Ar est un radical aromatique ou aromatique hétérocyclique substitué ou non substitué à un ou plusieurs noyaux,
dans lesquelles $R_1$ est H, méthyle ou éthyle et
dans lesquelles les radicaux $R_2$, $R_3$, $R_4$, $R_5$ et $R_6$ sont choisis, indépendamment les uns des autres, dans le groupe

comprenant les radicaux alkyle, alcényle, alcinyle, alcoxy, acyle et acyloxy, qui peuvent être linéaires ou ramifiés, substitués ou non substitués, les radicaux aryloxy substitués ou non substitués, les radicaux aromatiques ou les radicaux hétérocycliques substitués ou non substitués, les radicaux hydrocarbonés alicycliques substitués ou non substitués, les radicaux amino, acide carboxylique, amido et imido aliphatiques, aromatiques et aliphatiques - aromatiques, les atomes d'hydroxy, d'amino, de cyano, de nitro et d'halogène ou les atomes d'hydrogène, et des combinaisons des radicaux cités précédemment, où les radicaux substitués peuvent être substitués par des radicaux alkyle en $C_1$-$C_{12}$, alcoxy en $C_1$-$C_{12,}$ hydroxy, carboxy, carbonyle, amino, amido, imido, des atomes d'halogène, des radicaux aromatiques ou des combinaisons de ceux-ci.

**3.** Composition photopolymérisable selon la revendication 1 ou 2, dans laquelle les radicaux polymères B) sont choisis dans le groupe comprenant les polymères d'acétobutyrate de cellulose, les polymères et copolymères acryliques, y compris le polyméthacrylate de méthyle, les copolymères de méthacrylate de méthyle/ acide méthacrylique et méthacrylate de méthyle/ acide acrylique, les terpolymères de méthacrylate de méthyle/ acrylate ou méthacrylate d'alkyle en $C_2$-$C_4$/ acide acrylique ou méthacrylique, le polyvinylacétate, le polyvinylacétal, le polyvinylbutyral, le polyvinylformal et des mélanges de ceux-ci.

**4.** Composition photopolymérisable selon l'une des revendications 1 à 3, dans laquelle le liant polymère est choisi dans le groupe comprenant le polyméthacrylate de méthyle et le polyméthacrylate d'éthyle, le polyvinylester comme le polyvinylacétate, le polyvinylacétate/ -acrylate, le polyvinylacétate/ - méthacrylate et le polyvinylacétate partiellement hydrolysé, les copolymères d'éthylène/ vinylacétate, le polyvinylbutyral et le polyvinylformal, le butadiène et les polymères et copolymères d'isoprène et les oxydes de polyéthylène constitués de polyglycols ayant un poids moléculaire moyen d'environ 1 000 à 1 000 000 g/mol, les époxydes, comme les époxydes comprenant des radicaux acrylate ou méthacrylate, les polystyrènes, les esters de cellulose, comme l'acétate de cellulose, l'acétosuccinate de cellulose et l'acétobutyrate de cellulose, les éthers de cellulose, comme la méthylcellulose et l'éthylcellulose, les polycondensats, comme les polycarbonates, les polyesters, les polyamides, comme le N-méthoxyméthylpolyhexaméthylène adipamide, les polyimides, les polyuréthanes.

**5.** Composition photopolymérisable selon l'une des revendications 1 à 4, dans laquelle le ou les monomères monofonctionnels insaturés éthyléniquement sont choisis dans le groupe comprenant le butylester d'acide méthacrylique, le phénylester d'acide méthacrylique, le benzylester d'acide méthacrylique, l'isobornylester d'acide méthacrylique, le cyclohexylester d'acide méthacrylique, le 2-phénoxyéthylester d'acide méthacrylique, le 1H,1H,2H,2H-perfluorooctylester d'acide méthacrylique, le méthacrylate de 2,2,2-trifluoroéthyle, le méthacrylate d'heptafluoropropyle, le méthacrylate de 1,1,1,3,3,3-hexafluoroisopropyle, le méthacrylate de 2,2,3,3-tétrafluoropropyle, le méthacrylate de 2,2,3,3,4,4,4-heptafluorobutyle, le méthacrylate de 2,2,3,3,4,4,5,5-octafluoropentyle, le N,N-diéthylaminoéthylester d'acide acrylique, l'éthoxyéthyoxyéthylester d'acide acrylique, le 2-(p-chlorophénoxy)éthylester d'acide acrylique, l'acrylate de p-chlorophényle, le méthacrylate de 2-phényléthyle, l'acrylate de pentachlorophényle, l'acrylate de phényle, le p-chlorostyrène, le n-vinylcarbazole, la 1-vinyl-2-pyrrolidone, le 2-chlorostyrène, le 2-bromostyrène, le méthoxystyrène, l'acrylate de phénoléthoxylate, l'acrylate de 2-(p-chlorophénoxy)-éthyle, l'acrylate de 2-(1-naphtyloxy) éthyle, le monométhacrylate d'hydroquinone et l'acrylate de 2-[β-(N-carbazolyl)propionyloxy]éthyle.

**6.** Elément comprenant un hologramme, formé sous l'action d'un rayon modulé, portant une information holographique, comprenant un substrat, qui porte une composition photopolymérisable, qui se compose initialement

a) d'un liant polymère soluble dans l'eau et/ou dans des solvants organiques ou d'un mélange de liants constitué de différents liants polymères solubles dans l'eau et/ou dans des solvants organiques,
b) d'un monomère monofonctionnel insaturé éthyléniquement ou d'un mélange de monomère constitué de différents monomères monofonctionnels insaturés éthyléniquement et
c) d'un système photoinitiateur, qui active la polymérisation du ou des monomères insaturés lors de l'incidence d'un rayon,

**caractérisé en ce que** le liant polymère et/ou le monomère monofonctionnel insaturé éthyléniquement ou au moins un liant dans le mélange de liants et/ou au moins un des monomères monofonctionnels insaturés éthyléniquement dans le mélange de monomères présente des motifs structurels photoactivables, qui sont susceptibles d'une réaction de réticulation induite par rayonnement, où le motif structurel photoactivable est présent dans la chaîne principale du polymère et/ou dans une ou plusieurs des chaînes latérales du liant polymère et/ou dans une ou plusieurs des chaînes latérales du monomère, où la réaction de réticulation s'effectue après la polymérisation pour l'impression holographique et ne se fait pas pour l'essentiel par irradiation de la même longueur d'ondes que celle utilisée pour la polymérisation du monomère insaturé, et où le liant polymère et/ou le monomère monofonctionnel insaturé

éthyléniquement ou au moins un des liants polymères dans le mélange de liants et/ou au moins un des monomères monofonctionnels insaturés éthyléniquement dans le mélange de monomères présente des motifs structuraux photoactivables P des formules générales I à IV ci-après :

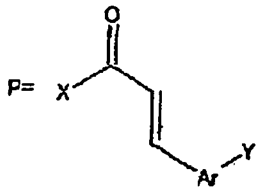
I

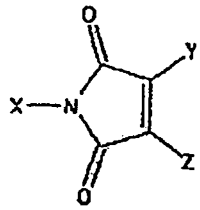
II

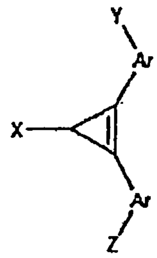
III

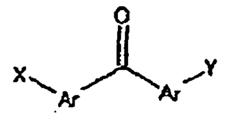
IV

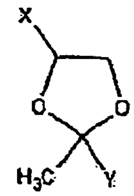
V

où Ar est un radical aromatique ou aromatique hétérocyclique substitué ou non substitué à un ou plusieurs noyaux, en particulier

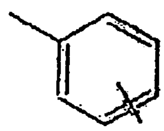
ou
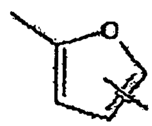

et où X, Y et Z sont identiques ou différents et choisis indépendamment les uns des autres parmi :

A) les radicaux monomères, qui comprenant des groupements insaturés éthylèniquement susceptibles de polymérisation et
B) les radicaux polymères qui sont dérivés de liants polymères solubles dans l'eau et/ou dans les solvants organiques et
C) les radicaux qui sont choisis, indépendamment les uns des autres, dans le groupe comprenant les radicaux alkyle, alcényle, alcinyle, alcoxy, acyle et acyloxy, qui peuvent être linéaires ou ramifiés, substitués ou non substitués, les radicaux aryloxy substitués ou non substitués, les radicaux aromatiques ou les radicaux hétérocycliques substitués ou non substitués, les radicaux hydrocarbonés alicycliques substitués ou non substitués, les radicaux amino, acide carboxylique, amido et imido aliphatiques, aromatiques et aliphatiques - aromatiques, les atomes d'hydroxy, d'amino, de cyano, de nitro et d'halogène ou les atomes d'hydrogène, et des combinaisons des radicaux cités précédemment, où les radicaux substitués peuvent être substitués par des radicaux alkyle en $C_1$-$C_{12}$, alcoxy en $C_1$-$C_{12}$, hydroxy, carboxy, carbonyle, amino, amido, imido, des atomes d'halogène, des radicaux aromatiques ou des combinaisons de ceux-ci.

**7.** Elément selon la revendication 6, dans lequel les radicaux monomères présentent les formules structurelles générales suivantes :

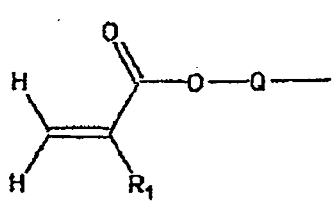
acrylate

or

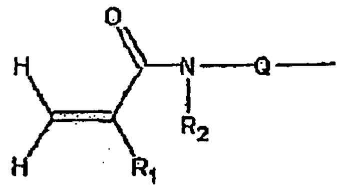

acrylamide

or

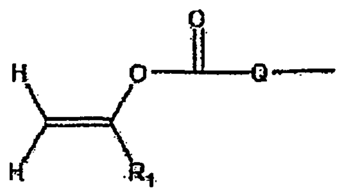

ester vinylique

or

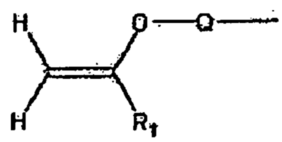

éther vinylique

or

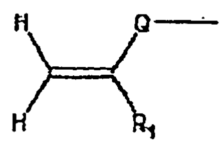

vinylique

or

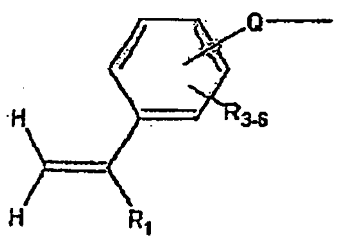

styrène

dans lesquelles

$$Q = -(CH_2)_n-(O)_o- \quad \text{ou} \quad -(CH_2)_n-Ar-(CH_2)_m-(O)_o-$$

avec n, m = 0 - 12 et o = 0, 1, où Ar est un radical aromatique ou aromatique hétérocyclique substitué ou non substitué à un ou plusieurs noyaux,
dans lesquelles $R_1$ est H, méthyle ou éthyle et
dans lesquelles les radicaux $R_2$, $R_3$, $R_4$, $R_5$ et $R_6$ sont choisis, indépendamment les uns des autres, dans le groupe

comprenant les radicaux alkyle, alcényle, alcinyle, alcoxy, acyle et acyloxy, qui peuvent être linéaires ou ramifiés, substitués ou non substitués, les radicaux aryloxy substitués ou non substitués, les radicaux aromatiques ou les radicaux hétérocycliques substitués ou non substitués, les radicaux hydrocarbonés alicycliques substitués ou non substitués, les radicaux amino, acide carboxylique, amido et imido aliphatiques, aromatiques et aliphatiques - aromatiques, les atomes d'hydroxy, d'amino, de cyano, de nitro et d'halogène ou les atomes d'hydrogène, et des combinaisons des radicaux cités précédemment, où les radicaux substitués peuvent être substitués par des radicaux alkyle en $C_1$-$C_{12}$, alcoxy en $C_1$-$C_{12}$, hydroxy, carboxy, carbonyle, amino, amido, imido, des atomes d'halogène, des radicaux aromatiques ou des combinaisons de ceux-ci.

**8.** Elément selon la revendication 6 ou 7, dans lequel les radicaux polymères B) sont choisis dans le groupe comprenant les polymères d'acétobutyrate de cellulose, les polymères et copolymères acryliques, y compris le polyméthacrylate de méthyle, les copolymères de méthacrylate de méthyle/ acide méthacrylique et méthacrylate de méthyle/ acide acrylique, les terpolymères de méthacrylate de méthyle/ acrylate ou méthacrylate d'alkyle en $C_2$-$C_4$/ acide acrylique ou méthacrylique, le polyvinylacétate, le polyvinylacétal, le polyvinylbutyral, le polyvinylformal et des mélanges de ceux-ci.

**9.** Elément selon l'une des revendications 6 à 8, dans lequel le liant polymère est choisi dans le groupe comprenant le polyméthacrylate de méthyle et le polyméthacrylate d'éthyle, le polyvinylester comme le polyvinylacétate, le polyvinylacétate/ -acrylate, le polyvinylacétate/ -méthacrylate et le polyvinylacétate partiellement hydrolysé, les copolymères d'éthylène/ vinylacétate, le polyvinylbutyral et le polyvinylformal, le butadiène et les polymères et copolymères d'isoprène et les oxydes de polyéthylène constitués de polyglycols ayant un poids moléculaire moyen d'environ 1,000 à 1,000,000 g/mol, les époxydes, comme les époxydes comprenant des radicaux acrylate ou méthacrylate, les polystyrènes, les esters de cellulose, comme l'acétate de cellulose, l'acétosuccinate de cellulose et l'acétobutyrate de cellulose, les éthers de cellulose, comme la méthylcellulose et l'éthylcellulose, les polycondensats, comme les polycarbonates, les polyesters, les polyamides, comme le N-méthoxyméthylpolyhexaméthylène adipamide, les polyimides, les polyuréthanes.

**10.** Elément selon l'une des revendications 6 à 9, dans lequel le ou les monomères monofonctionnels insaturés éthyléniquement sont choisis dans le groupe comprenant le butylester d'acide méthacrylique, le phénylester d'acide méthacrylique, le benzylester d'acide méthacrylique, l'isobornylester d'acide méthacrylique, le cyclohexylester d'acide méthacrylique, le 2-phénoxyéthylester d'acide méthacrylique, le 1H,1H,2H,2H-perfluorooctylester d'acide méthacrylique, le méthacrylate de 2,2,2-trifluoroéthyle, le méthacrylate d'heptafluoropropyle, le méthacrylate de 1,1,1,3,3,3-hexafluoroisopropyle, le méthacrylate de 2,2,3,3-tétrafluoropropyle, le méthacrylate de 2,2,3,3,4,4,4-heptafluorobutyle, le méthacrylate de 2,2,3,3,4,4,5,5-octafluoropentyle, le N,N-diéthylaminoéthylester d'acide acrylique, l'éthoxyéthyoxyéthylester d'acide acrylique, le 2-(p-chlorophénoxy)éthylester d'acide acrylique, l'acrylate de p-chlorophényle, le méthacrylate de 2-phényléthyle, l'acrylate de pentachlorophényle, l'acrylate de phényle, le p-chlorostyrène, le n-vinylcarbazole, la 1-vinyl-2-pyrrolidone, le 2-chlorostyrène, le 2-bromostyrène, le méthoxystyrène, l'acrylate de phénoléthoxylate, l'acrylate de 2-(p-chlorophénoxy)-éthyle, l'acrylate de 2-(1-naphtyloxy)éthyle, le monométhacrylate d'hydroquinone et l'acrylate de 2-[β-(N-carbazolyl)propionyloxy]éthyle.

**11.** Procédé de formation d'un hologramme résistance à la lumière dans une couche photopolymérisable sur la surface d'un substrat, comprenant les étapes suivantes :

(A) l'action d'un rayon modulé, porteur de l'information holographique, sur une couche photopolymérisable, qui comprend

a) un liant polymère soluble dans l'eau et/ou dans des solvants organiques ou d'un mélange de liants constitué de différents liants polymères solubles dans l'eau et/ou dans des solvants organiques,
b) un monomère monofonctionnel insaturé éthyléniquement ou d'un mélange de monomère constitué de différents monomères monofonctionnels insaturés éthyléniquement et
c) un système photoinitiateur, qui active la polymérisation du ou des monomères insaturés lors de l'incidence d'un rayon,

(B) l'action du rayon sur la couche photopolymérisable globalement,

**caractérisé en ce que** la longueur d'ondes du rayon utilisé à l'étape (B) est différent de celle du rayon utilisé à l'étape (A) pour inscrire l'information holographique et en outre **caractérisé en ce que** le liant polymère ou au moins un des liants polymères dans le mélange de liants et/ou le monomère monofonctionnel insaturé éthyléniquement

ou au moins un des monomères monofonctionnels insaturés éthyléniquement dans le mélange de monomères présente des motifs structurels photoactivables, qui sont susceptibles d'une réaction de réticulation induite par rayonnement, où le motif structurel photoactivable est présent dans la chaîne principale du polymère et/ou dans une ou plusieurs des chaînes latérales du liant polymère et/ou dans une ou plusieurs des chaînes latérales du monomère, où la réaction de réticulation s'effectue après la polymérisation pour l'impression holographique et ne se fait pas pour l'essentiel par irradiation de la même longueur d'ondes que celle utilisée pour la polymérisation du monomère monofonctionnel insaturé, et où le liant polymère et/ou le monomère monofonctionnel insaturé éthyléniquement ou au moins un des liants polymères dans le mélange de liants et/ou au moins un des monomères monofonctionnels insaturés éthyléniquement dans le mélange de monomères présente des motifs structuraux photoactivables P des formules générales I à IV ci-après :

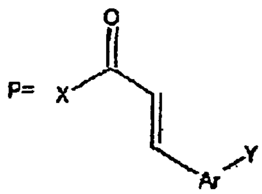
I

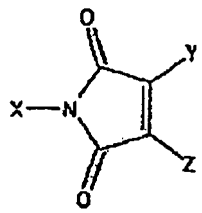
II

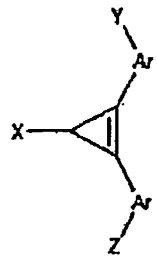
III

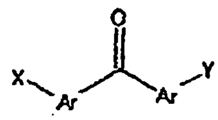
IV

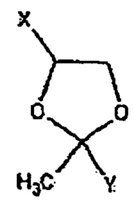
V

où Ar est un radical aromatique ou aromatique hétérocyclique substitué ou non substitué à un ou plusieurs noyaux, en particulier

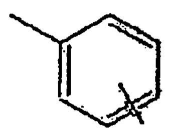
ou
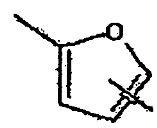

et où X, Y et Z sont identiques ou différents et choisis indépendamment les uns des autres parmi :

A) les radicaux monomères, qui comprennent des groupements insaturés éthylèniquement susceptibles de polymérisation et
B) les radicaux polymères qui sont dérivés de liants polymères solubles dans l'eau et/ou dans les solvants organiques et
C) les radicaux qui sont choisis, indépendamment les uns des autres, dans le groupe comprenant les radicaux alkyle, alcényle, alcinyle, alcoxy, acyle et acyloxy, qui peuvent être linéaires ou ramifiés, substitués ou non substitués, les radicaux aryloxy substitués ou non substitués, les radicaux aromatiques ou les radicaux hétérocycliques substitués ou non substitués, les radicaux hydrocarbonés alicycliques substitués ou non substitués, les radicaux amino, acide carboxylique, amido et imido aliphatiques, aromatiques et aliphatiques - aromatiques, les atomes d'hydroxy, d'amino, de cyano, de nitro et d'halogène ou les atomes d'hydrogène, et des combinaisons des radicaux cités précédemment, où les radicaux substitués peuvent être substitués par des radicaux alkyle en $C_1$-$C_{12}$, alcoxy en $C_1$-$C_{12}$, hydroxy, carboxy, carbonyle, amino, amido, imido, des atomes d'halogène, des radicaux aromatiques ou des combinaisons de ceux-ci.

**12.** Procédé selon la revendication 11, dans lequel, à l'étape (A), on utilise un rayon situé dans la plage des longueurs d'ondes visibles (400 à 800 nm) et, à l'étape (B), un rayon UV (150 à 400 nm).

**13.** Procédé selon l'une des revendications 11 ou 12, dans lequel les radicaux monomères présentent les formules structurelles générales suivantes :

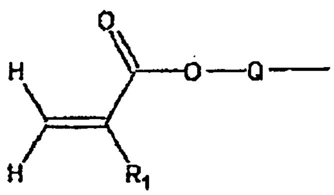

acrylate

or

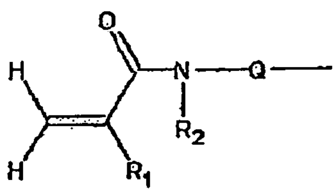

acrylamide

or

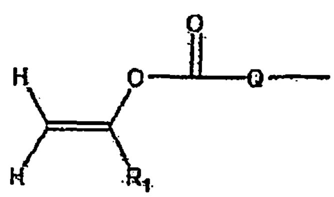

ester vinylique

or

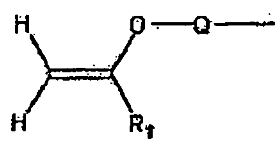

éther vinylique

or

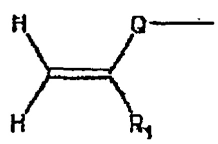

vinylique

or

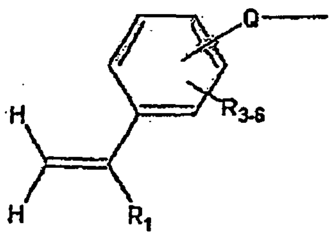

styrène

dans lesquelles

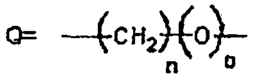 ou 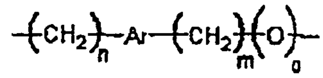

avec n, m = 0 - 12 et o = 0, 1, où Ar est un radical aromatique ou aromatique hétérocyclique substitué ou non substitué à un ou plusieurs noyaux,
dans lesquelles $R_1$ est H, méthyle ou éthyle et
dans lesquelles les radicaux $R_2$, $R_3$, $R_4$, $R_5$ et $R_6$ sont choisis, indépendamment les uns des autres, dans le groupe comprenant les radicaux alkyle, alcényle, alcinyle, alcoxy, acyle et acyloxy, qui peuvent être linéaires ou ramifiés, substitués ou non substitués, les radicaux aryloxy substitués ou non substitués, les radicaux aromatiques ou les radicaux hétérocycliques substitués ou non substitués, les radicaux hydrocarbonés alicycliques substitués ou non substitués, les radicaux amino, acide carboxylique, amido et imido aliphatiques, aromatiques et aliphatiques - aromatiques, les atomes d'hydroxy, d'amino, de cyano, de nitro et d'halogène ou les atomes d'hydrogène, et des combinaisons des radicaux cités précédemment, où les radicaux substitués peuvent être substitués par des radicaux alkyle en $C_1$-$C_{12}$, alcoxy en $C_1$-$C_{12}$, hydroxy, carboxy, carbonyle, amino, amido, imido, des atomes d'halogène, des radicaux aromatiques ou des combinaisons de ceux-ci.

**14.** Procédé selon l'une des revendications 11 ou 13, dans lequel les radicaux polymères B) sont choisis dans le groupe comprenant les polymères d'acétobutyrate de cellulose, les polymères et copolymères acryliques, y compris le polyméthacrylate de méthyle, les copolymères de méthacrylate de méthyle/ acide méthacrylique et méthacrylate de méthyle/ acide acrylique, les terpolymères de méthacrylate de méthyle/ acrylate ou méthacrylate d'alkyle en $C_2$-$C_4$/ acide acrylique ou méthacrylique, le polyvinylacétate, le polyvinylacétal, le polyvinylbutyral, le polyvinylformal et des mélanges de ceux-ci.

**15.** Procédé selon l'une des revendications 11 à 14, dans lequel le liant polymère est choisi dans le groupe comprenant le polyméthacrylate de méthyle et le polyméthacrylate d'éthyle, le polyvinylester comme le polyvinylacétate, le polyvinylacétate/ -acrylate, le polyvinylacétate/ -méthacrylate et le polyvinylacétate partiellement hydrolysé, les copolymères d'éthylène/ vinylacétate, le polyvinylbutyral et le polyvinylformal, le butadiène et les polymères et copolymères d'isoprène et les oxydes de polyéthylène constitués de polyglycols ayant un poids moléculaire moyen d'environ 1 000 à 1 000 000 g/mol, les époxydes, comme les époxydes comprenant des radicaux acrylate ou méthacrylate, les polystyrènes, les esters de cellulose, comme l'acétate de cellulose, l'acétosuccinate de cellulose et l'acétobutyrate de cellulose, les éthers de cellulose, comme la méthylcellulose et l'éthylcellulose, les polycondensats, comme les polycarbonates, les polyesters, les polyamides, comme le N-méthoxyméthylpolyhexaméthylène adipamide, les polyimides, les polyuréthanes.

**16.** Procédé selon l'une des revendications 11 à 15, dans lequel le ou les monomères monofonctionnels insaturés éthyléniquement sont choisis dans le groupe comprenant le butylester d'acide méthacrylique, le phénylester d'acide méthacrylique, le benzylester d'acide méthacrylique, l'isobornylester d'acide méthacrylique, le cyclohexylester d'acide méthacrylique, le 2-phénoxyéthylester d'acide méthacrylique, le 1H,1H,2H,2H-perfluorooctylester d'acide méthacrylique, le méthacrylate de 2,2,2-trifluoroéthyle, le méthacrylate d'heptafluoropropyle, le méthacrylate de 1,1,1,3,3,3-hexafluoroisopropyle, le méthacrylate de 2,2,3,3-tétrafluoropropyle, le méthacrylate de 2,2,3,3,4,4,4-heptafluorobutyle, le méthacrylate de 2,2,3,3,4,4,5,5-octafluoropentyle, le N,N-diéthylaminoéthylester d'acide acrylique, l'éthoxyéthyoxyéthylester d'acide acrylique, le 2-(p-chlorophénoxy)éthylester d'acide acrylique, l'acrylate de p-chlorophényle, le méthacrylate de 2-phényléthyle, l'acrylate de pentachlorophényle, l'acrylate de phényle, le p-chlorostyrène, le n-vinylcarbazole, la 1-vinyl-2-pyrrolidone, le 2-chlorostyrène, le 2-bromostyrène, le méthoxystyrène, l'acrylate de phénoléthoxylate, l'acrylate de 2-(p-chlorophénoxy)-éthyle, l'acrylate de 2-(1-naphtyloxy)éthyle, le monométhacrylate d'hydroquinone et l'acrylate de 2-[β-(N-carbazolyl)propionyloxy]éthyle.

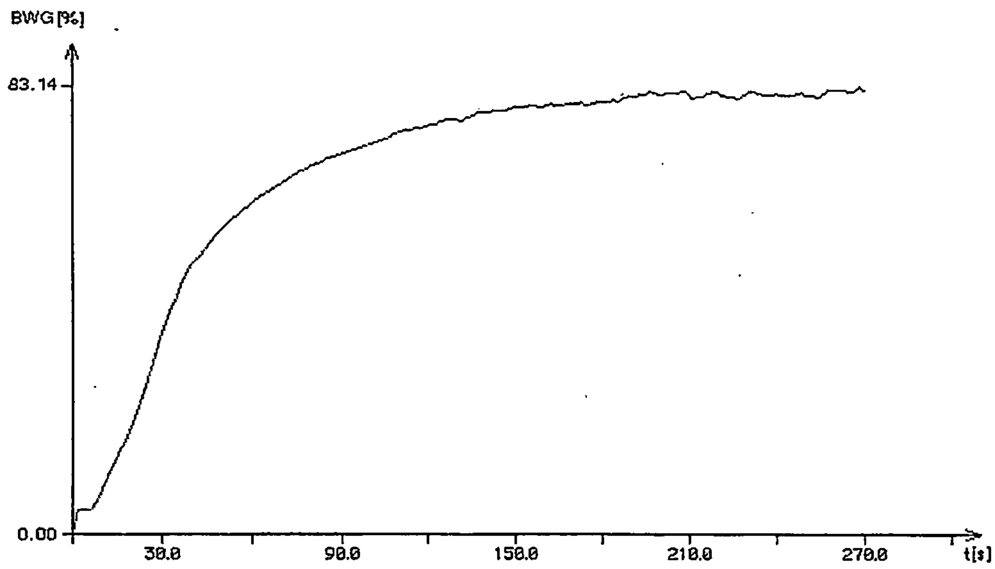
BWG [%]
83.14
0.00
30.0
90.0
150.0
210.0
270.0
t[s]

**Fig. 1**

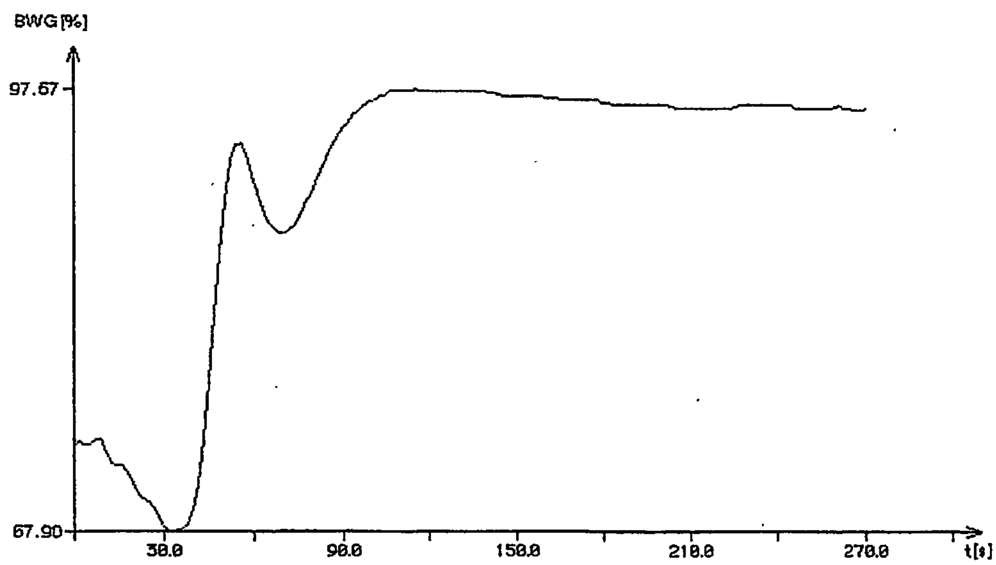
BWG [%]
97.57
67.90
30.0
90.0
150.0
210.0
270.0
t[s]

**Fig. 2**

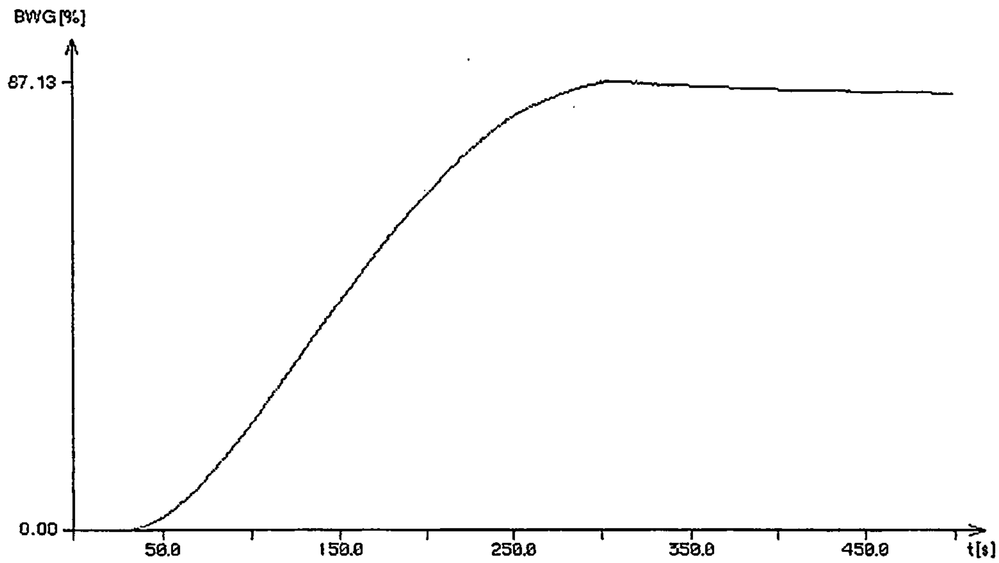
BWG [%]
87.13
0.00
50.0
150.0
250.0
350.0
450.0
t[s]

Fig. 3

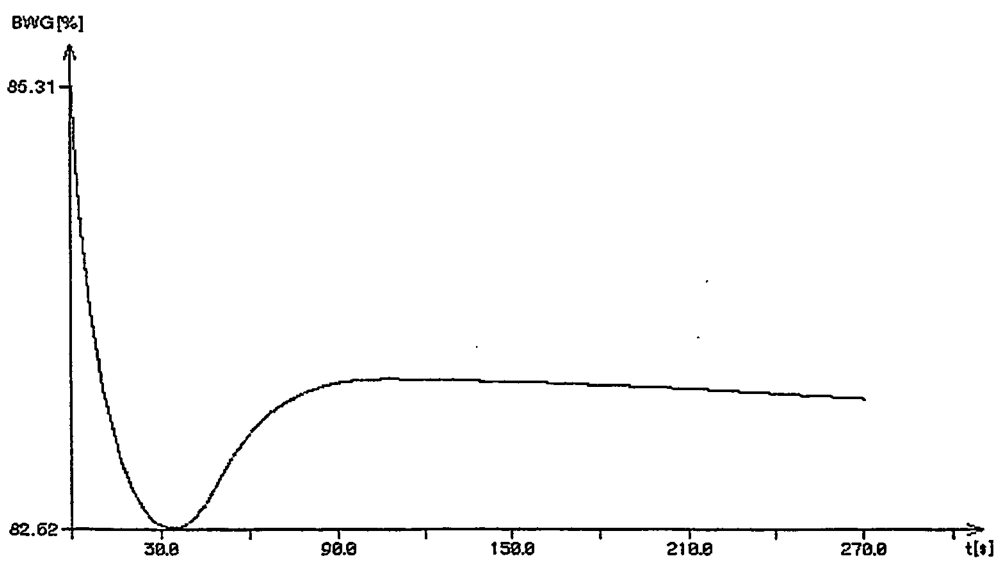
BWG [%]
85.31
82.62
30.0
90.0
150.0
210.0
270.0
t[s]

Fig. 4

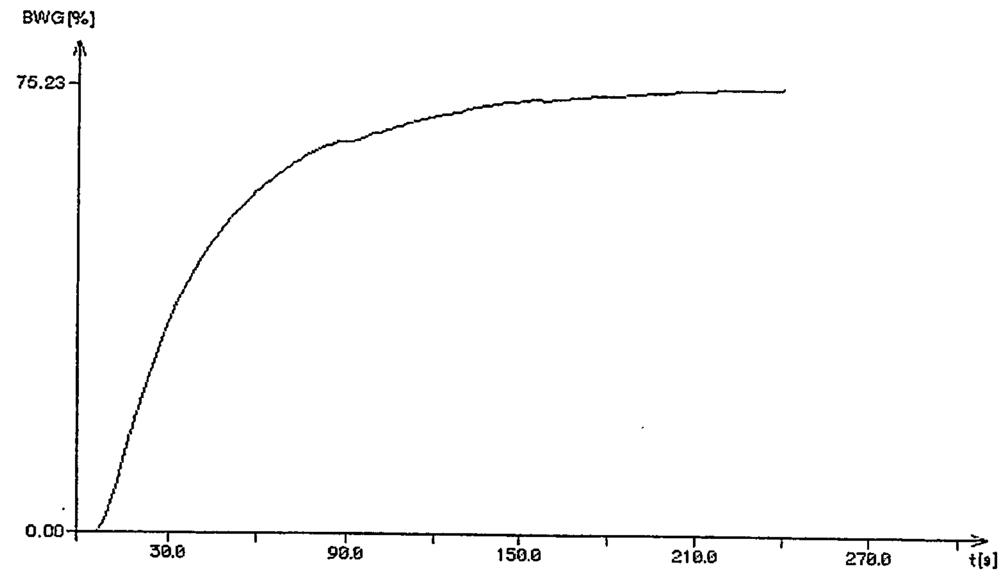
BWG [%]
75.23
0.00
30.0
90.0
150.0
210.0
270.0
t[s]

Fig. 5

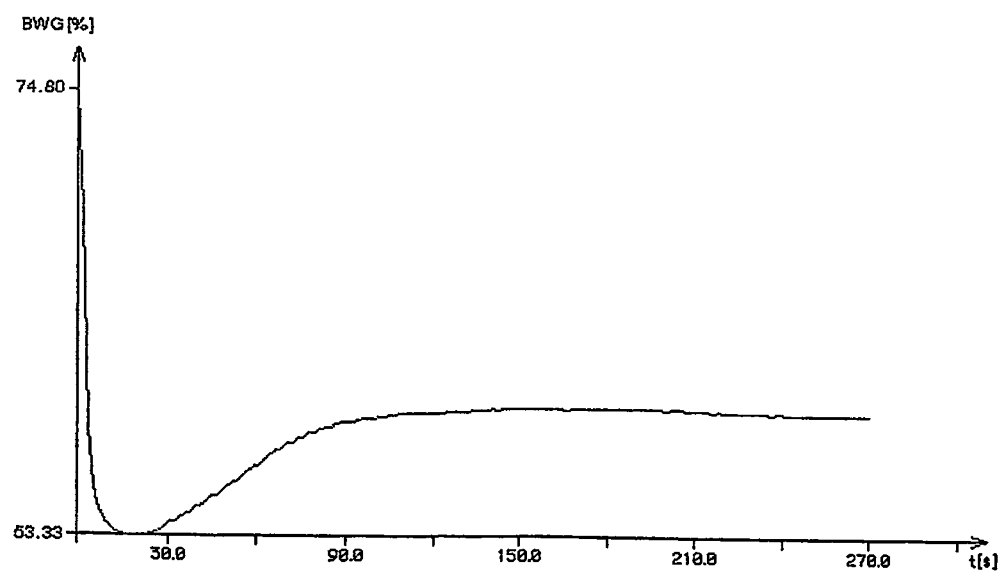
BWG [%]
74.80
53.33
30.0
90.0
150.0
210.0
270.0
t[s]

Fig. 6

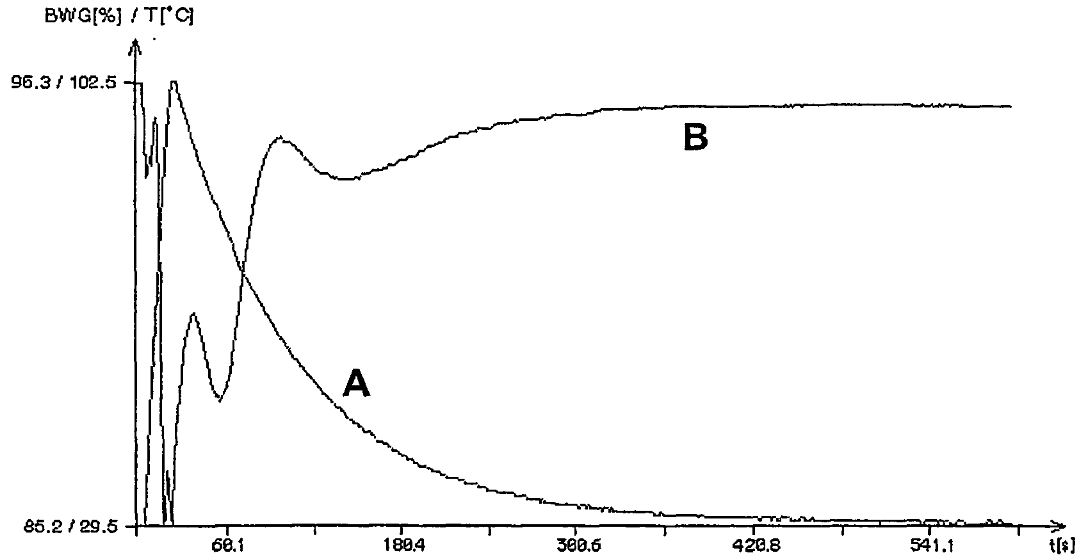
BWG[%] / T[°C]
96.3 / 102.5
85.2 / 29.5
60.1
180.4
300.6
420.8
541.1
t[s]
B
A

Fig. 7

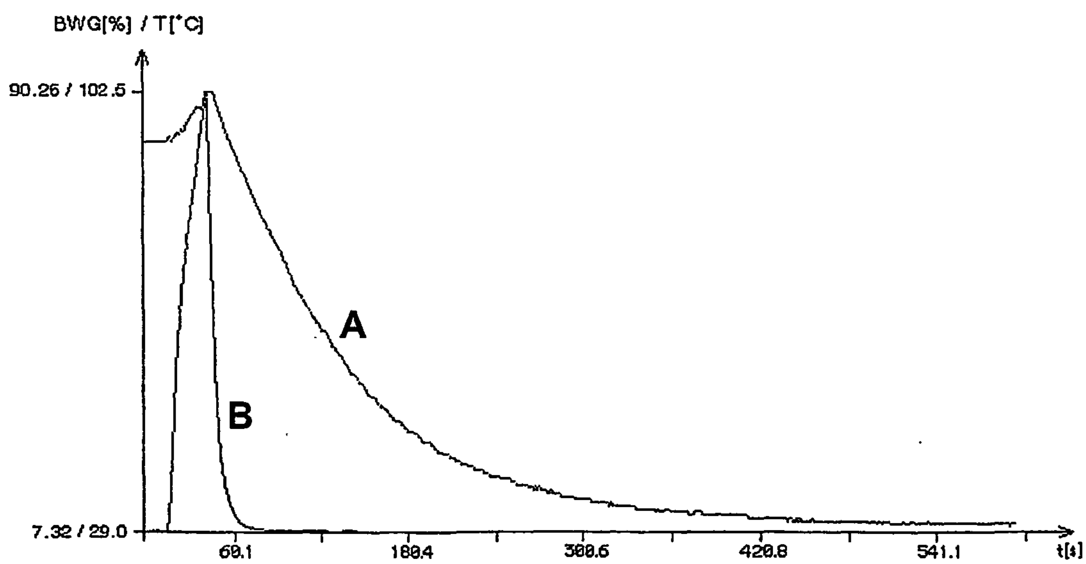
BWG[%] / T[°C]
90.26 / 102.5
7.32 / 29.0
60.1
180.4
300.6
420.8
541.1
t[s]
A
B

Fig. 8

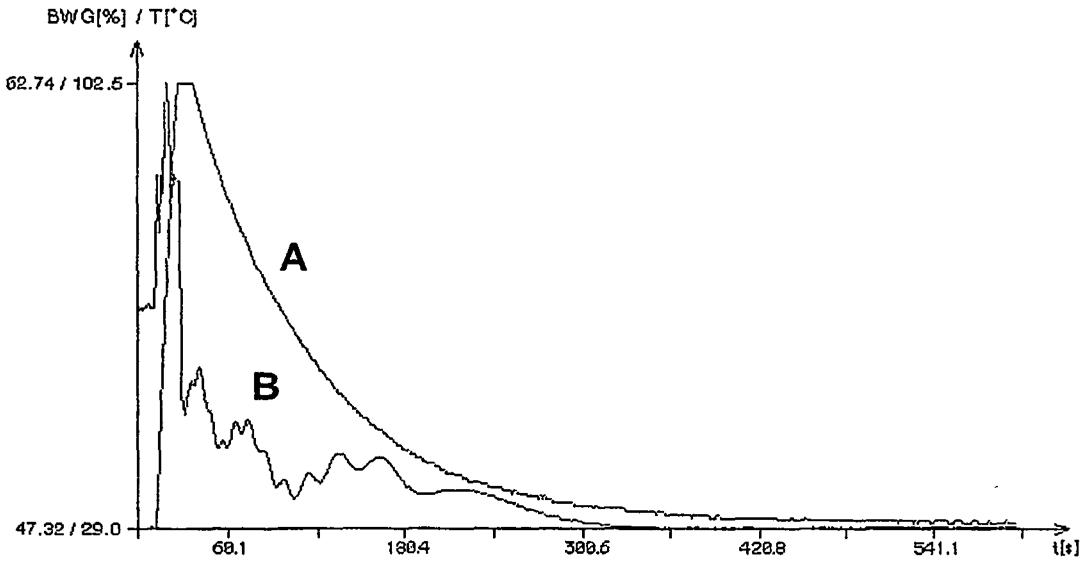
BWG[%] / T[°C]
62.74 / 102.5
47.32 / 29.0
60.1
180.4
300.6
420.8
541.1
t[s]
A
B

Fig. 9

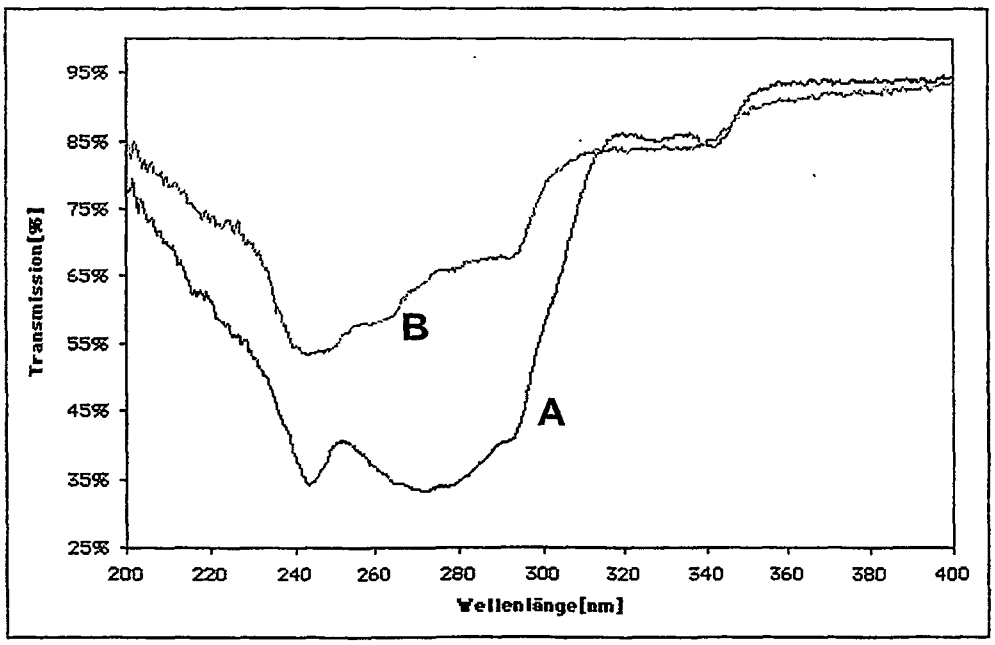
Transmission[%]
95%
85%
75%
65%
55%
45%
35%
25%
200
220
240
260
280
300
320
340
360
380
400
Wellenlänge[nm]
A
B

Fig. 10

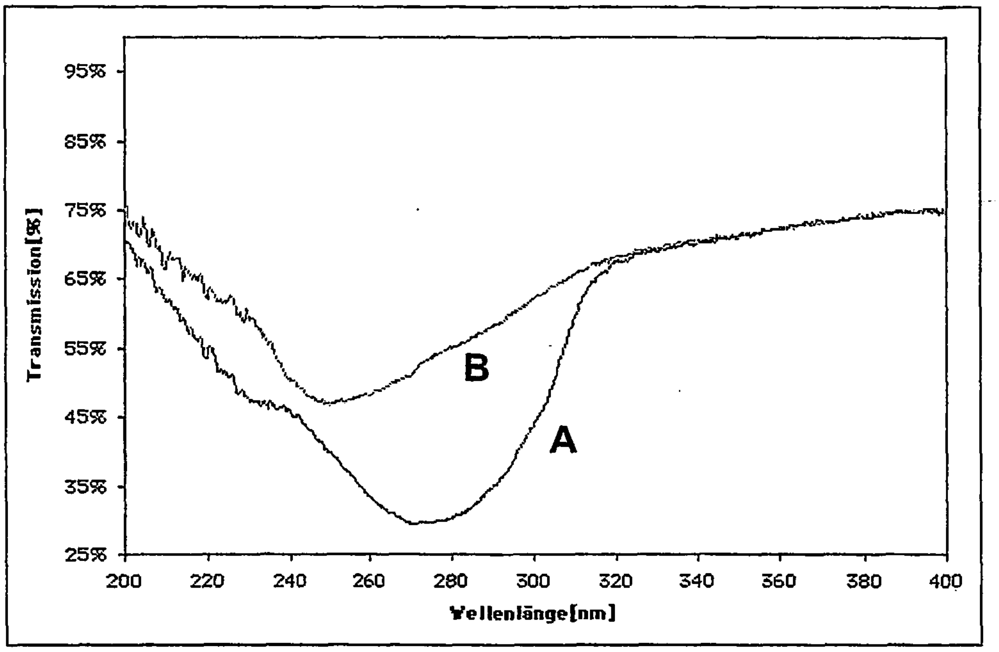
95%
85%
75%
65%
55%
45%
35%
25%
Transmission[%]
200
220
240
260
280
300
320
340
360
380
400
Wellenlänge[nm]
B
A

Fig. 11

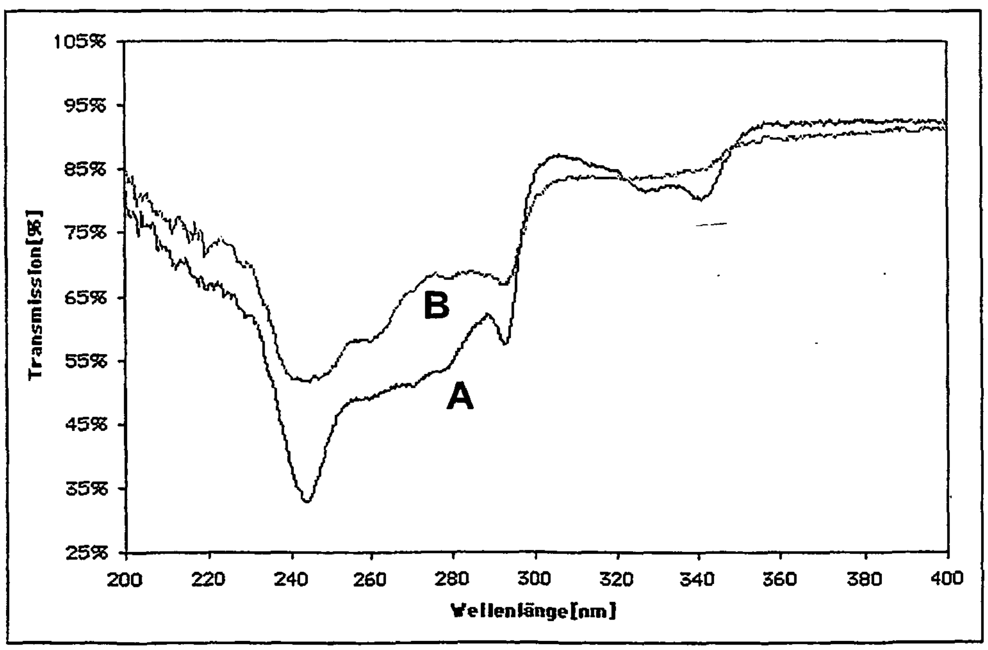
105%
95%
85%
75%
65%
55%
45%
35%
25%
Transmission[%]
200
220
240
260
280
300
320
340
360
380
400
Wellenlänge[nm]
B
A

Fig. 12

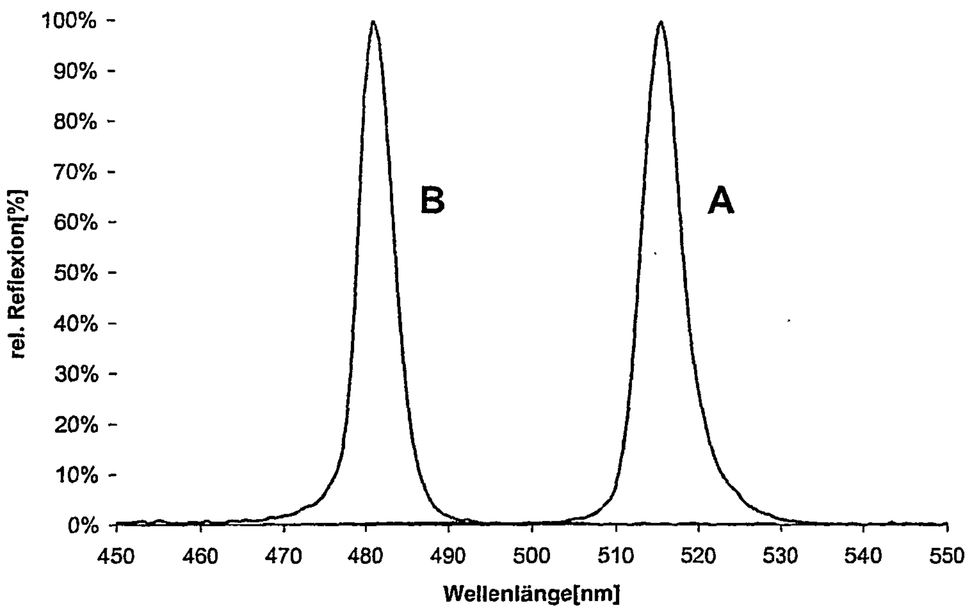
100%
90%
80%
70%
60%
50%
40%
30%
20%
10%
0%
rel. Reflexion[%]
B
A
450
460
470
480
490
500
510
520
530
540
550
Wellenlänge[nm]

Fig. 13

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 3658526 A
- EP 0324480 A
- US 2690966 A
- US 4152159 A
- EP 0240276 A
- US 3640722 A
- US 3748131 A
- DE 2230936
- EP 0021019 A
- US 3458311 A
- US 4273857 A
- US 4293635 A
- US 2760663 A
- US 2850445 A
- US 2875047 A
- US 3097096 A
- US 3074974 A
- US 3097097 A
- US 3145104 A
- US 3579339 A
- US 3427161 A
- US 3479185 A
- US 3549367 A
- US 4311783 A
- US 4622286 A
- US 3784557 A
- US 4341860 A
- US 3554753 A
- US 3563750 A
- US 3563751 A
- US 3647467 A
- US 3652275 A
- US 4162162 A
- US 4268667 A
- US 3351893 A
- US 4454218 A
- US 4535052 A
- US 4565769 A
- US 3854950 A
- US 4168982 A
- US 3390996 A
- US 4326010 A


### In der Beschreibung aufgeführte Nicht-Patentliteratur


- **C.C. Guest.** Encyclopedia of Physical Science and Technology. Academic Press, 1987, vol. 6, 507-519
- HQlographic Recording Materials. Topics in Applied Physics. Springer Verlag, 1977, vol. 20
- **Nagata et al.** Refractive index decrease during photocrosslinking in photopolymers suitable for holographic recording. *Macromol. Rapid Commun.,* 1997, vol. 18, 191-196
- **H.J. ; S. Neuenfeld.** Dyes in photoinitiator systems. *Kontakte,* 1990, 28-35
- **Jakubiak, J. ; J.F. Rabek.** Photoinitiators for visible light polymisation. *Polimery (Warschau),* 1999, vol. 44, 447-461
- Dye Sensitized Photopolymerization. **von D.F ; D.H. Volman ; G.S. Hammond ; K. Gollnick.** Adv. in Photochemistry. Wiley-Interscience, 1986, vol. 13, 427-487
- Reaktionen und Synthesen im organisch chemischen Praktikum und Forschungslaboratorium. **L.F. Tietze ; T. Eicher.** Reaktionen und Synthesen im organisch chemischen Praktikum und Forschungslaboratorium. Thieme-Verlag, 1991
- Makromoleküle. Hüthig & Wepf Verlag, 1990, vol. 1,2
- **D. Davidson ; M. Weiss ; M. Jelling.** J. Am. Chem. Soc. 1936, vol. 58, 319-327
- **M.D. Zammit ; T.P. Davis ; G.D. Willet.** *Macromolecules,* 1997, vol. 30, 5655-5659
- Coupled Wave Theory for Thick Hologram Gratings. *The Bell System Technical Journal vom,* 1969, vol. 23, 05